# EUROPÄISCHE PATENTSCHRIFT

(11) **EP 3 136 602 B1**
(45) Veröffentlichungstag und Bekanntmachung des Hinweises auf die Patenterteilung: **15.01.2020**
(21) Anmeldenummer: 16001889.1
(22) Anmeldetag: 29.08.2016
(51) Int. Cl.: H03K 17/967, G06F 3/0354, G06F 3/0338

(54) **SCHALTVORRICHTUNG, UND VERWENDUNG DER SCHALTVORRICHTUNG, ARBEITSVERFAHREN UND ARBEITSSYSTEM**
SWITCHING DEVICE, AND USE OF THE SWITCHING DEVICE, WORKING METHOD AND WORKING SYSTEM
DISPOSITIF DE COMMUTATION ET UTILISATION DU DISPOSITIF DE COMMUTATION, PROCESSUS DE FONCTIONNEMENT ET SYSTEME DE FONCTIONNEMENT

(30) Priorität: 27.08.2015 DE 102015011181; 27.08.2015 DE 102015011267
(43) Veröffentlichungstag der Anmeldung: 01.03.2017
(73) Patentinhaber: Fraunhofer-Gesellschaft zur Förderung der angewandten Forschung e.V., 80686 München (DE)
(72) Erfinder: Emmerich, Jan Sören, D-58313 Herdecke (DE); Ten Hompel, Michael, DE 44229 Dortmund (DE)
(74) Vertreter: Schatt, Markus F.

(56) Entgegenhaltungen:
- EP-A1- 1 691 263
- DE-A1- 10 015 009
- DE-A1- 19 535 423
- DE-A1-102004 017 579
- JP-A- H01 105 419
- US-A1- 2002 153 993

## Beschreibung

Die Erfindung betrifft eine elektrische Schaltvorrichtung und eine Verwendung der Schaltvorrichtung.

Aus der DE 20 2006 001 717 U1 ist ein elektrischer Schalter mit einem auf einem Dom angeordneten Taumelplatte bekannt.

Ein Display-Aktuator ist aus der EP 1 691 263 bekannt.

Aufgabe der vorliegenden Erfindung ist, eine elektrische Schaltvorrichtung bereitzustellen, die möglichst einfach, vorzugsweise mit niedriger Bauhöhe oder einem relativ flachen Gehäuseteil, gebaut und möglichst einfach herstellbar ist und auf effiziente Weise als Eingabevorrichtung verwendbar ist, sowie eine Verwendung der Schaltvorrichtung bereitzustellen.

Aufgabe der vorliegenden Erfindung ist auch, die Verwendung der Schaltvorrichtung in einem Arbeitssystem bereitzustellen, die eine effiziente und robuste sowie zuverlässige Aufgabenerfüllung durch einen Teilnehmer gewährleistet.

Diese Aufgaben werden mit den Merkmalen der unabhängigen Ansprüche gelöst. Weitere Ausführungsformen sind in den auf diesen rückbezogenen Unteransprüchen angegeben.

Nach der Erfindung ist insbesondere eine Schaltvorrichtung vorgesehen, die von einer Betätigungsseite her bedienbar ist, wobei die Schaltvorrichtung aufweist:
- einen plattenförmigen Grundkörper mit einer Anschluss-Oberfläche, die der Betätigungsseite der elektrischen Schaltvorrichtung zugewandt ist,
- ein in einer Dickenrichtung gesehen auf dieser angeordnetes plattenförmiges Betätigungsteil mit einer der der Betätigungsseite zugewandten Betätigungsoberfläche und einer entgegen gesetzt zu dieser gelegenen Anschluss-Oberfläche,
- eine Verbindungsvorrichtung zur elastischen Lagerung des Betätigungsteils gegenüber dem Grundkörper,
- zumindest ein Sensor, der zwischen dem Grundkörper und dem Betätigungsteil gelegen ist, so dass mit jedem Sensor des zumindest einen Sensors jeweils eine Position eines jeweils an diesem gelegenen Bereichs der zweiten Oberfläche in der Dickenrichtung erfasst werden kann.

Der zumindest eine Sensor ist insbesondere in einem Randbereich des Betätigungsteils gelegen, so dass mit diesem insbesondere ein Kipp- oder Wippbewegung des Betätigungsteils erfasst werden kann.

Durch die Verbindungsvorrichtung kann generell das Betätigungsteil relativ zum Grundkörper translatorisch in Z-Richtung bewegt oder gekippt oder geschwenkt werden, um das Betätigungsteil an Betätigungsbereichen, die an dessen Rand in Z-Richtung oberhalb zumindest eines jeweiligen Sensors gelegen sind, zu betätigen.

Nach einer Ausführungsform der Schaltvorrichtung kann das Betätigungsteil ein Display aufweisen, das in einem in der Dickenrichtung gesehen inneren Bereich der Betätigungsoberfläche des Betätigungsteils gelegen ist. In einer Variante dieser Ausführungsform kann das Display zugleich auch das Betätigungsteil selbst sein.

Durch das Vorsehen der Verbindungsvorrichtung wird eine Befestigung des Betätigungsteils am Grundkörper erreicht sowie eine lokale Veränderung der Position eines Bereichs des Betätigungsteils relativ zu einem an diesem Bereich jeweils gelegenen Sensor.

Durch die Verbindungsvorrichtung aus elastischem Material wird eine Rückstellfähigkeit der Verbindungsvorrichtung erreicht.

Nach einer Ausführungsform der Schaltvorrichtung ist vorgesehen, dass die Verbindungsvorrichtung aus wenigstens einer Verbindungsschicht besteht.

Nach einem weiteren Aspekt ist eine Schaltvorrichtung, die von einer Betätigungsseite her bedienbar ist, vorgesehen, wobei die Schaltvorrichtung aufweist:
- einen plattenförmigen Grundkörper mit einer Anschluss-Oberfläche, die der Betätigungsseite der elektrischen Schaltvorrichtung zugewandt ist,
- ein in einer Dickenrichtung gesehen auf dieser angeordnetes plattenförmiges Betätigungsteil mit einer der der Betätigungsseite zugewandten Betätigungsoberfläche und einer entgegen gesetzt zu dieser gelegenen Anschluss-Oberfläche,
- eine Verbindungsvorrichtung mit wenigstens einer Verbindungsschicht aus einem aus einem elastischen Material, das an einem in der Z-Richtung oder von einem Flächenschwerpunkt der Betätigungsoberfläche des Betätigungsteils gesehen äußeren Bereich oder Seitenrandabschnitt des Betätigungsteils und mit einer zweiten Oberfläche in der Z-Richtung gesehen an einem äußeren Bereich der Anschluss-Oberfläche des Grundkörpers befestigt ist,
- zumindest ein Sensor, der zwischen dem Grundkörper und dem Betätigungsteil gelegen sowie in dem Seitenrandabschnitt oder in der Dickenrichtung gesehen seitlich der Verbindungsvorrichtung gelegen sind, so dass mit jedem Sensor jeweils eine Position eines jeweils an diesem gelegenen Bereichs der zweiten Oberfläche in der Dickenrichtung bei einer Kippbewegung des Betätigungsteils erfasst werden kann.

Nach einem weiteren Aspekt ist eine Schaltvorrichtung vorgesehen, die aufweist:
- eine Gehäusevorrichtung mit einem plattenförmigen Grundkörper mit einer Anschluss-Oberfläche, die einer Betätigungsseite der elektrischen Schaltvorrichtung zugewandt ist, und mit einem Gehäuseteil,
- ein in einer Dickenrichtung gesehen auf dieser angeordnetes plattenförmiges Betätigungsteil mit einer der der Betätigungsseite zugewandten Betätigungsoberfläche und einer entgegen gesetzt zu dieser gelegenen Anschluss-Oberfläche,
- optional ein in dem Betätigungsteil integriertes Display zur Anzeige von Darstellungen auf der Betätigungsseite, wobei das Gehäuseteil aufweist: eine Seitenwand, die die Verbindungsvorrichtung und das Betätigungsteil in der Dickenrichtung gesehen zumindest abschnittsweise umgibt, und ein Randabschnitt, der sich zu der Betätigungsseite hin an der Seitenwand anschließt und eine zentrale Öffnung ausbildet, in der sich zumindest abschnittsweise das Display erstreckt,
- zumindest einen Sensor, der zwischen dem Grundkörper und dem Betätigungsteil gelegen sowie an einem Betätigungsteil gelegen ist, so dass mit jedem Sensor jeweils eine Position eines jeweils an diesem gelegenen Bereichs der zweiten Oberfläche in der Dickenrichtung erfasst werden kann.

Nach einer Alternative kann die Schaltvorrichtung zusätzlich aufweisen: eine Verbindungsvorrichtung mit wenigstens einer Verbindungsschicht aus einem aus einem elastischen Material, das an einem in der Z-Richtung gesehen inneren Bereich der Anschluss-Oberfläche des Betätigungsteils und mit einer zweiten Oberfläche in der Z-Richtung gesehen an einem inneren Bereich der Anschluss-Oberfläche des Grundkörpers befestigt ist. Dabei ist der zumindest eine Sensor vorzugsweise in der Dickenrichtung gesehen seitlich der Verbindungsvorrichtung gelegen. Vorzugsweise sind zumindest zwei Sensoren paarweise an in Bezug auf einen Flächenschwerpunkt des Betätigungsteils zueinander entgegen gesetzten Stellen gelegen.

Nach einer weiteren Alternative kann die Verbindungsvorrichtung durch eine Befestigungsvorrichtung realisiert sein, mit der der Randabschnitt des an einem Randabschnitt des Betätigungsteils befestigt ist, wobei der Randabschnitt der Gehäusevorrichtung elastisch gestaltet ist, so dass das Betätigungsteil relativ zum Grundkörper schwenkbar ist.

Nach einer weiteren Ausführungsform weist die Verbindungsvorrichtung wenigstens eine Verbindungsschicht auf, die aus einem aus einem elastischen Material gebildet ist und die von dem Flächenschwerpunkt der Betätigungsoberfläche des Betätigungsteils an einem äußeren Bereich der Anschluss-Oberfläche des Betätigungsteils und mit einer zweiten Oberfläche an einem von dem Flächenschwerpunkt aus gesehen äußeren Bereich der Anschluss-Oberfläche des Grundkörpers befestigt ist Dabei kann die Verbindungsvorrichtung aus wenigstens einer Verbindungsschicht bestehen.

Bei den hierin beschriebenen Ausführungsformen der Schaltvorrichtung kann ein in dem Betätigungsteil integriertes Display zur Anzeige von Darstellungen auf der Betätigungsseite vorgesehen sein, wobei das Gehäuseteil aufweist: eine sich von dem Grundkörper aus erstreckende Seitenwand, die das Betätigungsteil in der Dickenrichtung gesehen zumindest abschnittsweise umgibt, und ein Randabschnitt, der sich zu der Betätigungsseite hin an der Seitenwand anschließt und eine zentrale Öffnung ausbildet, in der sich zumindest abschnittsweise das Display erstreckt.

Bei den hierin beschriebenen Ausführungsformen der Schaltvorrichtung kann das Gehäuseteil aufweisen: eine sich von dem Grundkörper aus erstreckende Seitenwand, die das Betätigungsteil in der Dickenrichtung gesehen zumindest abschnittsweise umgibt, und ein Randabschnitt, der sich zu der Betätigungsseite hin an der Seitenwand anschließt, der zumindest abschnittsweise entlang des Umfangs des Betätigungsteils mit diesem verbunden ist und der eine zentrale Öffnung ausbildet, in der sich zumindest abschnittsweise das Display erstreckt. Dabei kann eine hierin beschriebene Verbindungsvorrichtung und insbesondere eine hierin beschriebene Verbindungsschicht in der Schaltvorrichtung integriert sein.

Nach einer Ausführungsform der Schaltvorrichtung ist vorgesehen,
- dass das Betätigungsteil ein Display aufweist, das in einem in der Dickenrichtung gesehen inneren Bereich der Betätigungsoberfläche des Betätigungsteils gelegen ist.
- dass der innere Display-Bereich als an der Betätigungsoberfläche geformte Vertiefung ausgeführt ist und das Display in der Dickenrichtung gesehenen zumindest teilweise in der Vertiefung gelegen ist.

Nach einer Ausführungsform der Schaltvorrichtung ist vorgesehen, dass das Betätigungsteil zumindest in Flächenanteilen optisch durchsichtig ist und wobei der Grundkörper einen in der Dickenrichtung gesehen inneren Display-Bereich aufweist, in dem das Display angeordnet ist, wobei die Lage des inneren Display-Bereichs nach einem der folgenden Alternativen definiert ist:
- der Display-Bereich in der Dickenrichtung gesehen innerhalb eines von den Sensoren aufgespannten Bereichs oder zwischen Sensoren und in der Dickenrichtung gesehen außerhalb der zumindest einen Verbindungsschicht liegt,
- der Display-Bereich in der Dickenrichtung gesehen innerhalb eines von den Sensoren aufgespannten Bereichs oder zwischen Sensoren und in der Dickenrichtung gesehen zumindest teilweise innerhalb zumindest einer der zumindest einen Verbindungsschicht liegt, wobei die zumindest eine Verbindungsschicht, innerhalb der der Display-Bereich gelegen ist, optisch durchsichtig ist.

Nach einer Ausführungsform der Schaltvorrichtung ist vorgesehen, dass der innere Display-Bereich als an der Anschluss-Oberfläche geformte Vertiefung ausgeführt ist und das Display in der Dickenrichtung gesehenen zumindest teilweise in der Vertiefung gelegen ist.

Nach einer Ausführungsform der Schaltvorrichtung ist vorgesehen, dass das plattenförmige Betätigungsteil als starres Teil ausgeführt ist.

Nach einer Ausführungsform der Schaltvorrichtung ist vorgesehen, dass das plattenförmige Betätigungsteil als biege-elastisches Teil ausgeführt ist.

Nach einer Ausführungsform der Schaltvorrichtung ist vorgesehen, dass die Schaltvorrichtung jeweils zwei Sensoren aufweist, von denen jeweils zwei in Bezug auf den Flächenschwerpunkt der Betätigungsoberfläche einander gegenüber liegend angeordnet sind.

Nach einer Ausführungsform der Schaltvorrichtung ist vorgesehen, dass der zumindest eine Sensor derart ausgeführt ist, dass dieser jeweils berührungslos den Abstand von demselben zu der diesem gegenüber liegenden Stelle der Anschluss-Oberfläche des Betätigungsteils erfasst.

Nach einer Ausführungsform der Schaltvorrichtung ist vorgesehen, dass der zumindest eine Sensor als optischer Sensor ausgeführt ist.

Nach einer Ausführungsform der Schaltvorrichtung ist vorgesehen, dass der zumindest eine Sensor als induktiver Sensor ausgeführt ist.

Nach einer Ausführungsform der Schaltvorrichtung ist vorgesehen, dass der zumindest eine Sensor als mechanischer Sensor mit einer Schaltkomponente ausgeführt ist.

Nach einer Variante dieser Ausführungsform der Schaltvorrichtung ist vorgesehen, dass der zumindest eine Sensor als mechanischer Sensor mit einer Schaltkomponente ausgeführt ist, wobei die Schaltkomponente mehr als eine mechanisch wirksam herstellbare Schaltpositionen aufweist (beispielsweise mehrere in Betätigungsrichtung erfolgende Rastungen, mehrere Druckpunkte, die Möglichkeit der Tastung und Übertastung, etc.).

Nach einer Ausführungsform der Schaltvorrichtung ist vorgesehen, dass die Schaltvorrichtung eine Anbindung (z. B. über WLAN) an ein Datennetzwerk aufweist,
Nach einer Ausführungsform der Schaltvorrichtung ist vorgesehen, dass über die Datennetzanbindung, nach Auswertung der über die Sensoren erfolgten Eingaben einsatzbezogene Dateninhalte (z. B. in Form von Apps) aus einer zentralen Datenbank herunterladbar und auf dem Display darstellbar sind.

Nach einem weiteren Aspekt ist eine Verwendung einer Ausführungsform der Schaltvorrichtung als Vorrichtung zur Eingabe von logistischen Daten in einem Lagerbereich vorgesehen.

Nach einem weiteren Aspekt ist eine Verwendung einer Ausführungsform der Schaltvorrichtung als Vorrichtung zur Eingabe von logistischen Daten und zur Ausgabe von logistischen Daten jeweils in einem Lagerbereich.

Nach einem weiteren Aspekt ist eine Verwendung einer Ausführungsform der Schaltvorrichtung mit einem Display als interaktive Mensch-Maschine-Schnittstelle in der Logistik und anderen industriellen Anwendungen, insbesondere in der Lagerbewirtschaftung und anderen Materialflusssystemen,
- wobei auf dem Display eine Anzahl aufgabenbezogener Alternativen anzeigbar ist,
- wobei über eine Eingabe des Benutzers, die auf Sensoren wirkt, eine Auswahl aus den angezeigten Alternativen erfolgt, worauf über die WLAN- Anbindung aus der zentralen Datenbank die nächste Aktion bzw. die nächste zu treffende Auswahl angezeigt wird.

Nach einem weiteren Aspekt ist eine Verwendung einer Ausführungsform der Schaltvorrichtung mit einem Display zur menügeführten Auswahl einer Aufgabe in der Lagerlogistik und in anderen industriellen Anwendungen vorgesehen,
- wobei in der zentralen Datenbank für eine Mehrzahl von Aufgaben Apps verfügbar gehalten werden, die über die Netzwerkanbindung auf dem Display wiedergebbaren Handlungsabfolgen, Alternativen zur aufgabenbezogenen Auswahl und/oder zu notwendigen Eingaben von Informationen anzeigbar machen,
- wobei der Benutzer die zur anstehenden Aufgabe entsprechende App auswählt und diese interaktiv unter Verwendung der Eingabemöglichkeiten über die Sensoren sowie unter Beachtung der Darstellungen auf dem Display abarbeitet.

Eine Verwendung einer Schaltvorrichtung mit Eingabemitteln und einem Display zur menügeführten Auswahl einer Aufgabe in einem Arbeitssystem und insbesondere in einer Lagersystem oder einer Produktionsanlage oder anderen industriellen Anwendungen ist vorgesehen, wobei in einer zentralen Datenbank für eine Mehrzahl von Aufgaben Anwendungsfunktionen verfügbar gehalten werden, die über eine Netzwerkanbindung auf dem Display wiedergebbare Handlungsabfolgen, Alternativen zur aufgabenbezogene Auswahl und/oder zu notwendigen Eingaben von Informationen anzeigbar machen, wobei der Benutzer die zur anstehenden Aufgabe entsprechende Anwendungsfunktionen auswählt und diese interaktiv unter Verwendung der Eingabemittel sowie unter Beachtung der Darstellungen auf dem Display abarbeitet. Ein Arbeitssystem mit zumindest einer Ausführungsform der Schaltvorrichtung, einem Zentralsystem und mehreren Arbeitsbereich-Teilnehmern ist vorgesehen, wobei die Schaltvorrichtung eine Ausgangs-Schnittstelle aufweist, über aufgrund der Bereitstellung zumindest eines Steuerungsfelds mittels eines Menü-Steuerungsmodul Aufgabenerfüllungs-Kommandos erzeugt und wahlweise
- an das Zentralsystem,
- sämtlichen der mehreren Arbeitsbereich-Teilnehmern,
- einzelnen der mehreren Arbeitsbereich-Teilnehmern
übermittelt werden können.

Auch ist ein Arbeitsverfahren mit einer mobilen Schaltvorrichtung, das als Handgerät ausgeführt ist und Eingabemitteln und ein Display zur menügeführten Auswahl und Ausführung einer Aufgabe in einem industriellen Arbeitssystem aufweist, vorgesehen mit den Schritten:
- Bereitstellung einer Mehrzahl von Aufgaben-Anwendungsfunktionen (App) in einer zentralen Datenbank,
- über eine Netzwerkanbindung auf dem Display der Schaltvorrichtung Anzeige von wiedergebbaren Handlungsabfolgen Teilnehmer-Aufgaben und/oder Alternativen zur aufgabenbezogene Auswahl und/oder zu notwendigen Eingaben von Informationen,
- durch einen Benutzer Auswahl von zur anstehenden Aufgabe entsprechenden Anwendungsfunktionen (App),
- Abarbeitung dieser Aufgaben interaktiv unter Verwendung der Eingabemittel sowie unter Beachtung der Darstellungen auf dem Display.

Nach einer Ausführungsform des Arbeitsverfahrens ist vorgesehen, dass
- dass in der ausgewählten Anwendungsfunktion (App) zumindest eine von einem oder mehreren Teilnehmern des Arbeitssystems zu erfüllende Teilnehmer-Aufgabe auf dem Display auswählbar ist,
- dass nach Auswahl einer Teilnehmer-Aufgabe eine Übermittlung einer ausgewählten Teilnehmer-Aufgabe durch Betätigung der Schaltvorrichtung an mehrere Arbeitsbereich-Teilnehmer erfolgt,
- dass bei den Teilnehmer jeweils eine Priorisierung der über einen vorgegebenen Arbeitszeitraum mittels Aufgabendurchführungs-Kommandos empfangenen Teilnehmer-Aufgaben erfolgt,
- dass eine Konsistenzprüfung und ein Abgleich der Teilnehmer-Aufgaben zwischen den Arbeitsbereich-Teilnehmern derart erfolgt, dass vermieden wird, dass derselben Aufgabe die oberste Priorität zugewiesen wird,
- dass eine Abarbeitung der Aufgabe jeweils oberster Priorität durch den jeweiligen Teilnehmer erfolgt, so dass jeder Teilnehmer eine Aufgabe oberster Priorität erfüllt.

Dabei kann insbesondere vorgesehen sein, dass das industrielle Arbeitssystem ein Lagersystem ist und wobei zumindest zwei Arbeitsbereich-Teilnehmer Lagerbediengeräte sind.

Bei einem Arbeitsverfahrens ist vorgesehen, dass über eine Ausgangs-Schnittstelle der Schaltvorrichtung in durch Betätigung der Schaltvorrichtung auswählbaren Menüformaten Steuerungsfelder bereit gestellt werden, mittels eines Menü-Steuerungsmodul Aufgabendurchführungs-Kommandos erzeugt werden und wahlweise
- an das Zentralsystem,
- sämtlichen der mehreren Arbeitsbereich-Teilnehmern,
- einzelnen der mehreren Arbeitsbereich-Teilnehmern,
übermittelt werden.

Bei dem Arbeitsverfahren ist vorgesehen, dass die Schaltvorrichtung nach einer hierin beschriebenen Ausführungsform ausgeführt ist.

Auch ist bei einem Arbeitsverfahren zur Erfüllung einer Arbeitsaufgabe eines Arbeitsbereich-Teilnehmers in einem Arbeitssystem vorgesehen, wobei das Verfahren die folgenden Schritte aufweist:
- mit einer Schaltvorrichtung über eine drahtlose Kommunikationsverbindung Empfang zumindest einer Arbeitsaufgabe von dem Arbeitsbereich-Teilnehmer oder einem Zentralsystem,
- mit einem Display der Schaltvorrichtung Anwahl der Arbeitsaufgabe und durch Betätigung der Schaltvorrichtung Übermittlung eines Aufgabendurchführungs-Kommandos an den Arbeitsbereich-Teilnehmer über die drahtlose Kommunikationsverbindung,
- mit Empfang des Aufgabendurchführungs-Kommandos durch den Teilnehmer Aktivierung eines Steuerungssystems des Arbeitsbereich-Teilnehmers und Erzeugung von Steuerungskommandos an Aktuatoren des Arbeitsbereich-Teilnehmers zur Durchführung einer Aufgabendurchführungs-Aktion zur Erfüllung der Arbeitsaufgabe durch den Arbeitsbereich-Teilnehmer entsprechend des Aufgabendurchführungs-Kommandos.

Bei dem Arbeitsverfahren kann die Schaltvorrichtung nach einer der hierin beschriebenen Ausführungsformen ausgeführt sein.

Weiterhin ist ein Arbeitssystem vorgesehen, das Arbeitssystem aufweisend:
- eine Schaltvorrichtung, wobei die Schaltvorrichtung eine Schnittstellenfunktion aufweist, mit der diese über eine drahtlose Kommunikationsverbindung eine Arbeitsaufgabe von einem Arbeitsbereich-Teilnehmer oder einem Zentralsystem empfangen kann, wobei die Schaltvorrichtung ein Display aufweist, mit dem eine Anwahl der Arbeitsaufgabe vorgenommen und bei Betätigung ein Aufgabendurchführungs-Kommando an den Arbeitsbereich-Teilnehmer über die drahtlose Kommunikationsverbindung übermittelt,
- zumindest einen Arbeitsbereich-Teilnehmer mit einem Steuerungssystem und einer mit dieser funktional in Verbindung stehenden Schnittstellen-Funktion, die zumindest ein Aufgabendurchführungs-Kommando von der Schaltvorrichtung empfangen kann und dieses an das Steuerungssystem übermittelt, wobei das Steuerungssystem nach Empfangen des Aufgabendurchführungs-Kommandos Steuerungskommandos erzeugt und an zumindest einen Aktuator des Arbeitsbereich-Teilnehmers übermittelt, wobei daraufhin der Aktuator zur Durchführung einer Aufgabendurchführungs-Aktion durch den Arbeitsbereich-Teilnehmer und zur Erfüllung der Arbeitsaufgabe entsprechend des Aufgabendurchführungs-Kommandos betätigt wird,
- das Zentralsystem.

Bei dem Arbeitssystem kann die Schaltvorrichtung nach einer der hierin beschriebenen Ausführungsformen ausgeführt sein.

Der Ausdruck "entlang" kann hierin im Zusammenhang mit den hierin genannten Richtungsangaben, die den Verlauf einer Konturlinie oder einer Oberfläche betreffen können, oder die eine Richtung einer mechanischen Komponente wie einer Achse oder Welle betreffen können, insbesondere bedeuten, dass die Tangente an die jeweilige Konturlinie oder an die jeweilige Oberfläche in deren Verlauf gemäß der Richtungsangabe bzw. die Längserstreckung und z.B. Mittelachse der mechanischen Komponente lokal mit einem Winkel von maximal 45 Grad und vorzugsweise von maximal 30 Grad von einer Bezugsrichtung oder Bezugsachse abweicht, auf die bzw. der die jeweilige Richtungsangabe bezogen ist.

Der Ausdruck "quer" kann hierin im Zusammenhang mit den hierin genannten Richtungsangaben, die den Verlauf einer Konturlinie oder einer Oberfläche betreffen können, oder die eine Richtung einer mechanischen Komponente wie einer Achse oder Welle betreffen können, insbesondere bedeuten, dass die Tangente an die jeweilige Konturlinie oder an die jeweilige Oberfläche in deren Verlauf gemäß der Richtungsangabe bzw. die Längserstreckung und z.B. Mittelachse der mechanischen Komponente lokal mit einem Winkel von minimal 45 Grad und vorzugsweise von minimal 30 Grad von einer Bezugsrichtung oder Bezugsachse abweicht, auf die bzw. der die jeweilige Richtungsangabe bezogen ist.

Der Ausdruck "in der Dickenrichtung Z gesehen" bedeutet hierin zur Bezeichnung einer relativen Lage von angesprochene Merkmale oder Komponenten eine Blickrichtung, aufgrund einer Lage der angesprochenen Merkmale oder Komponenten angegeben werden.

Eine Verwendung der Schaltvorrichtung als Vorrichtung zur Eingabe von logistischen Daten auf dem gesamten Gebiet der Logistik und industrieller Anwendungen, beispielsweise in einem Lagerbereich oder in der Produktion ist vorgesehen.

Weiterhin ist eine Verwendung der Schaltvorrichtung in der Ausführung mit einem Display als Vorrichtung zur Eingabe von logistischen Daten und zur Ausgabe von logistischen Daten auf dem gesamten Gebiet der Logistik und industrieller Anwendungen, beispielsweise jeweils in einem Lagerbereich oder in der Produktion vorgesehen.

Auch ist eine Verwendung von Schaltvorrichtungen nach dem Stand der Technik in einer Ausführung mit einem Display als Vorrichtung zur Eingabe von logistischen Daten und zur Ausgabe von logistischen Daten auf dem gesamten Gebiet der Logistik und industrieller Anwendungen, beispielsweise jeweils in einem Lagerbereich oder in der Produktion vorgesehen.

Im Folgenden werden Ausführungsformen der Erfindung anhand der beiliegenden Figuren beschrieben, die zeigen:
- Figur 1 eine Draufsicht einer Ausführungsform der elektrischen Schaltvorrichtung mit einem Gehäuse, einem darin angeordneten Grundkörper, einem Betätigungsteil und einer zwischen diesen gelegenen Verbindungsvorrichtung in einer ersten Ausführungsform sowie Sensoren, wobei die Sensoren als in der Draufsicht verdeckte Teile gestrichelt dargestellt sind,
- Figur 2 eine Schnittdarstellung der Ausführungsform der elektrischen Schaltvorrichtung nach der Figur 1 entlang der in der Figur 1 eingetragenen Linie L2-L2, wobei berührungslose Sensoren in Form von optischen Sensoren verwendet werden,
- Figur 3 eine Schnittdarstellung der Ausführungsform der elektrischen Schaltvorrichtung nach der Figur 1 entlang der in der Figur 1 eingetragenen Linie L3-L3,
- Figur 4 eine weitere Draufsicht der Ausführungsform der elektrischen Schaltvorrichtung nach der Figur 1, in der Betätigungsbereiche des Betätigungsteils gestrichelt dargestellt sind,
- Figur 5 als erster Schritt einer Schrittfolge die Schnittdarstellung der Ausführungsform der elektrischen Schaltvorrichtung nach der Figur 1 entlang der in der Figur 1 eingetragenen Linie L2-L2, wobei die Schaltvorrichtung in einer Ausgangsstellung gezeigt ist,
- Figur 6 die Ausführungsform der elektrischen Schaltvorrichtung nach der Figur 1 in der Darstellung der Figur 5, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
- Figur 7 die Ausführungsform der elektrischen Schaltvorrichtung nach der Figur 1 in der Darstellung der Figur 5, wobei eine gegenüber der Figur 6 größere äußere Druckkraft ausgeübt wird,
- Figur 8 die Ausführungsform der elektrischen Schaltvorrichtung nach der Figur 1 in der Darstellung der Figur 5, gegenüber der Figur 7 eine weitere äußere Druckkraft an einem zweiten seitlichen Randabschnitt des Betätigungsteils ausgeübt wird, der entgegen gesetzt zu dem ersten seitlichen Randabschnitt gelegen ist,
- Figur 9 eine Draufsicht einer weiteren Ausführungsform der Schaltvorrichtung mit einer weiteren Ausführungsform der Verbindungsvorrichtung,
- Figur 10 eine Draufsicht einer weiteren Ausführungsform der Schaltvorrichtung mit einer weiteren Ausführungsform der Verbindungsvorrichtung,
- Figur 11 eine Draufsicht einer weiteren Ausführungsform der Schaltvorrichtung mit einer weiteren Ausführungsform der Verbindungsvorrichtung,
- Figur 12 eine perspektivische Darstellung der Grundplatte und der Verbindungsvorrichtung einer weiteren Ausführungsform der Schaltvorrichtung, wobei die Verbindungsvorrichtung eine Variante der Verbindungsvorrichtung nach der Figur 11 ist,
- Figur 13 eine perspektivische Darstellung der Grundplatte und der Verbindungsvorrichtung einer weiteren Ausführungsform der Schaltvorrichtung, wobei die Verbindungsvorrichtung eine Variante den Verbindungsvorrichtungen nach den Figur 11 oder 12 ist,
- Figuren 14 bis 16 verschiedene Verformungszustände des Betätigungsteils einer Schaltvorrichtung nach der Figur 12 in einer Schnittdarstellung,
- Figur 17 eine Variante zu der in der Figur 12 dargestellten Ausführungsform der Verbindungsvorrichtung, bei der Weichenteile als Bereiche größerer Elastizität in der Verbindungsschicht integriert sind,
- Figur 18 eine Draufsicht auf eine weitere Ausführungsform der Verbindungsvorrichtung ohne dem Betätigungsteil mit einer ringförmigen Verbindungsschicht und einem im Wesentlichen unelastischen sphärischen Weichenteil in deren Mitte,
- Figur 19 eine Schnittdarstellung der Ausführungsform der elektrischen Schaltvorrichtung nach der Figur 18 entlang der in der Figur 18 eingetragenen Linie L19-L19, wobei die Schaltvorrichtung in einer Ausgangsstellung gezeigt ist,
- Figur 20 eine Draufsicht auf eine Variante zu der in der Figur 18 gezeigten Ausführungsform mit einer zu dieser alternativ ausgeführten Verbindungsvorrichtung,
- Figur 21 eine Schnittdarstellung einer weiteren Ausführungsform der Schaltvorrichtung analog der in der Figur 1 eingetragenen Linie L2-L2, wobei das Betätigungsteil als Display ausgeführt ist,
- Figuren 22 und 23 jeweils eine sich analog der Linie L2-L2 der Figur 1 ergebenden Schnittdarstellung von weiteren Ausführungsformen der Schaltvorrichtung, bei denen die Anschlussoberflächen der Grundplatte und des Betätigungsteils gekrümmt verlaufen,
- Figur 24 eine Detaildarstellung der Ausführungsform der elektrischen Schaltvorrichtung nach der Figur 1 mit dem ersten seitlichen Randabschnitt des Betätigungsteils, wobei sich die Schaltvorrichtung in dem in der Figur 5 gezeigten Ausgangszustand befindet,
- Figur 25 die Detaildarstellung der Figur 24, wobei sich die Schaltvorrichtung in dem in der Figur 6 gezeigten Betätigungszustand befindet,
- Figur 26 die Detaildarstellung der Figur 25, wobei sich die Schaltvorrichtung in dem in der Figur 7 gezeigten Betätigungszustand befindet,
- Figur 27 eine Draufsicht einer weiteren Ausführungsform der elektrischen Schaltvorrichtung, wobei die Sensoren als in der Draufsicht verdeckte Teile gestrichelt dargestellt sind,
- Figur 28 eine Schnittdarstellung der Ausführungsform der elektrischen Schaltvorrichtung nach der Figur 27 entlang der in der Figur 27 eingetragenen Linie L28-L28,
- Figur 29 als erster Schritt einer Schrittfolge von vier Schritten die Schnittdarstellung der Ausführungsform der elektrischen Schaltvorrichtung nach der Figur 27 entlang der in der Figur 27 eingetragenen Linie L28-L28, wobei die Schaltvorrichtung in einer Ausgangsstellung gezeigt ist und wobei die dargestellte Ausführungsform der Schaltvorrichtung ein flexibles Betätigungsteil aufweist,
- Figur 30 die Ausführungsform der elektrischen Schaltvorrichtung nach der Figur 27 in der Darstellung der Figur 29, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
- Figur 31 die Ausführungsform der elektrischen Schaltvorrichtung nach der Figur 1 in der Darstellung der Figur 29, wobei eine gegenüber der Figur 30 größere äußere Druckkraft ausgeübt wird,
- Figur 32 die Ausführungsform der elektrischen Schaltvorrichtung nach der Figur 1 in der Darstellung der Figur 29, gegenüber der Figur 31 eine weitere äußere Druckkraft an einem zweiten seitlichen Randabschnitt des Betätigungsteils ausgeübt wird, der entgegen gesetzt zu dem ersten seitlichen Randabschnitt gelegen ist,
- Figur 33 eine Detaildarstellung der Ausführungsform der elektrischen Schaltvorrichtung nach der Figur 27 mit dem ersten seitlichen Randabschnitt des Betätigungsteils, wobei sich die Schaltvorrichtung in dem in der Figur 29 gezeigten Ausgangszustand befindet,
- Figur 34 die Detaildarstellung der Figur 33, wobei sich die Schaltvorrichtung in dem in der Figur 30 gezeigten Betätigungszustand befindet,
- Figur 35 die Detaildarstellung der Figur 33, wobei sich die Schaltvorrichtung in dem in der Figur 31 gezeigten Betätigungszustand befindet,
- Figur 36 als erster Schritt einer Schrittfolge von fünf Schritten die Schnittdarstellung der Ausführungsform der elektrischen Schaltvorrichtung nach der Figur 27 entlang der in der Figur 27 eingetragenen Linie L36-L36, wobei die Schaltvorrichtung in einer Ausgangsstellung gezeigt ist und wobei die dargestellte Ausführungsform der Schaltvorrichtung ein starres Betätigungsteil aufweist,
- Figur 37 die Ausführungsform der elektrischen Schaltvorrichtung nach der Figur 27 in der Darstellung der Figur 36, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
- Figur 38 die Ausführungsform der elektrischen Schaltvorrichtung nach der Figur 27 in der Darstellung der Figur 36, wobei eine gegenüber der Figur 37 größere äußere Druckkraft ausgeübt wird,
- Figur 39 die Ausführungsform der elektrischen Schaltvorrichtung nach der Figur 27 in der Darstellung der Figur 36, wobei gegenüber der Figur 38 eine weitere äußere Druckkraft an einem zweiten seitlichen Randabschnitt des Betätigungsteils ausgeübt wird, der entgegen gesetzt zu dem ersten seitlichen Randabschnitt gelegen ist,
- Figur 40 die Ausführungsform der elektrischen Schaltvorrichtung nach der Figur 27 in der Darstellung der Figur 36, wobei gegenüber der Figur 39 bei einem weiteren Betriebszustand keine äußere Druckkraft an einem seitlichen Randabschnitt des Betätigungsteils ausgeübt wird,
- Figur 41 als erster Schritt einer Schrittfolge von vier Schritten eine Schnittdarstellung der Ausführungsform der elektrischen Schaltvorrichtung nach der Figur 27 entlang der in der Figur 27 eingetragenen Linie L41-L41, wobei die Schaltvorrichtung in einer Ausgangsstellung gezeigt ist und wobei die dargestellte Ausführungsform der Schaltvorrichtung ein starres Betätigungsteil aufweist,
- Figur 42 die Ausführungsform der elektrischen Schaltvorrichtung nach der Figur 27 in der Darstellung der Figur 41, wobei die Schaltvorrichtung in einer Betätigungsstellung gezeigt ist, bei der äußere Druckkräfte auf entgegen gesetzt zueinander gelegenen seitlichen Randabschnitten des Betätigungsteils von der Betätigungsseite her ausgeübt wird,
- Figur 43 die Ausführungsform der elektrischen Schaltvorrichtung nach der Figur 27 in der Darstellung der Figur 41, wobei eine gegenüber der Figur 42 größere äußere Druckkräfte ausgeübt wird,
- Figur 44 die Ausführungsform der elektrischen Schaltvorrichtung nach der Figur 27 in der Darstellung der Figur 41, wobei gegenüber der Figur 43 bei einem weiteren Betriebszustand wiederum keine äußere Druckkraft an einem seitlichen Randabschnitt des Betätigungsteils ausgeübt wird,
- Figur 45 eine Draufsicht einer weiteren Ausführungsform der elektrischen Schaltvorrichtung, wobei die Sensoren als in der Draufsicht verdeckte Teile gestrichelt dargestellt sind,
- Figur 46 eine Schnittdarstellung der Ausführungsform der elektrischen Schaltvorrichtung nach der Figur 45 entlang der in der Figur 45 eingetragenen Linie L46-L46,
- Figur 47 als erster Schritt einer Schrittfolge von vier Schritten die Schnittdarstellung der Ausführungsform der elektrischen Schaltvorrichtung nach der Figur 45 entlang der in der Figur 45 eingetragenen Linie L46-L46, wobei die Schaltvorrichtung in einer Ausgangsstellung gezeigt ist und wobei die dargestellte Ausführungsform der Schaltvorrichtung ein starres Betätigungsteil aufweist,
- Figur 48 die Ausführungsform der elektrischen Schaltvorrichtung nach der Figur 45 in der Darstellung der Figur 7 wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
- Figur 49 die Ausführungsform der elektrischen Schaltvorrichtung nach der Figur 45 in der Darstellung der Figur 47, wobei eine gegenüber der Figur 48 größere äußere Druckkraft ausgeübt wird,
- Figur 50 die Ausführungsform der elektrischen Schaltvorrichtung nach der Figur 45 in der Darstellung der Figur 47, wobei gegenüber der Figur 49 keine äußere Druckkraft an seitlichen Randabschnitten des Betätigungsteils ausgeübt wird,
- Figur 51 eine Detaildarstellung der Ausführungsform der elektrischen Schaltvorrichtung nach der Figur 45 mit dem ersten seitlichen Randabschnitt des Betätigungsteils, wobei sich die Schaltvorrichtung in dem in der Figur 47 gezeigten Ausgangszustand befindet,
- Figur 52 die Detaildarstellung der Figur 51, wobei sich die Schaltvorrichtung in dem in der Figur 48 gezeigten Betätigungszustand befindet,
- Figur 53 die Detaildarstellung der Figur 51, wobei sich die Schaltvorrichtung in dem in der Figur 49 gezeigten Betätigungszustand befindet,
- Figur 54 eine Schnittdarstellung der Ausführungsform der elektrischen Schaltvorrichtung als Variante der Ausführungsformen der Figuren 27 und 45, wobei sich Schnittdarstellung analog der Linien L28-L28 bzw. L46-L46 ergibt und wobei ein Randabschnitt des Betätigungsteils von einem Randabschnitt des Gehäuses vorgespannt ist,
- Figur 55 eine Schnittdarstellung der Ausführungsform der elektrischen Schaltvorrichtung als im Vergleich zur Ausführungsform der Figur 54 weitere Variante der Ausführungsformen der Figuren 27 und 45 in der Darstellung der Figur 54 und wobei ein Randabschnitt des Betätigungsteils von einem Randabschnitt des Gehäuses vorgespannt ist,
- Figur 56 eine Draufsicht einer weiteren Ausführungsform der elektrischen Schaltvorrichtung, wobei die Sensoren als in der Draufsicht verdeckte Teile gestrichelt dargestellt sind,
- Figur 57 eine Schnittdarstellung der Ausführungsform der elektrischen Schaltvorrichtung nach der Figur 56 entlang der in der Figur 56 eingetragenen Linie L57-L57,
- Figur 58 als erster Schritt einer Schrittfolge von vier Schritten die Schnittdarstellung der Ausführungsform der elektrischen Schaltvorrichtung nach der Figur 56 entlang der in der Figur 56 eingetragenen Linie L57-L57, wobei die Schaltvorrichtung in einer Ausgangsstellung gezeigt ist,
- Figur 59 die Ausführungsform der elektrischen Schaltvorrichtung nach der Figur 56 in der Darstellung der Figur 58, wobei die Schaltvorrichtung in einer Betätigungsstellung gezeigt ist, bei der eine äußere Druckkraft auf einen ersten seitlichen Randabschnitt des Betätigungsteils von einer Betätigungsseite her ausgeübt wird,
- Figur 60 die Ausführungsform der elektrischen Schaltvorrichtung nach der Figur 56 in der Darstellung der Figur 58, wobei eine gegenüber der Figur 59 größere äußere Druckkraft ausgeübt wird,
- Figur 61 die Ausführungsform der elektrischen Schaltvorrichtung nach der Figur 56 in der Darstellung der Figur 58, gegenüber der Figur 60 eine weitere äußere Druckkraft an einem zweiten seitlichen Randabschnitt des Betätigungsteils ausgeübt wird, der entgegen gesetzt zu dem ersten seitlichen Randabschnitt gelegen ist,
- Figur 62 eine Detaildarstellung der Ausführungsform der elektrischen Schaltvorrichtung nach der Figur 56 mit dem ersten seitlichen Randabschnitt des Betätigungsteils, wobei sich die Schaltvorrichtung in dem in der Figur 58gezeigten Ausgangszustand befindet,
- Figur 63 die Detaildarstellung der Figur 62, wobei sich die Schaltvorrichtung in dem in der Figur 60 gezeigten Betätigungszustand befindet,
- Figur 64 die Detaildarstellung der Figur 62, wobei sich die Schaltvorrichtung in dem in der Figur 61 gezeigten Betätigungszustand befindet,
- Figur 65 als erster Schritt einer Schrittfolge von drei Schritten eine Schnittdarstellung der Ausführungsform der elektrischen Schaltvorrichtung nach der Figur 56 entlang der in der Figur 56 eingetragenen Linie L65-L65, wobei die Schaltvorrichtung in einer Ausgangsstellung gezeigt ist,
- Figur 66 die Schnittdarstellung der Ausführungsform der elektrischen Schaltvorrichtung nach der Figur 56 in der Darstellung der Figur 65, wobei die Schaltvorrichtung in einem Betätigungszustand gezeigt ist, bei dem mittig eine Kraft F1 auf das Betätigungsteil ausgeübt wird,
- Figur 67 die Schnittdarstellung der Ausführungsform der elektrischen Schaltvorrichtung nach der Figur 56 in der Darstellung der Figur 65, wobei die Schaltvorrichtung wiederum in der Ausgangsstellung gezeigt ist,

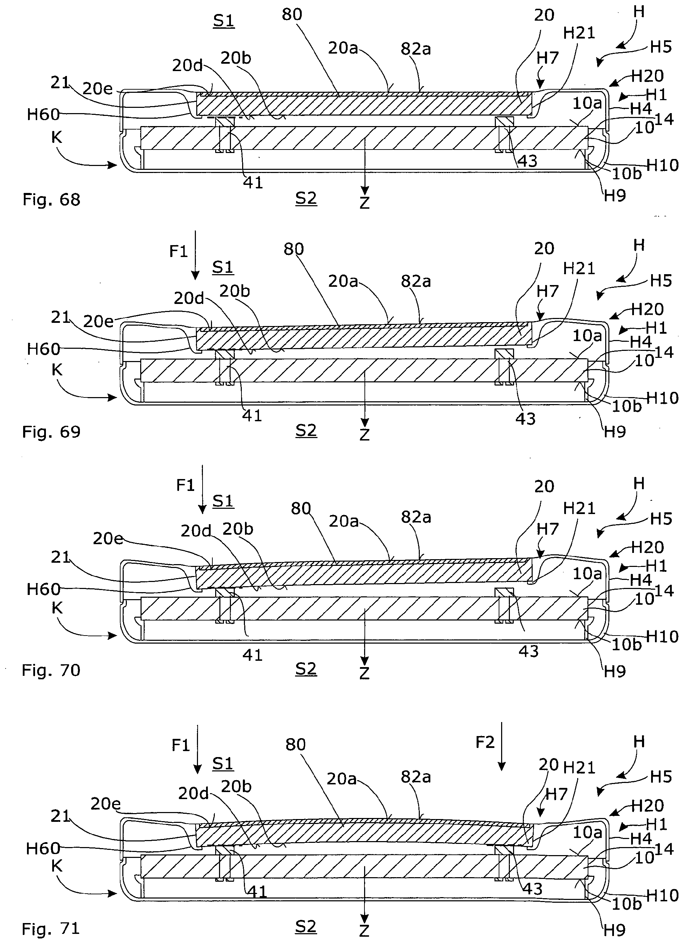

- Figuren 68 bis 71 Darstellungen von Betriebszuständen einer weiteren Ausführungsform der der elektrischen Schaltvorrichtung, wobei die Schaltvorrichtung keine Verbindungsschicht aufweist und ein umlaufender Randabschnitt des Gehäuseteils mit dem Betätigungsteil verbunden ist, wobei die Betriebszustände einen Ausgangszustand (Figur 68), einen ersten Verformungszustand durch Ausübung einer seitlichen Kraft F1 auf das Betätigungsteil (Figur 69), einen weiteren Verformungszustand durch Ausübung der seitlichen Kraft F1 mit einem größeren Betrag auf das Betätigungsteil (Figur 69) und einen Verformungszustand durch Ausübung der seitlichen Kraft F1 sowie einer weiteren seitlichen Kraft F2 auf das Betätigungsteil (Figur 70) beinhalten,
- Figur 72 eine Draufsicht einer weiteren Ausführungsform der elektrischen Schaltvorrichtung, wobei die Sensoren als in der Draufsicht verdeckte Teile gestrichelt dargestellt sind, wobei die Verbindungsvorrichtung anders als in den vorangehenden Figuren ausgebildet ist und wobei ein Display im Grundkörper integriert ist,
- Figur 73 eine Schnittdarstellung der Ausführungsform der elektrischen Schaltvorrichtung nach der Figur 72 entlang der in der Figur 72 eingetragenen Linie L73-L73,
- Figur 74 eine Schnittdarstellung der Ausführungsform der elektrischen Schaltvorrichtung nach der Figur 72 entlang der in der Figur 72 eingetragenen Linie L74-L74,
- Figur 75 eine Draufsicht einer weiteren Ausführungsform der elektrischen Schaltvorrichtung, wobei die Sensoren als in der Draufsicht verdeckte Teile gestrichelt dargestellt sind, wobei die Verbindungsvorrichtung anders als in den vorangehenden Figuren und mehrteilig ausgebildet ist und wobei ein Display im Grundkörper integriert ist,
- Figur 76eine Schnittdarstellung der Ausführungsform der elektrischen Schaltvorrichtung nach der Figur 75 entlang der in der Figur 75 eingetragenen Linie L76-L76,
- Figur 77 eine Schnittdarstellung der Ausführungsform der elektrischen Schaltvorrichtung nach der Figur 75 entlang der in der Figur 75 eingetragenen Linie L77-L77,
- Figur 78 eine perspektivische Explosionsdarstellung einer Ausführungsform der elektrischen Schaltvorrichtung mit einer Darstellung der elektrischen Anbindung eines in dem Betätigungsteil integrierten Displays an elektrische Komponenten des Grundkörpers,
- Figur 79 eine perspektivische Darstellung einer gegenüber der Darstellung der Figur 78 weiteren Ausführungsform der elektrischen Schaltvorrichtung mit einer Darstellung der elektrischen Anbindung eines in dem Betätigungsteil integrierten Display,
- Figuren 80 bis 84 Darstellungen einer weiteren Ausführungsform der elektrischen Schaltvorrichtung mit einem Gehäuse,
- Figur 85 eine funktionale Darstellung einer Ausführungsform der Schaltvorrichtung mit einem Display und einer Verarbeitungsvorrichtung sowie einer externen Arbeitseinrichtung mit einem Zentralsystem und externen Teilnehmern, wobei das Display im Betätigungsteil angeordnet ist,
- Figur 86 eine funktionale Darstellung einer Ausführungsform der Schaltvorrichtung mit einem Display und einer Verarbeitungsvorrichtung sowie einer externen Arbeitseinrichtung mit einem Zentralsystem und externen Teilnehmern, wobei das Display im Grundkörper angeordnet ist,
- Figuren 87 bis 94 Darstellungsformate eines in Ausführungsformen der Schaltvorrichtung verwendeten Displays,
- Figur 95 ein Ablauf-Diagramm für ein Logistikverfahren, das mit Ausführungsformen der Schaltvorrichtung mit einem Display ausführbar ist,
- Figur 96 eine Darstellung der Menüsteuerung, mit der Menüdarstellungen mit zu erfüllenden Aufgaben in einem Display einer Ausführungsform einer Schaltvorrichtung sichtbar bereitgestellt wird,
- Figur 97 eine funktionale Darstellung einer Ausführungsform eines Arbeitssystems.

Nach der Erfindung ist eine elektrische Schaltvorrichtung 1 zur Erzeugung von mehreren Schaltzuständen vorgesehen, die über elektrische Leitungen oder einen elektrischen Kontakt von einer Ansteuerungsvorrichtung insbesondere zur Erzeugung von Stellkommandos für eine Stellvorrichtung abgreifbar sind. Zur Erzeugung der Schaltzustände wird die elektrische Schaltvorrichtung 1 auf einer Betätigungsseite S1 desselben betätigt. In den Figurendarstellungen ist ein kartesisches Koordinatensystem mit einer X-Achse, einer Y-Achse oder Dickenrichtung Z und einer z-Achse eingetragen. Die Z-Achse verläuft in der Dickenrichtung Z der elektrischen Schaltvorrichtung 1. In Bezug auf die Dickenrichtung Z der elektrischen Schaltvorrichtung 1 ist in der Z-Richtung entgegen gesetzt zu der Betätigungsseite S1 eine Rückseite S2 der elektrischen Schaltvorrichtung 1 desselben gelegen.

Mit der Schaltvorrichtung 1 kann eine von einem oder mehreren Teilnehmern T bzw. T1, T2, T3 des Arbeitssystems S zu erfüllende Teilnehmer-Aufgabe ermittelt, gegebenenfalls zur Anzeige gebracht werden, und als Aufgabendurchführungs-Kommando über einen Übertragungsweg 93a an das Zentralsystem Z oder einem oder mehreren Teilnehmern T bzw. T1, T2, T3 des Arbeitssystems S, das ein industrielles Arbeitssystem S und insbesondere ein Lagersystem oder eine Produktionsanlage sein kann, übermittelt werden.

Die elektrische Schaltvorrichtung 1 weist einen Grundkörper 10 mit einer ersten oder oberen Oberfläche oder Anschluss-Oberfläche 10a auf, die der Betätigungsseite S1 der elektrischen Schaltvorrichtung 1 zugewandt ist, und eine zweite oder untere Oberfläche 10b auf, die entgegen gesetzt zu der oberen Oberfläche 10a gelegen ist.

Der Grundkörper 10 kann insbesondere plattenförmig und dabei insbesondere rechteckförmig gestaltet sein. Die flächige Erstreckung des Grundkörpers 10 verläuft dabei quer zur Dickenrichtung Z und entlang der X-Koordinate und der Y-Koordinate. Die X-Koordinate kann insbesondere definiert sein als eine mittlere Verbindungslinie der Flächenschwerpunkte von jeweils kleinsten Querschnittsflächen, die sich entlang einer Längsrichtung ergeben, oder eine gemittelte Verbindungslinie durch diese.

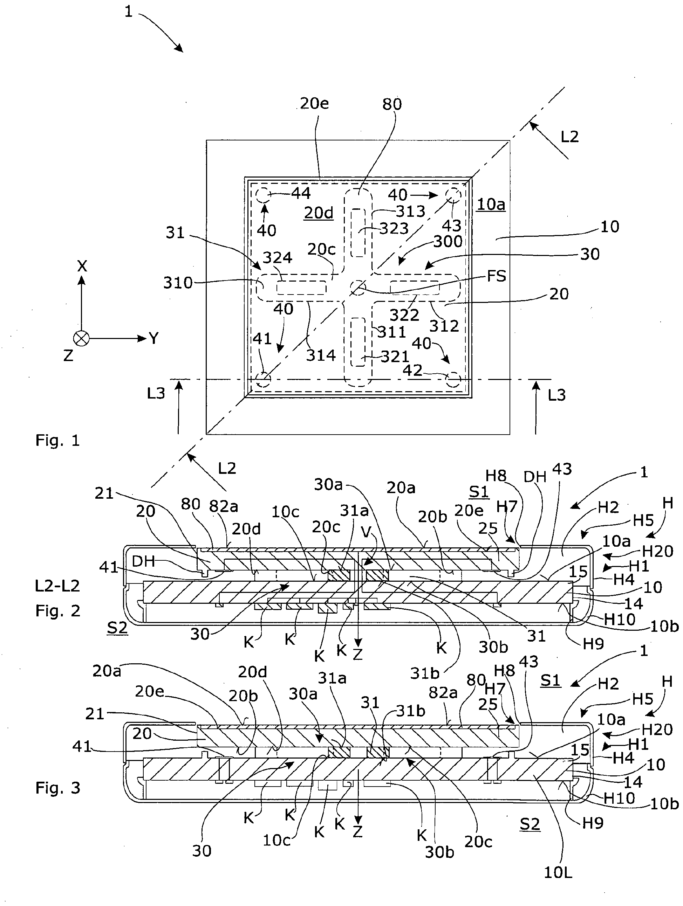

Weiterhin weist die elektrische Schaltvorrichtung 1 ein Betätigungsteil oder eine Betätigungsplatte 20 auf, das sich quer zur Dickenrichtung Z erstreckt und das in der Dickenrichtung Z gesehen auf dem Grundkörper 10 an der Seite von dessen erster Oberfläche 10a angeordnet ist. Das Betätigungsteil 20 kann insbesondere als Betätigungsplatte ausgeführt sein. Dabei kann das Betätigungsteil 20, wie es in der Ausführungsform der Figur 1 dargestellt ist, in der Draufsicht oder in der Z-Richtung gesehen rechteckförmig oder zumindest im Wesentlichen rechteckförmig gestaltet sein. Unter dem Ausdruck "im Wesentlichen rechteckförmig" wird hierin eine Form verstanden, bei der die jeweils entlang zueinander verlaufenden Randlinien parallel oder in etwa parallel verlaufen und zumindest einer der Eckbereiche abgerundete Ecklinien-Abschnitte haben kann. Ein Verlaufen von Randlinien "in etwa parallel" zueinander soll hierin bedeuten, dass die jeweiligen Randlinien derart zueinander verlaufen, dass zwischen den Tangenten an die jeweiligen Randlinien an einander gegenüber liegenden Punkten der jeweiligen Randlinien maximal ein Winkel von 20 Grad besteht, wobei die einander gegenüber liegenden Punkte ausgehend von einer der Randlinien Punkte mit jeweils geringstem Abstand voneinander sind. Das Betätigungsteil 20 kann in der Draufsicht oder in der Z-Richtung gesehen auch oval oder kreisförmig gestaltet sein.

Weiterhin weist die erfindungsgemäße Schaltvorrichtung eine Gehäusevorrichtung H auf, die aus einem Gehäuseteil H1 gebildet sein kann, das sich im Wesentlichen auf der Betätigungsseite S1 erstreckt.

Das Betätigungsteil 20 weist eine Betätigungsoberfläche 20a, die der Betätigungsseite S1 der elektrischen Schaltvorrichtung 1 zugewandt ist, und eine entgegen gesetzt zu dieser gelegenen und der Anschluss-Oberfläche 10a des Grundkörpers 10 zugewandte Anschluss-Oberfläche 20b auf. Die Betätigungsoberfläche 20a ergibt sich in der Draufsicht auf das Betätigungsteil 20 insbesondere in der Dickenrichtung oder der Z-Richtung.

Der Grundkörper 10 kann insbesondere als Leiterplatten-Anordnung ausgeführt sein, die eine Leiterplatte 10L aus einem Leiterplattenmaterial und mit dieser integrierte elektronische Komponenten aufweist. In der Darstellung der Figur 2 sind mehrere elektronische Komponenten K an der unteren Oberfläche 10b des Grundkörpers 10 angeordnet, die an Leiterbahnen der Leiterplatte 10L angeschlossen sind. Die elektronischen Komponenten K können auch in anderer Weise als dargestellt realisiert sein.

Weiterhin weist die elektrische Schaltvorrichtung 1 eine Verbindungsvorrichtung 30 mit wenigstens einer Verbindungsschicht aus einem elastischen Material auf. Dabei kann vorgesehen sein, dass die Verbindungsvorrichtung 30 aus zumindest einer Verbindungsschicht besteht, dass also die Schaltvorrichtung 1 kein weiteres Verbindungsmittel aufweist. Dabei kann jede der zumindest einen Verbindungsschicht in ihrer flächigen Erstreckung kontinuierlich zusammenhängend ausgebildet sein. Bei anderen Ausführungsformen der Schaltvorrichtung 1 kann vorgesehen sein, dass die zumindest eine Verbindungsschicht oder eine einzelne Verbindungsschicht der zumindest einen Verbindungsschicht eine sich in deren Dickenrichtung Z erstreckende und die Verbindungsschicht in deren ganzen Dicke durchgehende Ausnehmung aufweist bzw. aufweisen. Die zumindest eine Verbindungsschicht der Verbindungsvorrichtung 30 oder die Verbindungsvorrichtung 30 ist generell mit einer ersten Oberfläche 30a an einem Verbindungsbereich oder in der Z-Richtung gesehen inneren Bereich 20c der Anschluss-Oberfläche 20b des Betätigungsteils 20 und mit einer zweiten Oberfläche 30b an einem inneren Bereich 10c der Anschluss-Oberfläche 10a des Grundkörpers 10 befestigt oder mit dem jeweiligen inneren Bereich 10c, 20c verbunden.

Bei der Ausführungsform der Figur 1 besteht die Verbindungsvorrichtung 30 aus einer Verbindungsschicht 31, die mit einer ersten Oberfläche 31a an einem Verbindungsbereich oder in der Dickenrichtung Z gesehen inneren Bereich 20c der Anschluss-Oberfläche 20b des Betätigungsteils 20 und mit einer zweiten Oberfläche 31b an einem in der Dickenrichtung Z gesehen inneren Bereich 10c der Anschluss-Oberfläche 10a des Grundkörpers 10 befestigt oder mit dem jeweiligen inneren Bereich 10c, 20c verbunden ist.

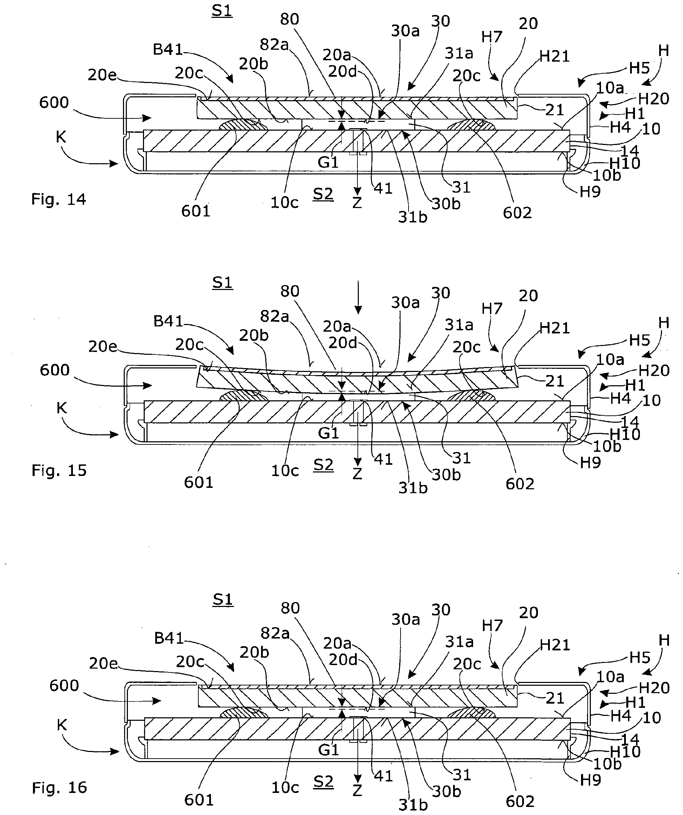

Das elastische Material kann - insbesondere bei jeder der hierin genannten Ausführungsformen - ein selbsthaftendes Material sein, so dass die Verbindungsschicht 31 an den inneren Bereichen 10c, 20c anhaftet. Dazu alternativ oder zusätzlich kann, wie es beispielartig in der Figur 16 dargestellt ist, vorgesehen sein, dass die Verbindungsschicht 31 mittels einer Klebeschicht an einem der inneren Bereiche 10c, 20c oder an beide der inneren Bereiche 10c, 20c angeklebt ist. Insbesondere kann dabei vorgesehen sein, dass die Verbindungsvorrichtung 30 aus einer Verbindungsschicht 31, einer ersten Klebeschicht 30i, die zwischen der Verbindungsschicht 31 und der Anschluss-Oberfläche 10a des Grundkörpers 10 gelegen ist, und einer ersten Klebeschicht 30i, die zwischen der Verbindungsschicht 31 und der Anschluss-Oberfläche 10a des Grundkörpers 10 gelegen ist, gebildet ist oder aus diesen Schichten besteht. Das Klebermaterial kann insbesondere ein elastisches Material sein.

Bei der Ausführungsform der Schaltvorrichtung mit einer zentralen Verbindungsschicht 31, wie sie in den Figuren 1 bis 3 gezeigt ist, kann sich die Verbindungsschicht 31 über die gesamte Anschlussoberfläche 10b oder die gesamte Anschlussoberfläche 20b erstrecken, falls eine der Anschlussoberflächen zumindest in einer Erstreckungsrichtung größer ist als die jeweils andere und je nachdem, welche der Anschlussoberflächen größer ist. Alternativ dazu kann die Größe der inneren Bereiche 10c, 20c, wie es in den Figuren 1 bis 4 dargestellt ist, auch derart definiert sein, dass die diese flächenmäßig maximal 75 % der Größe der Anschluss-Oberfläche 20b des Betätigungsteils 20 beträgt oder innerhalb einer Kreises gelegen ist, dessen Fläche maximal 75 % der Größe der Anschluss-Oberfläche 20b des Betätigungsteils 20 beträgt. Alternativ oder zusätzlich kann definiert sein, dass der Flächenschwerpunkt FS der Betätigungsoberfläche 20a des Betätigungsteils 20 oder der Öffnung H7 in ihrer jeweiligen flächigen Erstreckung gesehen innerhalb des inneren Bereichs 20c der Anschluss-Oberfläche 20b des Betätigungsteils 20 und innerhalb der Verbindungsschicht 31 gelegen ist.

Im Folgenden wird der Flächenschwerpunkt FS zum einen auf die Betätigungsoberfläche 20a des Betätigungsteils 20 oder, zur Beschreibung einer alternativen Ausführungsform, auf die Öffnung H7 in ihrer jeweiligen flächigen Erstreckung bezogen.

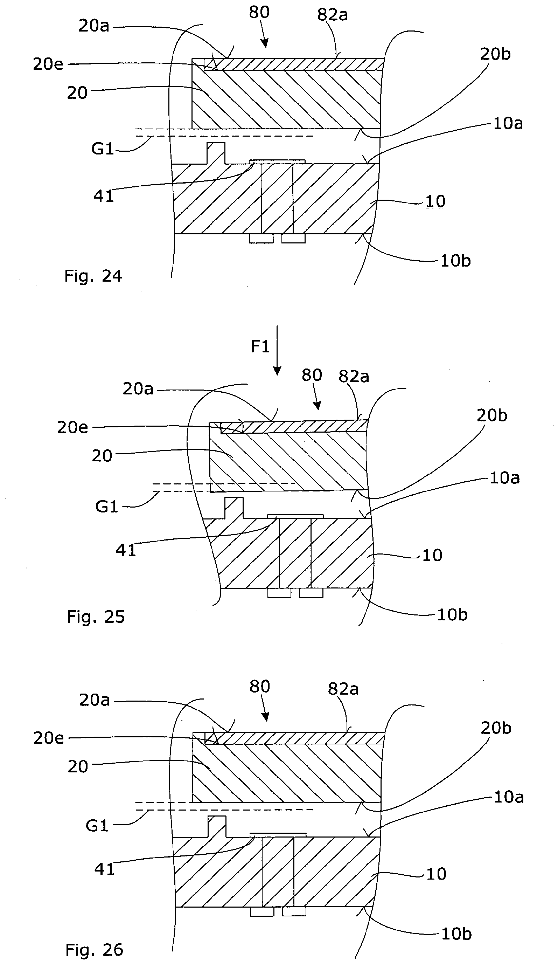

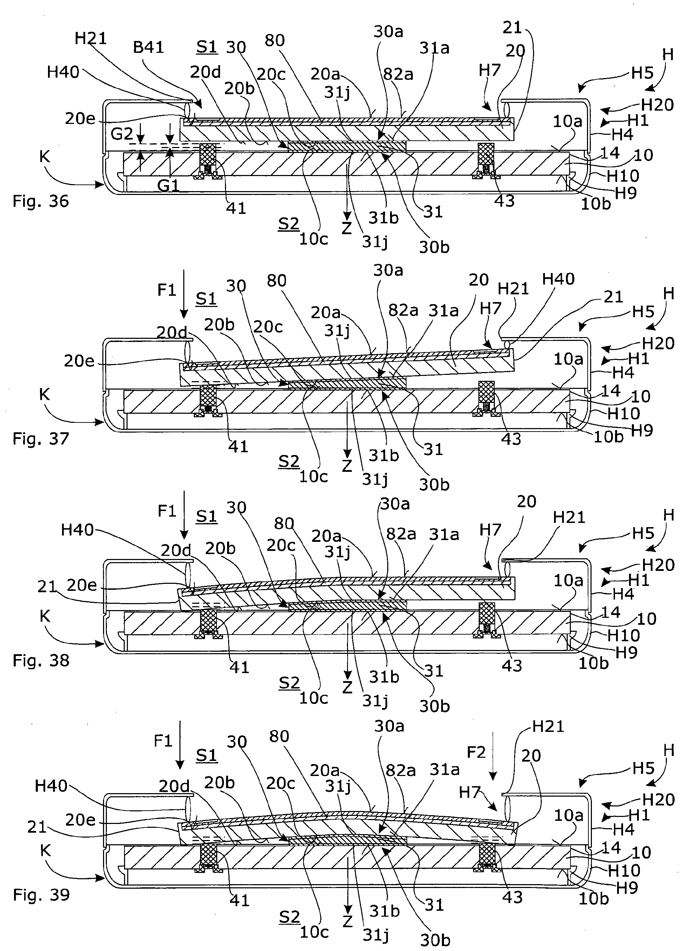

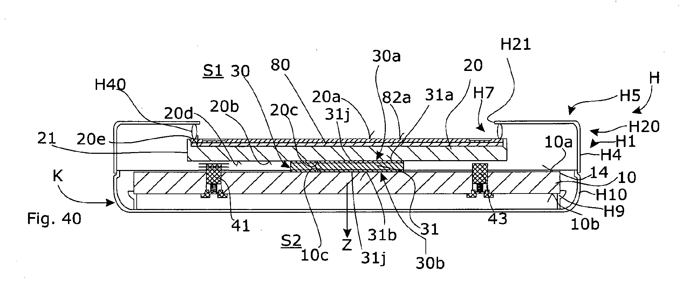

Beispielsweise bei den Ausführungsformen der Schaltvorrichtung nach den Figuren 1 bis 44 ragt das Betätigungsteil 20 vom Flächenschwerpunkt FS aus gesehen über die Verbindungsschicht 31 hinaus, so dass die Schaltvorrichtung 1 einen den Verbindungsbereich oder inneren Bereich 20c der Anschluss-Oberfläche 20b in der flächigen Erstreckung des Grundkörpers 10 gesehen vorstehenden Bereich 20d aufweist. Dabei kann insbesondere vorgesehen sein, dass der vorstehende Bereich 20d den Verbindungsbereich oder inneren Bereich 20c oder die Verbindungsschicht 31 vollständig umgibt, also den Verbindungsbereich oder inneren Bereich 20c oder die Verbindungsschicht 31 umschließt. Der überstehende Bereich ist mit dem Bezugszeichen 20d bezeichnet. Dieser ist in der Ausführungsform der Figur 1 die Verbindungsschicht 31 umlaufend ausgeführt. Danach ist die Anschluss-Oberfläche 20b des Betätigungsteils 20 aus dem Verbindungsbereich 20c und dem überstehende Bereich 20d gebildet.

Das Material der Verbindungsschicht 31 ist insofern elastisch, als diese auf ein Zusammendrücken des Betätigungsteils 20 gegenüber dem Grundkörper 10 eine Rückstellkraft erzeugt. Das Material der Verbindungsschicht 31 kann insbesondere aus einem Acrylmaterial gebildet sein. Insbesondere kann das Material ein schaumförmiges Acrylmaterial sein. Insbesondere kann ein sowohl beidseitig selbstklebendes als auch elastisches Material aus dem Bereich der industriellen Klebetechnik verwendet werden, wie es beispielsweise unter der Produktbezeichnung "ACXplus" von der Firma "tesa SE" angeboten wird. Die Verbindungsschicht 31 kann auch aus Silikon oder einem Schaum-Material gebildet sein. Auch kann die Verbindungsschicht 31 aus einem Schaum-Material mit Acrylanteilen bestehen. Insbesondere in dem Fall, dass in dem Grundkörper 10 ein Display angeordnet ist und das Display in der Dickenrichtung Z gesehen zumindest teilweise innerhalb der Verbindungsschicht 31 gelegen ist, kann die Verbindungsschicht 31 aus einem optisch durchsichtigen Material gebildet sein, so dass hinter der Verbindungsschicht 31 liegende Anzeigeelemente sichtbar sind.

Die Dicke der Verbindungsschicht 31 in der Z-Richtung kann zwischen 0,2 mm und 10 mm, jedoch vorzugweise zwischen 0,2 mm und 5 mm betragen. Auch kann die Dicke der Verbindungsschicht 31 in der Z-Richtung durch die Größe des Betätigungsteils 20 derart definiert sein, dass die Dicke der Verbindungsschicht 31 in der Z-Richtung 1/100 bis 1/10 der größten Längserstreckung der Betätigungsplatte quer zur Z-Richtung beträgt. Für den Dickenbereich kann insbesondere ein Randbereich der Verbindungsschicht 31 ausgenommen sein, der insbesondere zwischen 1 mm und 2 mm betragen kann.

Das Gehäuseteil H1 der Gehäusevorrichtung H weist auf: eine Seitenwand H4, die die Verbindungsvorrichtung 30, soweit dieses ein Teil der Schaltvorrichtung 1 ist, das Betätigungsteil 20 in der Dickenrichtung Z gesehen zumindest abschnittsweise umgibt, und einen Randabschnitt H5, der sich zu der Betätigungsseite S1 hin an der Seitenwand H4 anschließt, sich entlang der Erstreckungsrichtung des Betätigungsteils 20 erstreckt und eine zentrale Öffnung H7 ausbildet, in der sich gegebenenfalls zumindest abschnittsweise das Display 80 erstreckt.

Das Gehäuseteil H1 kann insbesondere relativ flach, d.h. mit einer relativ niedrigen Bauhöhe ausgeführt sein. Mit diesen Bezeichnungen ist hierin gemeint, dass die größte Breite des Gehäuseteils H1 in der X-Y-Ebene um mindestens das Fünffache größer ist wie die größte Dicke des Gehäuseteils H1 in der Z-Richtung gesehen.

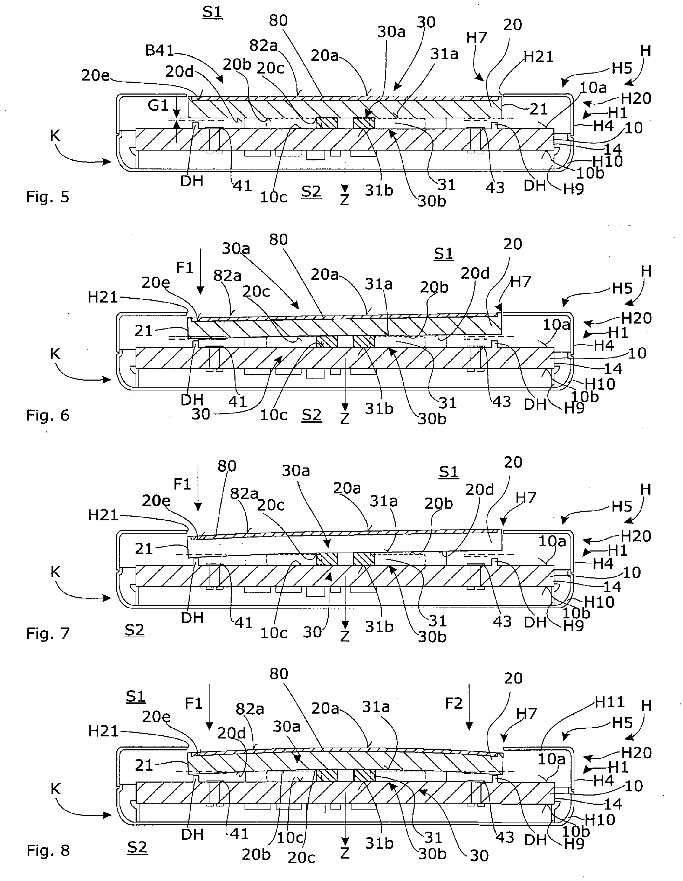

Bei der Ausführung der Schaltvorrichtung 1 mit einem Display ist die Öffnung H7 des Gehäuseteils H1 vorzugsweise im Wesentlichen rechteckig gebildet, wie es z.B. in den Figuren 1 und 5 dargestellt ist. Insbesondere ist vorgesehen, dass der Innenrand H8 aus zwei Paaren von Seitenrand-Abschnitten H81, H83 und H82, H84 gebildet ist, die zumindest abschnittsweise entlang zueinander verlaufen, so dass diese eine im Wesentlichen rechteckige sichtbare Display-Fläche in der Draufsicht in Z-Richtung bereitstellen. Dementsprechend kann der Innenrand H8 aus vier Ecken oder Eckabschnitten H85, H86, H87, H88 gebildet sein, von denen einer jeweils zwischen zwei entsprechenden zueinander benachbarten Seitenrand-Abschnitten H81, H82, H83, H84 gelegen ist. Bei der Ausführungsform der Figuren 1 und 5 sind zwischen jeweils zwei entsprechenden zueinander benachbarten Seitenrand-Abschnitten H81, H82, H83, H84 jeweils eine Ecke H85, H86, H87, H88 ausgebildet. Alternativ dazu kann vorgesehen sein, dass zwischen jeweils zwei entsprechenden zueinander benachbarten Seitenrand-Abschnitten H81, H82, H83, H84 jeweils gekrümmte und insbesondere von dem FS aus gesehen konkav gekrümmte Eckabschnitte H85, H86, H87, H88 ausgebildet sind.

Die Seitenwand H4 erstreckt sich entlang der Z-Richtung und kann als das Betätigungsteil 20 kontinuierlich umlaufende Wand ausgebildet sein. Auch kann die Seitenwand H4 derart ausgeführt sein, dass diese das Betätigungsteil 20 entlang seines Umfangs abschnittsweise umgibt, also z.B. mehrere entlang des Umfangs des Betätigungsteils 20 verteilt angeordnete Ausnehmungen aufweist. Dabei kann die Seitenwand H4 z.B. seitlich von dem Grundkörper 10 ausgehen. insbesondere sich an die sich in der Z-Richtung gesehen ergebende Außenfläche 14 oder an einem an diese anschließenden Außenrand-Abschnitt 15 des Grundkörpers 10 anschließen. Dabei kann die Seitenwand H4 direkt über ein Zwischenteil mit der Außenfläche 14 oder an dem Außenrand-Abschnitt 15 verbunden sein. Die Seitenwand H4 kann ein auf der zweiten Seite S2 gelegenes äußeres Teil des Gehäuseteils H1 sein.

Auch kann, wie es in den Figuren 2 und 3 dargestellt ist, das Gehäuseteil H1 eine Haltevorrichtung H9 aufweisen, von der der Grundkörper 10 aufgenommen ist und an der der Grundkörper 10 befestigt sein kann. Die Haltevorrichtung H9 kann als Sockel oder gemäß der Figur 2 als Haltearm ausgeführt sein.

Das Gehäuseteil H1 kann, wie es in der Figur 1 dargestellt ist, ein an der Rückseite S2 der elektrischen Schaltvorrichtung 1 angeordnetes Bodenteil H10 und ein Abdeckungsteil H20 aufweisen, wobei das Bodenteil H10 und das Abdeckungsteil H20 einen Innenraum H2 ausbilden, in dem der Grundkörper 10 und das Betätigungsteil 20 gelegen ist. Dabei kann die Haltevorrichtung H10 als Anbauteil des Bodenteils H10 ausgeführt sein. Das Bodenteil H10 und das Abdeckungsteil G20 können zusammen in einem Stück oder aus einem Stück hergestellt sein, z.B. durch ein Gießverfahren und insbesondere ein Kunststoff-Spritzgussverfahren. In der Darstellung der Figuren 1 bis 3 ist das Gehäuse als zweiteiliges Gehäuse ausgeführt, wobei der das Bodenteil H10 als ein erstes Teil und das Abdeckungsteil H20 als ein zweites Teil ausgebildet sind und das Abdeckungsteil H20 auf dem Bodenteil H10 aufgesetzt und an diesem fixiert ist, so dass das Gehäuse insgesamt ein Teil bildet. Das Bodenteil H10 und das Abdeckungsteil G20 können jeweils insbesondere schalenförmig gebildet sein. Auch kann das Gehäuseteil H1 derart ausgebildet sein, dass nur das Bodenteil H10 oder nur das Abdeckungsteil G20 jeweils schalenförmig gebildet ist.

Bei der Ausführungsform der Figuren 1 bis 3 ist die Seitenwand H4 in der Dickenrichtung Z gesehen zumindest teilweise außerhalb des Betätigungsteils 20 gelegen. Dabei kann die Seitenwand H4 den Grundkörper 10 entlang dessen Umfang umgeben. An die Seitenwand H4 schließt sich in Richtung zur Betätigungsseite S1 ein Randabschnitt H5 des Gehäuseteils H1 an, der eine in der Z-Richtung gesehen innere zentrale Öffnung H7 aufweist und ausbildet. Der Außenrand der Betätigungsplatte 20 verläuft entlang dem die Öffnung H7 ausbildenden Innenrand H8.

Bei einer Ausführungsform der Schaltvorrichtung 1 kann diese derart ausgeführt sein, dass die in der Z-Richtung gesehen äußere Randoberfläche 21 der Betätigungsplatte 20 in der Z-Richtung gesehen innerhalb des an der Betätigungsseite S1 gelegenen Innenrands H7 desRandabschnitts H5 des Gehäuseteils H1 gelegen ist, so dass das Betätigungsteil 20 in der Z-Richtung gesehen innerhalb der Öffnung H7 gelegen ist (Figur 2).

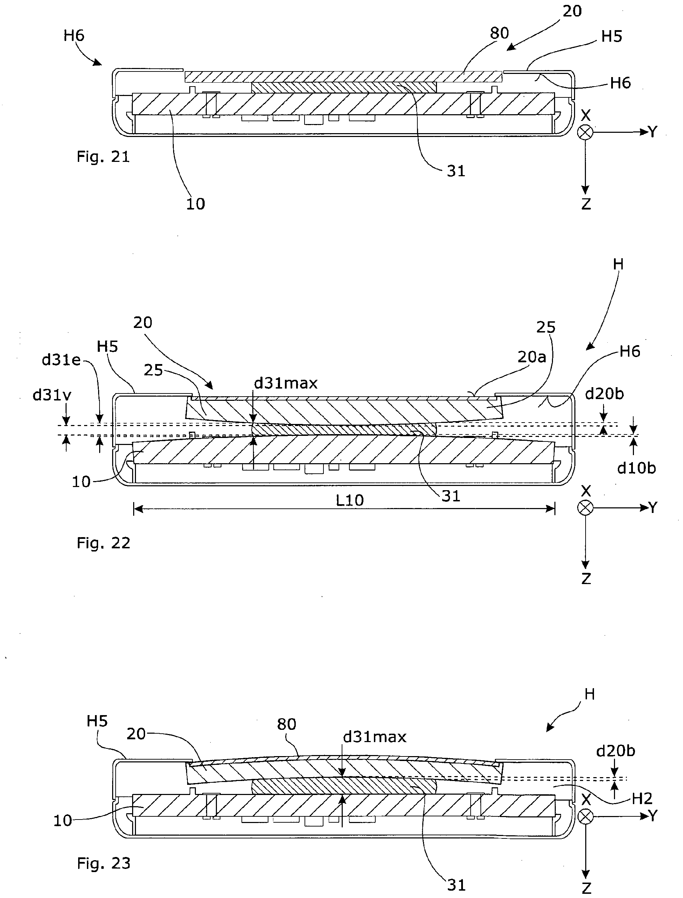

Generell kann, wie es in der Figur 21 dargestellt ist, bei den hierin beschriebenen Ausführungsformen vorgesehen sein, dass das Betätigungsteil 20 als Display 80 ausgeführt ist. Dabei kann das Display 80 eine steife Basisplatte aufweisen, auf der die Bilderzeugungskomponenten angeordnet sind.

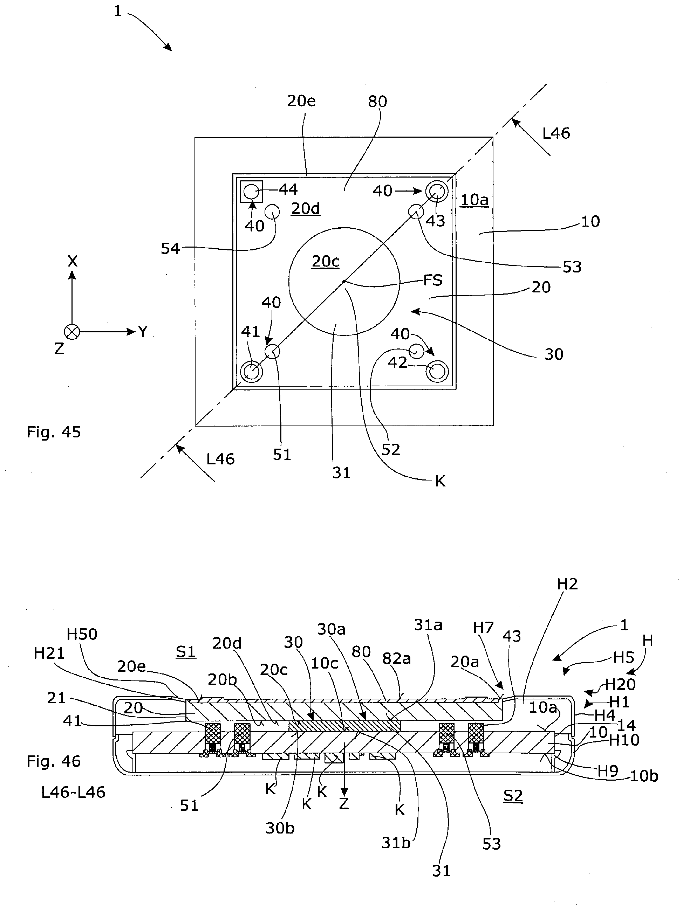

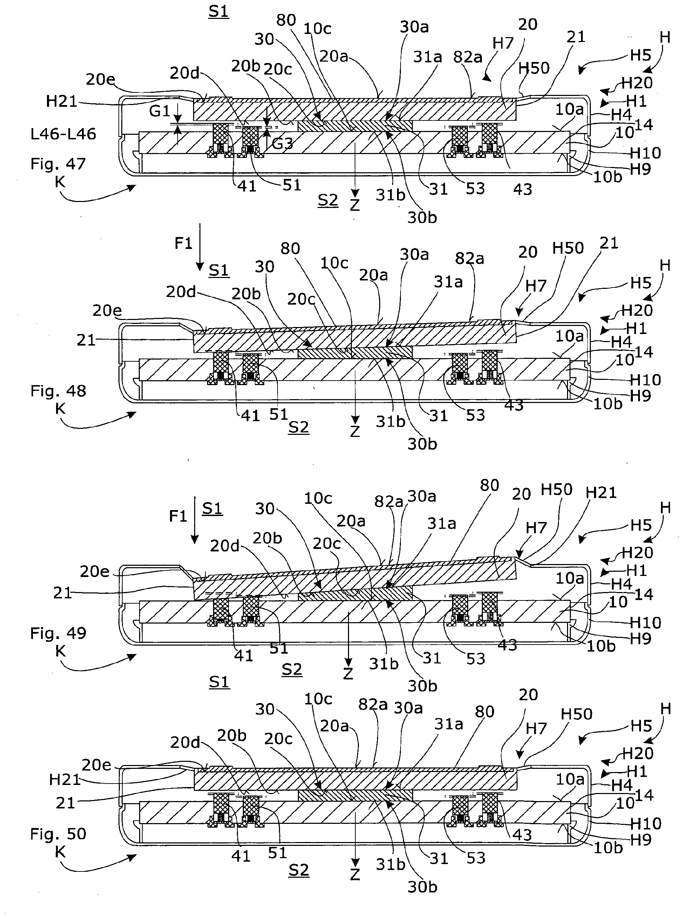

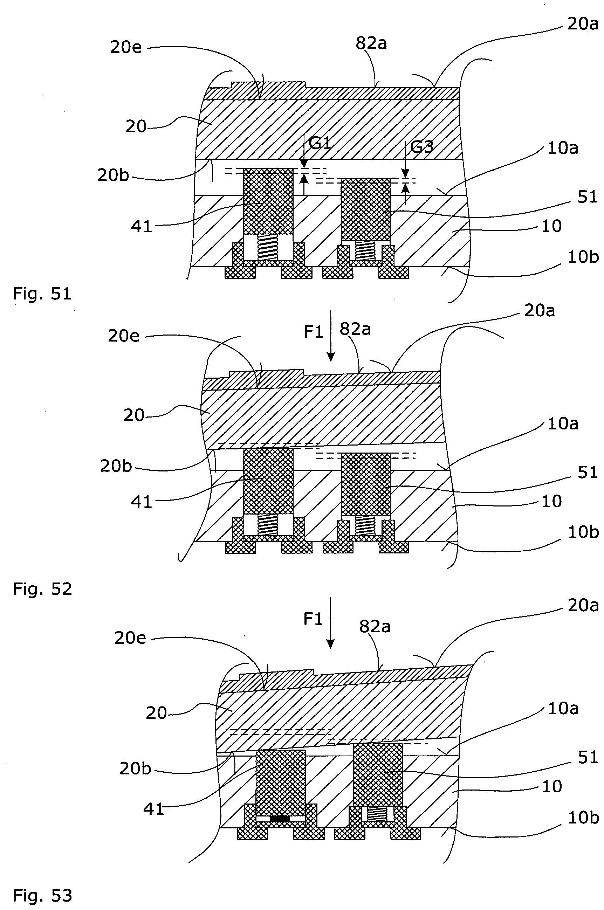

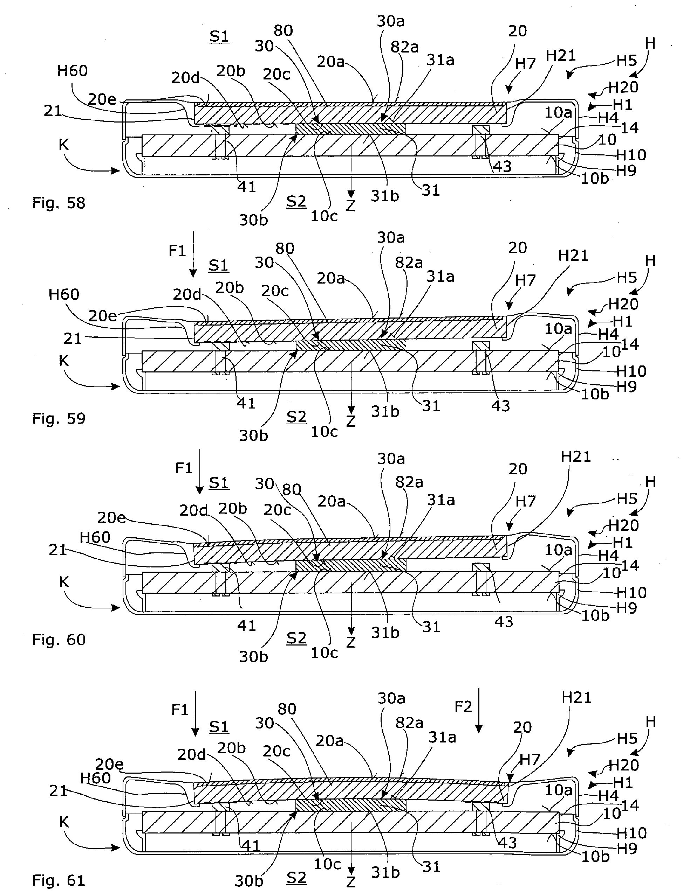

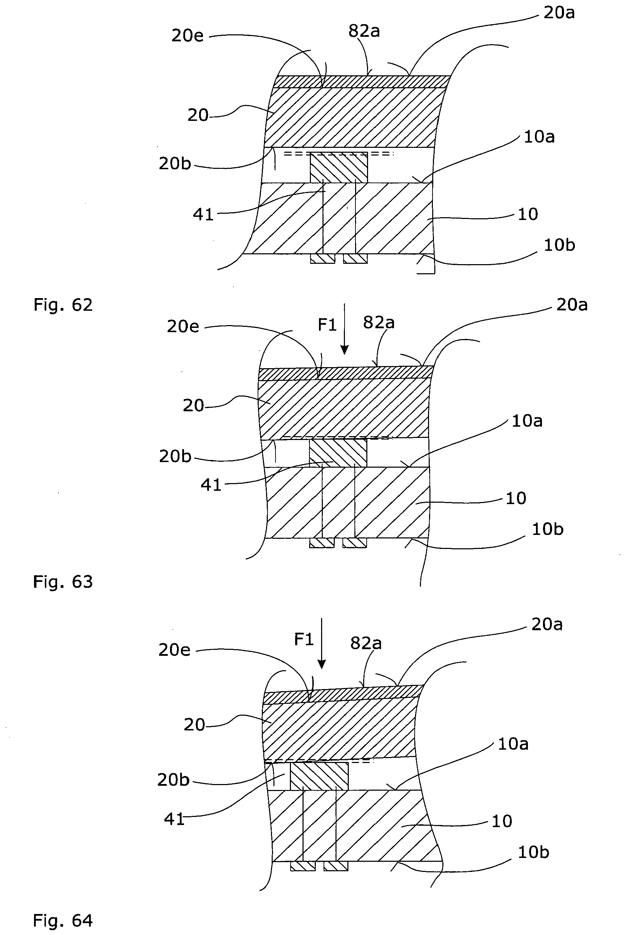

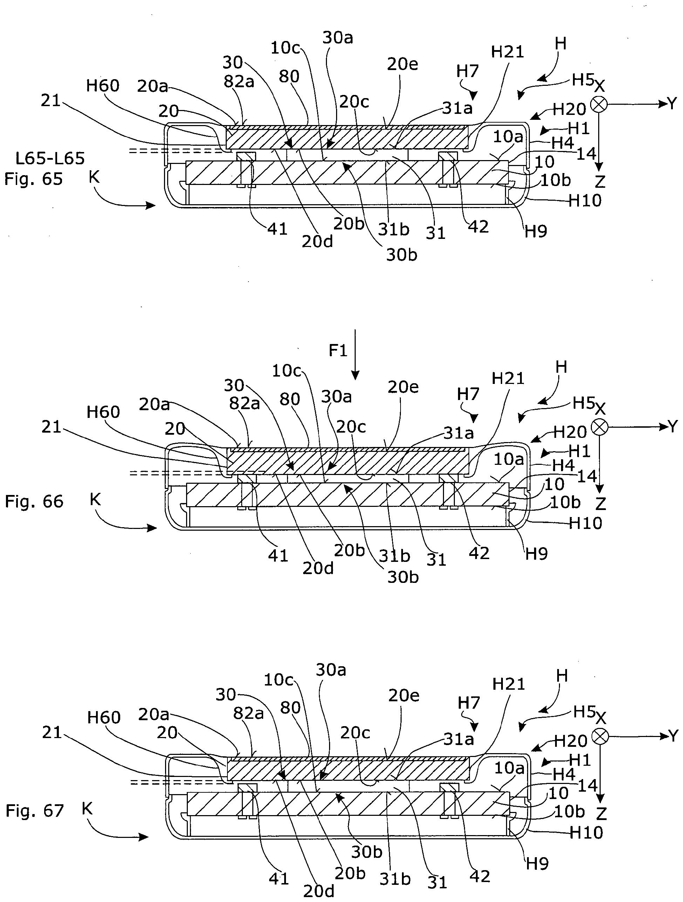

Bei allen hierin beschriebenen Ausführungsformen kann, auch wenn es an diesen jeweils nicht konkret beschrieben wird, vorgesehen sein, dass die Betätigungsplatte 20 in der Z-Richtung gesehen überlappend mit dem Randabschnitt H5 des Gehäuseteils H1 gelegen ist. Dies ist beispielsweise bei den Ausführungsformen der Figuren 21, 23, 27 bis 53, 54, 55 sowie 56 bis 71 gezeigt.

Bei diesem Merkmal der Überlappung kann insbesondere vorgesehen sein, dass der Randabschnitt H5 des Gehäuseteils H1 mit einem Randabschnitt 25 des Betätigungsteils 20 verbunden ist, wenn sich das Betätigungsteil 20 in seiner Ausgangsstellung oder Neutralstellung befindet. Der Randabschnitt 25 des Betätigungsteils 20 ist als ein in der Z-Richtung gesehen äußerer, an einer sich in dieser Blickrichtung ergebenen äußeren Randlinie 21 anschließenden Bereich des Betätigungsteils 20 definiert. Die Ausgangsstellung oder Neutralstellung des Betätigungsteils 20 ist derart definiert, dass dieses mit seinem Randabschnitt 25 an jeder Stelle des Außenumfangs eine Entfernung zu jedem der Sensoren hat, bei dem der Grenzwert G1 nicht überschritten wird. Mit anderen Worten ist die Ausgangsstellung oder Neutralstellung des Betätigungsteils 20 derart definiert, dass an keinem der Sensoren die in der Figur 6 gezeigte Situation eintritt und auch keine äußere Betätigungskraft (z.B. F1 oder F2) angreift. Dabei kann vorgesehen sein, dass eine der Grundplatte 10 zugewandte Innenfläche H6 des vorzugsweise umlaufenden Randabschnitts H5 an der ersten Oberfläche 20a des Randabschnitts 25 des Betätigungsteils 20 zumindest abschnittsweise anliegt, wenn sich das Betätigungsteil 20 in seiner Ausgangsstellung oder Neutralstellung befindet (Figuren 22, 23, 54, 55).

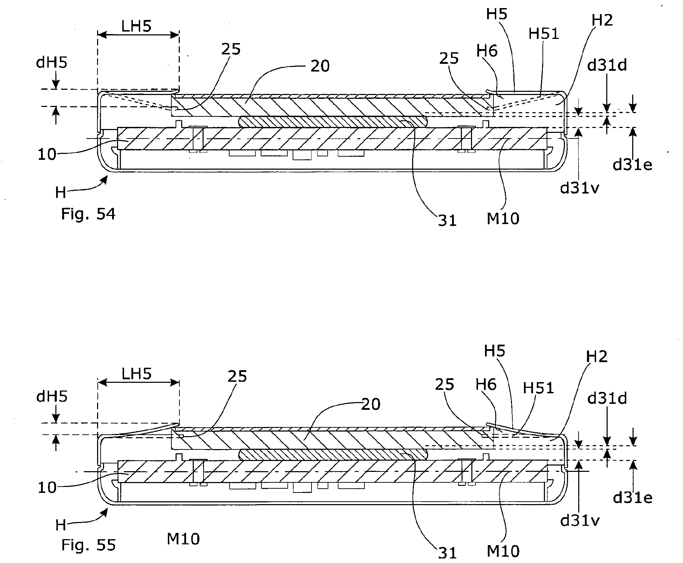

Dabei ist durch die Lage des Randabschnitts H5 die Lage des Betätigungsteils 20 fixiert, da die Lage des Betätigungsteils 20 einerseits von der Verbindungsschicht 31 und andererseits von dem Randabschnitt H5 her bestimmt ist. Nach einer Ausführungsform kann vorgesehen sein, dass die Verbindungsschicht 31 in ihrem entspannten Zustand ist und keine Kraft auf das Betätigungsteil 20 aufgrund ihrer Elastizität ausübt, wenn sich das Betätigungsteil 20 in einer Ausgangsstellung oder Neutralstellung befindet und auch keine äußere Betätigungskraft auf diese einwirkt. Auch kann in einer dazu alternativen Ausführungsform vorgesehen sein, dass die Verbindungsschicht 31 in einem zumindest abschnittsweise zusammengedrückten Zustand ist und eine Ausgangskraft auf das Betätigungsteil 20 aufgrund ihrer Elastizität ausübt, wenn sich das Betätigungsteil 20 in einer Ausgangsstellung oder Neutralstellung befindet und auch keine äußere Betätigungskraft auf diese einwirkt. In diesem Fall ist durch diesen Anlagezustand der Randabschnitt H5 Teil der Verbindungsvorrichtung 30 sein. Derartige Ausführungsformen sind in den Figuren 54 und 55 dargestellt. Bei den Darstellungen der Figuren 54 und 55 ist mit gestrichelten Linien der durch die Verbindungsschicht 31 unverformte Randbereich, der jeweils mit dem Bezugszeichen H51 versehen ist, gezeigt. Durch die Verformung des Randabschnitt H5 als Gegenlager für die Elastizitätskraft, die die Verbindungsschicht 31auf diesen ausübt, wird die Verbindungsschicht von einer in ihrem entspannten Zustand auftretenden Dicke d31e auf eine in ihrem von dem Randabschnitt H5 zusammengedrückten Zustand auftretende Dicke d31v zusammengedrückt, so dass sich dadurch eine Dicken-Differenz d31d ergibt. Die Verformung des Randabschnitts H5 kann dabei scharnierartig (Figur 54) oder über deren Länge LH5 entlang der Y-Richtung (Figur 55) auftreten.

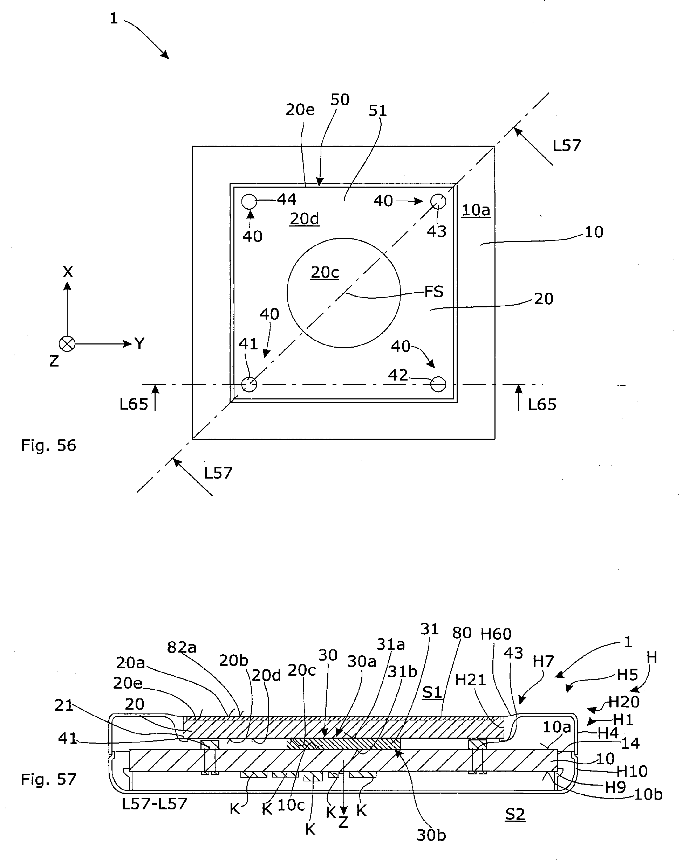

Eine Vorspannung durch den Randabschnitt H5 auf das Betätigungsteil 20 kann auch bei den Ausführungsformen der Figuren 56 und 57 gegeben sein.

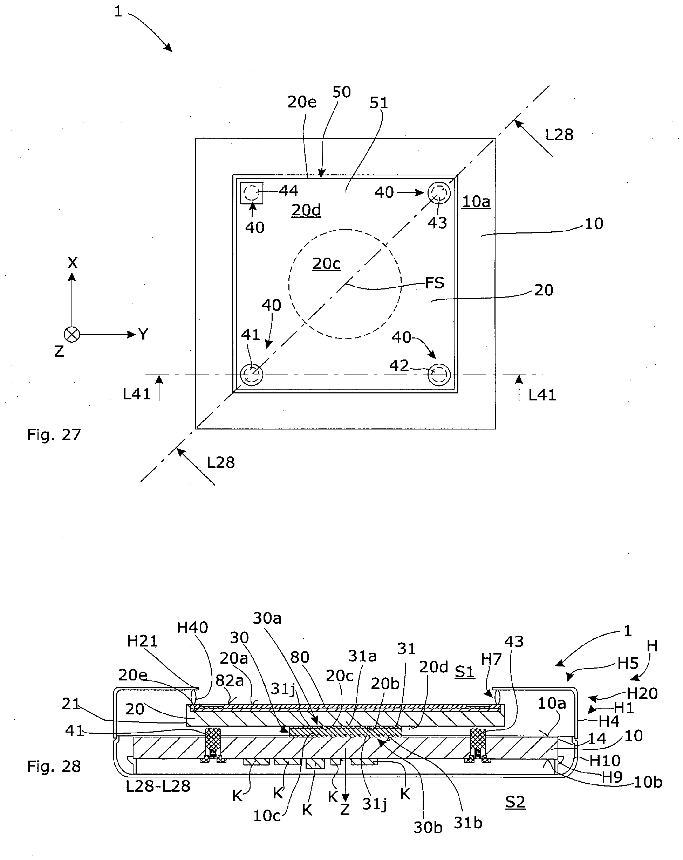

Generell, aber insbesondere bei Ausführungsformen, bei denen sich der Randabschnitt H5 des Gehäuseteils H1 und das Betätigungsteil 20 in der Z-Richtung gesehen überlappen, kann eine Dichtung H40 zwischen dem Randabschnitt H5 des Gehäuseteils H1 und dem Randabschnitt 25 oder der äußere Randoberfläche 21 des Betätigungsteils 20 gelegen sein, die den Randabschnitt H5 und das Betätigungsteil 20 miteinander verbindet, insbesondere um den Innenraum H2 des Gehäuseteils H1 nach außen abzudichten. Beispiele einer Ausführung der elektrischen Schaltvorrichtung 1 mit einer Dichtungsvorrichtung sind in den Figuren 27 bis 53 dargestellt. In diesem Fall kann die Dichtung H40 Teil der Verbindungsvorrichtung 30 sein, da durch diese eine Verbindung zwischen dem Grundkörper 10, der an dem Gehäuse H1 gelagert ist, und dem Betätigungsteil 20 realisiert ist. Dabei kann die Dichtung H40 aus einem elastischen Material gebildet sein, so dass diese die Rückstellfähigkeit der Verbindungsschicht 31 unterstützt. Die Dichtung H40 kann auch abschnittsweise entlang des Umfangs des Randabschnitts H5 gelegen sein.

Weiterhin kann bei den Ausführungsformen der Figuren 54 und 55 die Oberfläche H6 umlaufend und dabei abdichtend in Kontakt mit der Oberfläche 20a des Betätigungsteils 20 sein, so dass auch diese Ausführungsformen eine Abdichtung des Innenraums H2 bereitstellen.

Bei Ausführungsformen mit einer Dichtung H40 zwischen dem Randabschnitt H5 und dem Randabschnitt 25 oder der äußeren Randoberfläche 21 kann in der Z-Richtung gesehen ein Abstand zwischen dem äußeren Randabschnitt 21 der Betätigungsplatte 20 und dem Innenrand 21 des Randabschnitts H5 des Gehäuseteils H1 bestehen (Figur 28 bis 44), wobei eine Dichtungsvorrichtung oder eine Abdeckungsvorrichtung H50 z.B. in Form eines Abdeckungsrings oder einer Abdeckungsmembran den äußeren Randabschnitt 25 der Betätigungsplatte 20 und den Randabschnitt H5 des Gehäuseteils H1 verbindet, um den Innenraum H2 des Gehäuseteils H1 nach außen abzudichten.Bei einer weiteren Ausführungsform kann die Schaltvorrichtung 1 bei dem Vorhandensein der Dichtung H40, H50 ohne Verbindungsschicht 31 ausgeführt sein, so dass die Dichtung H40 die Verbindungsvorrichtung 30 bildet (Figuren 56 bis 71).

Eine weitere Ausführungsform der Schaltvorrichtung 1 kann derart ausgeführt sein, dass der äußere Randabschnitt 21 der Betätigungsplatte 20 in der Z-Richtung gesehen über den Innenrand Randabschnitts H5 des Gehäuseteils H1 hinausragt, so dass sich das Betätigungsteil 20 und der äußere Randabschnitt 25 der Betätigungsplatte 20 in der Z-Richtung gesehen überlappen (Figuren27 bis 44). Bei dieser Gegebenheit kann jede der hierin genannten Dichtungsvorrichtungen realisiert sein.

Mit einer Dichtungsvorrichtung H40, H50 kann in Analogie zu den Ausführungsformen der Figuren 54 und 55 auch eine Vorspannung auf die Verbindungsschicht 31 ausgeübt werden.Gemäß den Figuren 56 bis 71 kann bei einer weiteren Ausführungsform der elektrischen Schaltvorrichtung 1 vorgesehen sein, dass der umlaufende Randabschnitt H5 des Gehäuseteils H1 mit dem Betätigungsteil 20 und insbesondere mit einem Außenrand desselben verbunden ist, wobei, wie dargestellt, insbesondere vorgesehen sein kann, dass der Randabschnitt H5 in einem Stück mit der Seitenwand H4 ausgebildet ist. Dabei kann vorgesehen sein, dass die Schaltvorrichtung 1 keine Verbindungsschicht aufweist und der Randabschnitt H5 des Gehäuseteils H1 als Rückstellvorrichtung für das Betätigungsteil 20 ausgeführt ist, indem dieses elastisch verformbar ist.

Dabei kann insbesondere vorgesehen sein, dass der Randabschnitt H5 oder Abschnitte derselben über einen Verbindungsabschnitt H60, der insbesondere Teil des Randabschnitts H5 und insbesondere in einem Stück mit diesem ausgeführt sein kann, direkt mit einem Seitenrandabschnitt 25 der Betätigungsplatte 20 verbunden oder an diesem befestigt ist (Figuren 56 bis 71). Dabei ist der Randabschnitt H5 derart ausgeführt, dass dieser eine elastische Lagerung der Betätigungsplatte 20 bereitstellt, die bei Auslenkung derselben eine Rückstellkraft erzeugt. Dabei kann vorgesehen sein, dass die Verbindungsschicht 31 vorhanden ist. Nach einer dazu alternativen Ausführungsform ist bei einer solchen elastischen Lagerung keine Verbindungsschicht 31 vorgesehen. Bei diesen Ausführungsformen kann die Verbindungsschicht 31 entfallen.

Insbesondere bei diesen Ausführungsformen, bei denen eine Verbindungsschicht 31 vorhanden ist, kann diese, jedoch muss nicht, aus einem elastischen und somit das Betätigungsteil 20 rückstellbaren Material sein. Eine Verbindungsschicht 31 kann überhaupt entfallen oder eine Verbindungsschicht 31 kann aus einem nicht rückstellfähigen Material vorgesehen sein, wenn die Verbindungsvorrichtung 30 ein weiteres das Betätigungsteil 20 rückstellbares Bauteil aufweist, z.B. eine Dichtung H40, H50 oder eine Verbindung eines Randabschnitts H5 des Gehäuseteils mit dem Betätigungsteil 20. In diesem Fall übernimmt die jeweilige Dichtung die Rückstellfunktion nach Betätigung des Betätigungsteils 20.

Auch weist die elektrische Schaltvorrichtung 1 zumindest einen Sensor oder zumindest zwei Sensoren auf, der bzw. die zwischen dem Grundkörper 10 und dem Betätigungsteil 20 gelegen sowie in der Dickenrichtung Z gesehen seitlich der Verbindungsschicht 31 gelegen ist bzw. sind, wobei sich das Betätigungsteil 20 quer zur Dickenrichtung Z und in der Erstreckung der X-Y-Ebene gesehen über die Verbindungsschicht 31 und über jeden des jeweiligen Sensors hinaus erstreckt.

Bei der Ausführungsform der Verbindungsvorrichtung 30 mit der Verbindungsschicht 31 gemäß der Figur 1 ist jeder des zumindest einen Sensors in der Dickenrichtung Z gesehen von dem Flächenschwerpunkt des Betätigungsteils 20 aus gesehen hinter der Verbindungsvorrichtung 31 gelegen.

Aufgrund der jeweiligen Lage des zumindest einen Sensors oder der Sensoren kann jeweils eine Position eines jeweils an diesem gelegenen Bereichs der zweiten Oberfläche 20b in der Dickenrichtung Z erfasst oder ermittelt werden. Insbesondere kann aufgrund der Lage der Sensoren der Abstand zwischen der Anschluss-Oberfläche 10a des Grundkörpers 10 und der Anschluss-Oberfläche 20b des Betätigungsteils 20 in der Dickenrichtung Z gesehen an der Position des jeweiligen Sensors in der X-Y-Ebene gesehen erfasst oder ermittelt werden.

Die Schaltvorrichtung 1 kann eine Sensor-Vorrichtung 40 aufweisen, die den zumindest einen Sensor sowie eine Positionsermittlungs-Vorrichtung mit einer Positionsermittlungs-Funktion aufweist, die Positionsermittlungs-Funktion funktional mit dem jeweiligen Sensor verbunden ist. Die Positionsermittlungs-Funktion kann in einer der elektronischen Komponenten K des Grundkörpers 10 integriert sein. Mit der Sensor-Vorrichtung 40 wird aufgrund eines Vergleichs einer Ist-Auslenkung gegenüber einem vorgegebener Grenzwert G1 ermittelt, ob bei der Auslenkung an einem Betätigungsbereich, z.B. dem Betätigungsbereich B41, aufgrund eines Drückens desselben in der Z-Richtung gegenüber dem Grundkörper 10 ein vorgegebener Grenzwert G1 der Auslenkung des Betätigungsteils 20 an dem Bereich oder Betätigungsbereich überschritten worden ist. Ein solches durch eine Vergleichsfunktion ermitteltes Überschreiten des vorgegebenen Grenzwerts G1 wird von der Sensor-Vorrichtung 40 als Betätigungskommando gewertet.

Die Ausführungsform der elektrischen Schaltvorrichtung 1, die in der Figur 1 gezeigt ist, weist vier Sensoren 41, 42, 43, 44 auf. Diese sind entlang der den Außenumfang der Randlinie gleichmäßig verteilt angeordnet, um eine Auslenkung eines über dem jeweiligen Sensor gelegenen Betätigungsbereichs des Betätigungsteils 20 zu erfassen. Dabei sind jeweils zwei Sensoren, nämlich jeweils die Sensoren 41 und 43 und die Sensoren 42 und 44 in Bezug auf den Flächenschwerpunkt FS der Betätigungsoberfläche 20a einander gegenüber liegend angeordnet. Mit jedem Sensor 41, 42, 43, 44 kann jeweils eine Position eines jeweils an diesem gelegenen Bereich der zweiten Oberfläche in der Dickenrichtung Z erfasst werden.

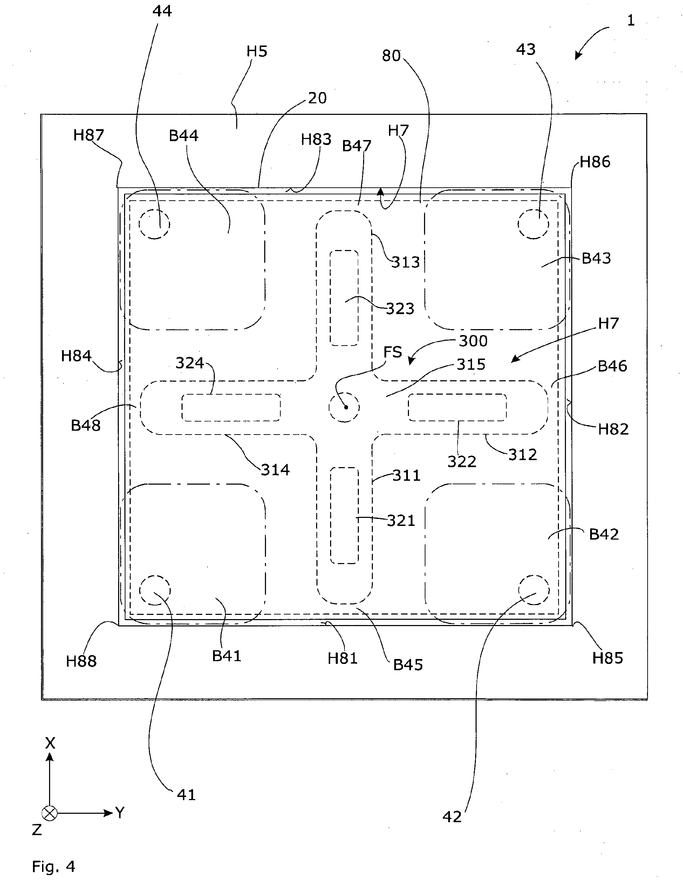

Der zumindest eine Sensor oder die Sensoren können jeweils als Sensor zur berührungslosen Erfassung des Abstands von dem jeweiligen Sensor zu der diesem gegenüber liegenden Stelle der Anschluss-Oberfläche 20b des Betätigungsteils 20 ausgeführt sein. Die Figur 3 zeigt eine Schnittdarstellung der Ausführungsform der elektrischen Schaltvorrichtung nach der Figur 1 entlang der in der Figur 1 eingetragenen Linie L3-L3, wobei berührungslose Sensoren in Form von optischen Sensoren verwendet werden. Die Figur 4 zeigt eine Schnittdarstellung der Ausführungsform der elektrischen Schaltvorrichtung nach der Figur 1 entlang der in der Figur 1 eingetragenen Linie L3-L3, wobei berührungslose Sensoren in Form von induktiven Sensoren verwendet werden. Bei der in der Figur 2 dargestellten Schaltvorrichtung 1 ist somit jeder der Sensoren 41, 42, 43, 44 als ein optischer Sensor ausgeführt.

Nach einer Ausführungsform sind Sensoren 41, 42, 43, 44 vorgesehen, die jeweils berührungslos den Abstand von demselben zu der dem jeweiligen Sensor gegenüber liegenden Stelle der Anschluss-Oberfläche 20b des Betätigungsteils 20 erfasst.

Die Sensoren können nicht nur berührungslos arbeitende Sensoren wie z.B. optische Sensoren sein, sondern auch magnetisch empfindliche oder den piezoelektrischen Effekt ausnutzende Sensoren sein.

In den Figuren 27 bis 53 ist eine Ausführungsform der Sensoren 41, 42, 43, 44 dargestellt, bei der jeder der Sensoren 41, 42, 43, 44 jeweils mechanische Sensoren sind, die z.B. als Schaltsensoren mit einer Schaltkomponente ausgeführt sind.

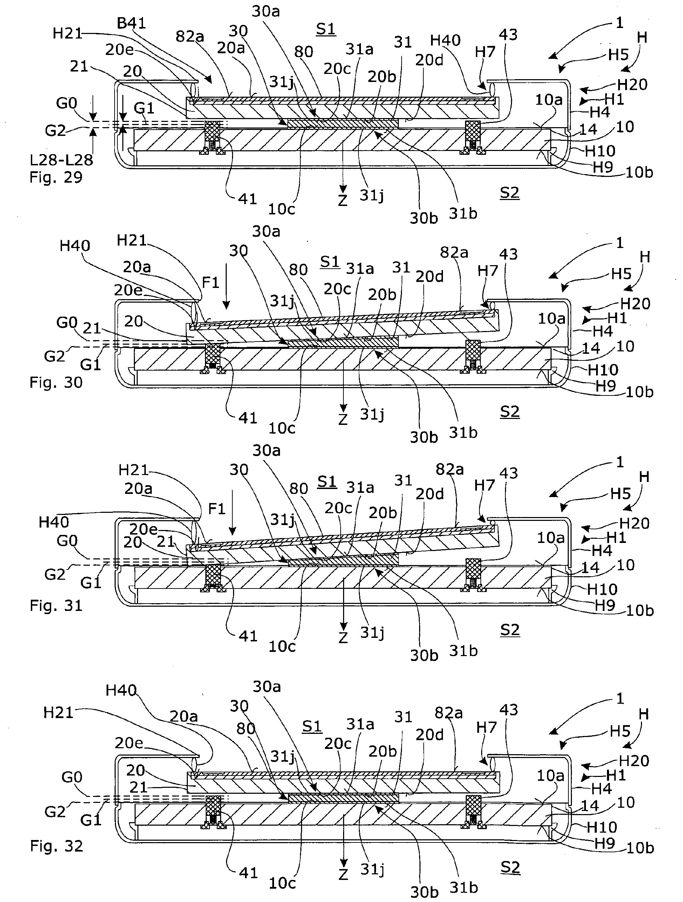

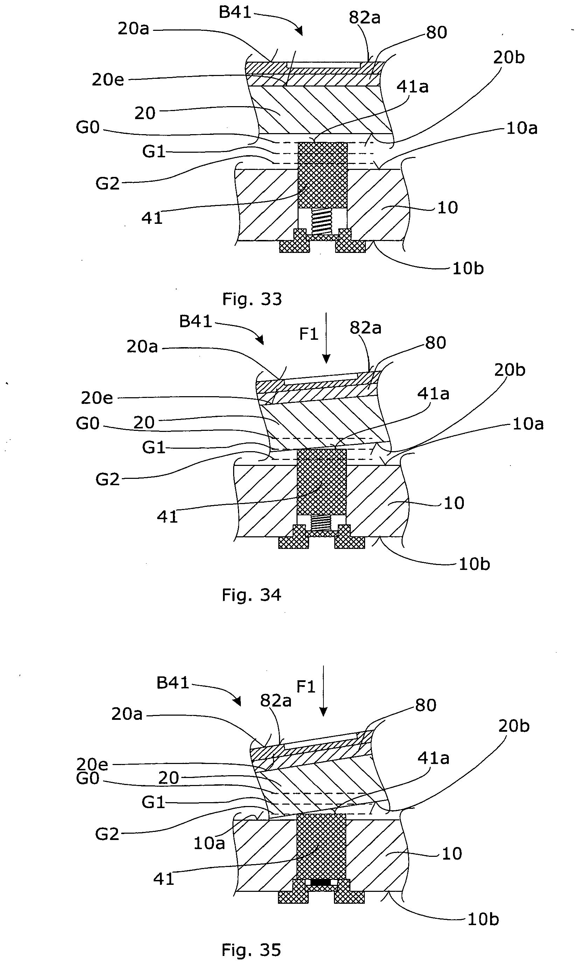

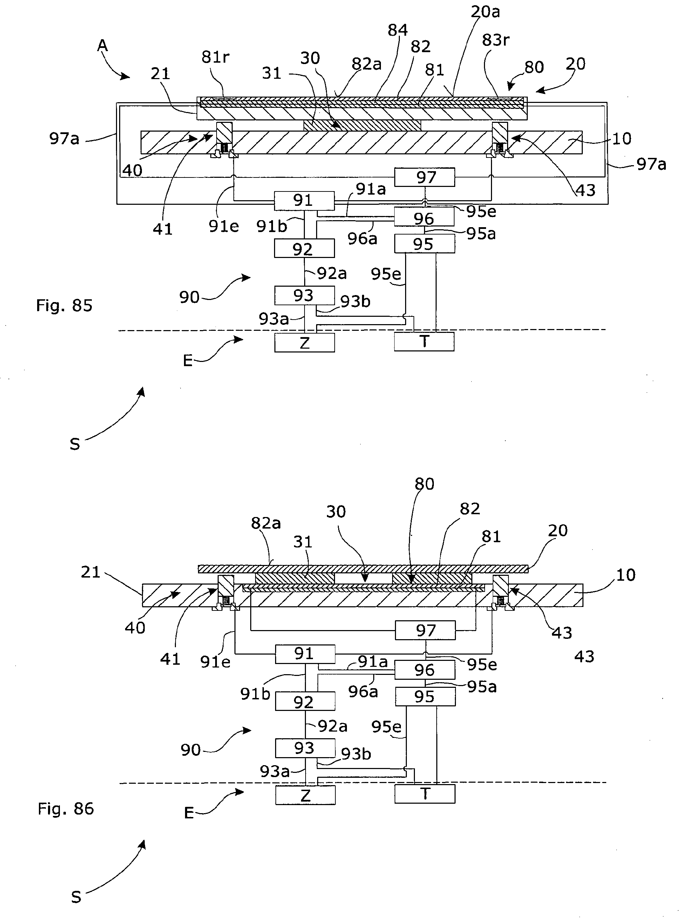

Bei der Ausführungsform der Sensoren 41, 42, 43, 44 als mechanische Sensoren können diese jeweils oder teilweise eine Rastungsvorrichtung aufweisen, die eine oder mehrere Rastungsstellungen bereitstellen. In den Figuren 29 bis 32 und insbesondere den Detaildarstellungen der Figuren 33 bis 35 sind Betätigungszustände des Betätigungsteils 20 bei einer Ausführung der Schaltvorrichtung 1 mit Sensoren dargestellt, die jeweils zwei Rastungsstellungen bereitstellen. In einer Ausgangsstellung oder einem unbelasteten Zustand des jeweiligen Sensors 41 nimmt dessen dem Betätigungsteils 20 zugewandte Oberfläche 41a eine zur Oberfläche 10a relative Position G0 ein (Figur 33). Bei einem Bewegen des Betätigungsbereichs B41 des Betätigungsteils 20 in Richtung zur Grundplatte 10 wird ein erster Grenzwert G1 oder eine relative Position einer in Anlage mit der Oberfläche 41a befindlichen Stelle der Oberfläche 20b erreicht, bei der für einen Benutzer eine erste Rastungsstellung merklich ist. Die Schaltvorrichtung 1 und insbesondere eine Betätigungsbereich-Identifikationsfunktion 91 einer Verarbeitungsvorrichtung oder Auswertungsvorrichtung 90 derselben (Figuren 85, 86) ermittelt in dieser ersten Rastungsstellung das Erreichen des Grenzwertes G1. Bei einem weiteren Bewegen des Betätigungsbereichs B41 des Betätigungsteils 20 in Richtung zur Grundplatte 10 wird ein zweiter Grenzwert G2 oder eine zweite relative Position einer in Anlage mit der Oberfläche 41a befindlichen Stelle der Oberfläche 20b erreicht, bei der für einen Benutzer eine zweite Rastungsstellung merklich ist. Die Schaltvorrichtung 1 und insbesondere eine Betätigungsbereich-Identifikationsfunktion 91 einer Verarbeitungsvorrichtung oder Auswertungsvorrichtung 90 derselben ermittelt in dieser zweiten Rastungsstellung das Erreichen des Grenzwertes G1. Je nach einer im Display insbesondere mittels eines Bilderzeugungs-Generators 97 (Figuren 85, 86) erzeugten Anfrage kann der Benutzer auf diese eine Betätigung des Betätigungsteils 20 vornehmen, bei der ein Grenzwert G1, G2 erreicht wird.

Jede Rastungsstellung ist bei manueller Ausübung eines Drucks auf das Betätigungsteil 20 an diesem als merklicher Widerstand gegen eine Weiterbewegung aus der jeweiligen Rastungsstellung spürbar. Eine jeweilige Rastungsstellung kann durch einen mechanischen Widerstand wie ein Vorsprung in einer Führung des Sensors realisiert sein.

Nach einer Ausführungsform der elektrischen Schaltvorrichtung 1 kann diese ein Display 80 oder ein Anzeigepaneel aufweisen, so dass diese Ausführungsform eine Ein- und Ausgabevorrichtung bilden. Das Display 80 kann auf der Anschluss-Oberfläche 10a des Grundkörpers 10 oder auf der Betätigungsoberfläche 20a des Betätigungsteils 20 angeordnet und insbesondere gelegen sein. Bei Ausführungsformen der Schaltvorrichtung 1 kann das Display 80 zumindest teilweise in einer Ausnehmung gelegen sein, die durch die Anschluss-Oberfläche 10a des Grundkörpers 10 oder auf der Betätigungsoberfläche 20a des Betätigungsteils 20 geformt ist.

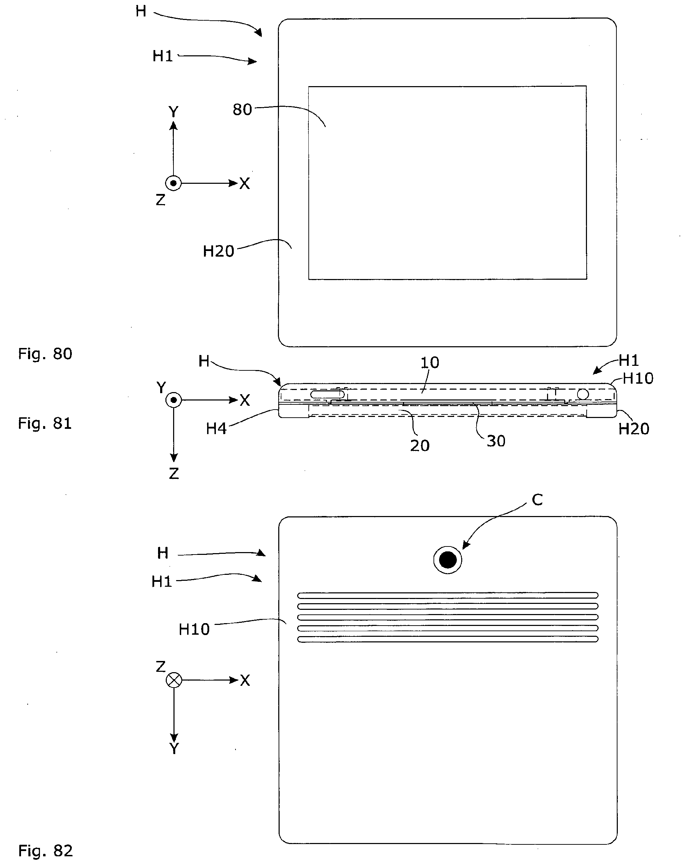

Generell kann die Schaltvorrichtung 1 eine Kameravorrichtung C aufweisen. In der Figur 82 ist eine Kameravorrichtung C schematisch durch eine in das Gehäuseteil H1 integrierte Linse dargestellt. Die Kameravorrichtung C kann insbesondere ein optisches System mit einer Linse und einer Kamera-Betätigungsvorrichtung sowie eine Bild-Erfassungsvorrichtung aufweisen. Die Bild-Erfassungsvorrichtung kann insbesondere eine Barcode-Erkennungsfunktion aufweisen, mit der ein mittels der Kamera erfasster Barcode hinsichtlich der in diesem enthaltenen Funktionen interpretiert werden kann.

Auch kann das Gehäuseteil G1 und insbesondere das Bodenteil H10 aus einem magnetischen und/oder magnetisierbaren Material gebildet sein, um das Gehäuseteil G1 in einem Anwendungsraum an ein metallisches Ausstattungsteil dieses Anwendungsraums anordnen zu können.

Insbesondere bei den in den Figuren 1 bis 19, 24, 26 bis 71 und der Figur 85 gezeigten Ausführungsformen der Schaltvorrichtung 1 weist das Betätigungsteil 20 ein Display 80 oder Anzeigepaneel auf, das in einem in der Dickenrichtung Z gesehen inneren Display-Bereich 20e der Betätigungsoberfläche 20a des Betätigungsteils 20 gelegen ist. Durch die Anzeigevorrichtung wird ein Anzeigebereich und wird gegebenenfalls ein Bedienbereich für einen Benutzer bereitgestellt. Der Display-Bereich 20e kann, wie es in den Figuren 1 bis 19 dargestellt ist, als an der Betätigungsoberfläche 20a geformte Vertiefung ausgeführt sein. Dabei kann das Display 80 in der Dickenrichtung Z gesehenen ganz oder teilweise, also zumindest teilweise in der Vertiefung gelegen sein.

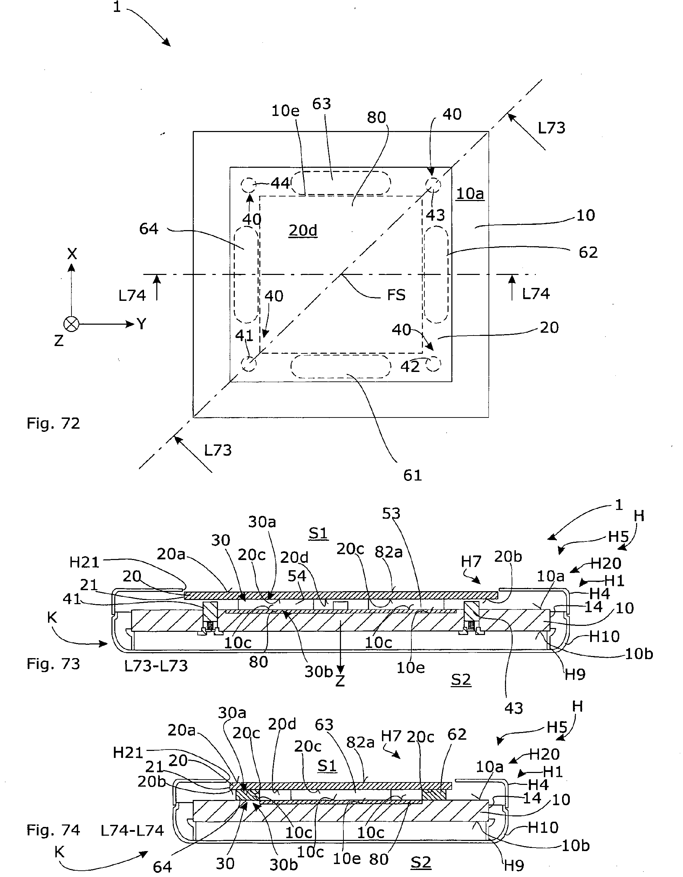

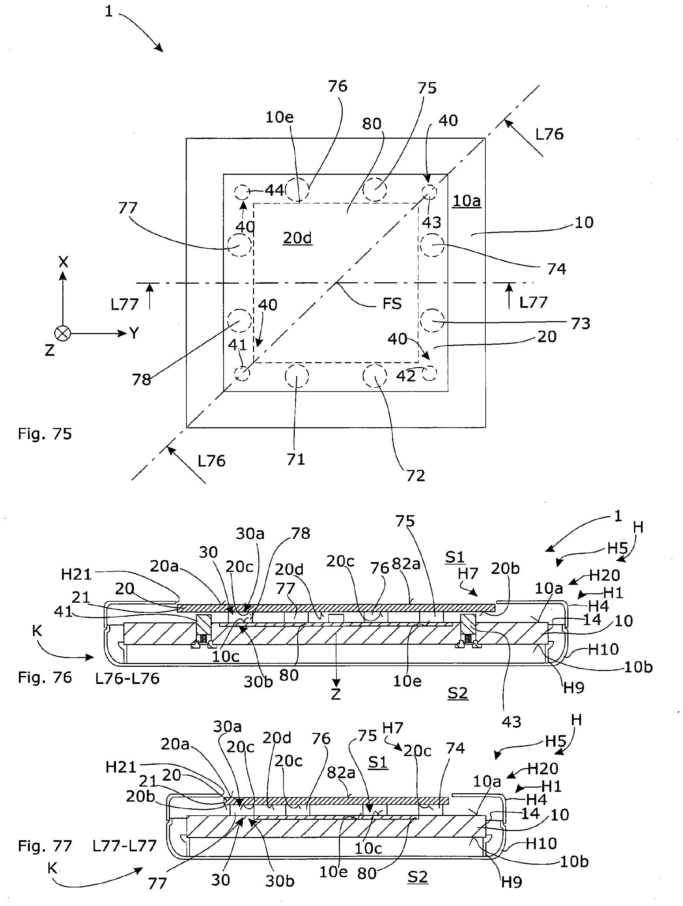

Bei den Ausführungsformen nach der Erfindung kann, wie anhand der Figuren 72 bis 77 beschrieben ist, vorgesehen sein, dass der Grundkörper 10 ein Display 80 oder Anzeigepaneel aufweist, das in einem in der Dickenrichtung Z gesehen inneren Display-Bereich der Oberfläche 10a des Grundkörpers 20, der insbesondere eine Vertiefung aufweist oder ausbildet, gelegen ist.

Das Display 80 oder die Anzeigepaneel ist in funktionaler Hinsicht eine Ausgabevorrichtung. Das Display 80 kann insbesondere ein sich flächig ersteckendes Bilderzeugungsmodul 81 und eine in Richtung zu der Betätigungsseite S1 über diese gelegene Bildschirm-Abdeckplatte oder eine Trägerplatte 82 aufweisen. Das Bilderzeugungsmodul 81 kann insbesondere eine Bildausgabe-Vorrichtung mit einer Anzeigevorrichtung wie eine Flüssigkeitsanzeige-Vorrichtung sein.

Das Display 80 kann in funktionaler Hinsicht zusätzlich eine Ausgabevorrichtung sein, die zusätzlich als Eingabevorrichtung und in diesem Fall somit als Ein- und Ausgabevorrichtung ausgeführt sein kann. Bei der Ausführung des Display 80 als Ein- und Ausgabevorrichtung kann dieses auch ein annäherungs- und/oder berührungssensitives Paneel oder ein Touch-Paneel aufweisen. Das annäherungs- und/oder berührungssensitives Paneel kann insbesondere auf oder unter der Trägerplatte 81 ein annäherungs- und/oder berührungssensitives Paneel 84 oder ein Touch Paneel gelegen sein. In den Figuren 85 und 86 ist jeweils eine Ausführungsform des Display 80 dargestellt, in der das Display 80 ein annäherungs- und/oder berührungssensitives Paneel 84 aufweist.

In einer weiteren Ausführungsform des Schaltgeräts 1 kann dieses mit dem annäherungs- und/oder berührungssensitives Paneel 84, jedoch ohne der elastischen Verbindungsschicht 31 und die Sensoren zur Ermittlung eines einem Abstand entsprechenden Wertes zwischen dem Grundkörper 10 und dem Betätigungsteil 20 ausgeführt sein.

In Bezug auf die Bedienungs- und insbesondere Betätigungsfunktionen der Schaltvorrichtung 1 können auf der Betätigungsoberfläche 20a derselben in Abhängigkeit von der Stelle, an der in der flächigen Erstreckung der Schaltvorrichtung 1 oder entlang der X-Y-Ebene gesehen der jeweilige Sensor des zumindest einen Sensors gelegen ist, Betätigungsbereiche zugeordnet werden.

In der Figur 4 sind für die vier Sensoren 41, 42, 43, 44 und deren jeweils spezifischen Lage auf der Betätigungsoberfläche 20a der Schaltvorrichtung 1 nach der Figur 1 vier Betätigungsbereiche B41bzw. B42 bzw. B43 bzw. B44 zugeordnet. Diese sind in entsprechenden Randbereichen des Betätigungsteils 20, in denen der jeweilige des zumindest einen Sensors angeordnet ist, gelegen. Die Betätigungsbereiche sind in der Z-Richtung gesehen vor oder oberhalb eines eine Auslenkung des Betätigungsteils 20 erfassenden Sensors und derart gelegen, dass eine Betätigung oder ein Ausüben einer Druckkraft F1, F2 mit einer Mindestgröße in einem jeweiligen Betätigungsbereich beispielsweise eine Verringerung des Abstands zwischen dem Grundkörper 10 und dem Betätigungsteil 20 nur in diesem jeweiligen Betätigungsbereich und somit nur an dem Sensor, der an dem jeweiligen Betätigungsbereich gelegen ist, auftritt. Bei einem durch eine Betätigungsbereich-Identifikationsfunktion 91 ermittelten Überschreiten eines Grenzwerts G1 aufgrund einer entsprechenden Druckkraft wird diese Kraft infolge der Betätigung bzw. eine gegebenenfalls daraus resultierende Bewegung als eine Betätigung bewertet, die auf die Schaltvorrichtung 1 und insbesondere deren Betätigungsteil 20 wirksam einwirkt.

In den Figuren 5 bis 8 ist eine Betätigung eines Betätigungsbereichs B41 in mehreren Schritten dargestellt.

Bei Ausführungsformen der Schaltvorrichtung 1, die zumindest zwei, also auch mehr als zwei Sensoren aufweisen, können beispielsweise vier Sensoren generell in den Eckbereichen oder an Mittenbereichen von Seitenrandabschnitten des Betätigungsteils 20 oder der Öffnung gelegen sein, wobei zumindest ein Sensor an zwei gegenüber liegenden Stellen des Betätigungsteils 20 gelegen ist. Insbesondere können auch zwei Sensoren zur Ermittlung von Betätigungen des Betätigungsteils 20 vorgesehen sein, die in Bezug auf den Flächenschwerpunkt FS an entgegen gesetzt zueinander gelegenen Eckbereichen oder an Mittenbereichen von Seitenrandabschnitten des Betätigungsteils 20 oder der Öffnung gelegen sind.

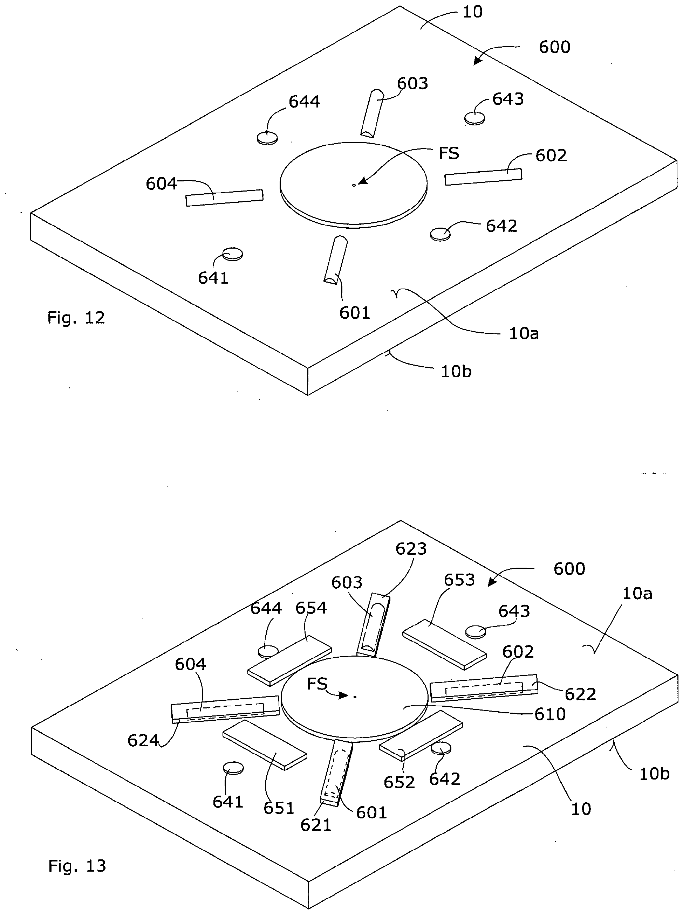

Bei der Ausführungsform der Figur 1 sind die zumindest vier Sensoren 41, 42, 43, 44 und somit die Betätigungsbereiche B41 bzw. B42 bzw. B43 bzw. B44 in einem jeweiligen Eckbereich des Betätigungsteils 20 und insbesondere in einem jeweiligen Eckbereich der Öffnung H7 gelegen. Bei den hierin beschriebenen Ausführungsformen können, wie es beispielartig in der Figur 12 gezeigt ist, vier der zumindest vier Sensoren 45, 46, 47, 48 jeweils in einem jeweiligen Mittenbereich von jeweils entgegen gesetzt zueinander gelegenen Seitenrändern des Betätigungsteils 20 oder der Öffnung H7 gelegen sein, wobei vorzugsweise der jeweilige Sensor an einem solchen Seitenrand jeweils mittig gelegen ist. Bei diesen Ausführungsformen sind die Betätigungsbereiche ebenfalls mittig an einem jeweiligen Seitenrand gelegen. Solche Betätigungsbereiche sind in den Figur 12 mit den Bezugszeichen B45 bzw. B46 bzw. B47 bzw. B48 versehen. Bei beiden Varianten können zusätzliche Sensoren und somit entsprechende Betätigungsbereiche, also mehr als vier Sensoren vorgesehen sein. Davon unabhängig können mehrere Sensoren an jeweils einem Betätigungsbereich angeordnet sein.

Generell kann auch vorgesehen sein, dass neben zumindest einem in einem jeweiligen Eckbereich der Öffnung H7 gelegenen und z.B. vier jeweils in einem jeweiligen Eckbereich der Öffnung H7 gelegenen Sensoren 41, 42, 43, 44 zumindest ein und z.B. vier Sensoren 45, 46, 47, 48 jeweils in einem jeweiligen Mittenbereich von jeweils entgegen gesetzt zueinander gelegenen Seitenrändern des Betätigungsteils 20 oder der Öffnung H7 gelegen sind.

Die Verbindungsschicht 31 kann in der Z-Richtung gesehen verschiedenartig gestaltet sein wie anhand mehrerer Figurendarstellungen beschrieben wird:
Bei der Ausführungsform der Figur 1 weist die Verbindungsvorrichtung 30, hier mit dem 300 versehen, in der Draufsicht, also in der Z-Richtung gesehen, eine Verbindungsschicht 310 mit vier Seitenarm-Abschnitten 311, 312, 313, 314 auf, die sich kreuzförmig von einem Zentralbereich 315 aus, in dem der Flächenschwerpunkt FS des Betätigungsteils 20 oder der Öffnung H7 gelegen ist, in Richtung zu einem Randbereich des Betätigungsteils 20 oder der Öffnung H7, der jeweils zwischen zwei Betätigungsbereichen gelegen ist, erstrecken. Durch das Vorsehen der Seitenarm-Abschnitte 311, 312, 313, 314 wird die Betätigung des Betätigungsteils 20 mit einer Bewegung desselben um einen Mindestbetrag G1 an einem Bereich, in dem ein entsprechender Sensor zur Ermittlung eines Betätigungskommandos gelegen ist, unterstützt, indem das gleichzeitige Betätigen eines jeweils benachbarten Betätigungsbereichs, beispielsweise durch gleichzeitiges oder ungenaues Drücken eines Betätigungsbereichs von der Betätigungsseite S1 aus vermieden oder verhindert wird. Die Seitenarm-Abschnitte 311, 312, 313, 314 sind somit "Weichenteile" hinsichtlich der Betätigung der Betätigungsplatte 20 an einem jeweiligen Betätigungsbereich.

Bei einer Variante kann die Verbindungsschicht zwei oder drei Seitenarm-Abschnitte aufweisen, die sich jeweils von dem Zentralbereich 315 aus in zueinander entgegengesetzten Richtungen bzw. kreuzförmig in Richtung zu einem Randbereich des Betätigungsteils 20 oder der Öffnung H7, der jeweils zwischen zwei Betätigungsbereichen gelegen ist, erstrecken. Bei einer Anordnung der Sensoren gemäß der Ausführungsform der Figur 1 kann vorgesehen sein, dass sich die zwei oder drei Seitenarm-Abschnitte derart in zueinander entgegen gesetzten Richtungen erstrecken, dass diese vom Flächenschwerpunkt FS aus gesehen zwischen zwei Sensoren jeweils beider an einem jeweiligen Seitenrand-Abschnitt H81, H83 bzw. H82, H84 des Paare von Sensoren verlaufen. Bei einer Verbindungsschicht mit drei Seitenarm-Abschnitten sind drei entsprechend gelegene Sensoren jeweils zur Ermittlung einer Betätigung des Betätigungsteils 20 vorgesehen.

Insbesondere kann vorgesehen sein, dass die vier Seitenarme-Abschnitte 311, 312, 313, 314 jeweils zumindest 50% der Strecke Flächenschwerpunkt FS der Betätigungsoberfläche 20a aus in der Richtung des jeweiligen Seitenarm-Abschnitts zum entsprechenden Seitenrandabschnitt 21 des Betätigungsteils 20 hin erstreckt.

Bei dieser Ausführungsform der Verbindungsschicht 310 ist diese vorzugsweise aus einem einheitlichen rückstellfähigen Material gebildet oder besteht einheitlich aus einem rückstellfähigen Material.

Bei einer Variante der beschriebenen Ausführungsformen kann innerhalb jedes Seitenarm-Abschnitts 311, 312, 313, 314 zumindest ein im Wesentlichen unelastisches Weichenteil 321, 322, 323, 324 gelegen sein. Hierin bedeutet "im Wesentlichen unelastisch" generell, dass das Weichenteil 321, 322, 323, 324 eine zumindest um das Fünffache geringere Elastizität besitzt als die Verbindungsschicht 301. Dadurch wird die beschriebene Funktion der Seitenarm-Abschnitte 311, 312, 313, 314 unterstützt. Die Weichenteile 321, 322, 323, 324 können jeweils insbesondere als Stege oder Rippen ausgebildet sein, die von der Betätigungsoberfläche 20a abstehen und sich in der Richtung des jeweiligen Seitenarm-Abschnitts 311, 312, 313, 314 erstrecken. Die Stege oder Rippen können länglich ausgeführt sein.

Bei einer Variante der Verbindungsschicht 310 weist diese nur zwei Seitenarm-Abschnitte 311, 312, 313, 314 auf, die sich in zueinander entgegen gesetzten Richtungen erstrecken.

Durch die Seitenarm-Abschnitte wird erreicht, dass bei einem entsprechenden Drücken des Betätigungsteils 20 an einer Stelle in einem ersten Betätigungsbereich (z.B. dem Betätigungsbereich B43), die innerhalb desselben nahe einem benachbarten zweiten Betätigungsbereich (z.B. dem Betätigungsbereich B42) gelegen ist, mit größerer Zuverlässigkeit eine Überschreitung eines für den ersten Betätigungsbereich (z.B. dem Betätigungsbereich B43) vorgegebenen Grenzwerts G1 ermittelt wird, um ein dem ersten Betätigungsbereich entsprechendes Betätigungskommando zu erzeugen. Somit wird insbesondere durch einen jeweiligen Seitenarm-Abschnitt erreicht, dass bei einer ungenauen Betätigung eines Betätigungsbereichs des Betätigungsteils 20 eine Auslenkung an einem Betätigungsbereich, dessen Betätigung nicht beabsichtigt ist, mit größerer Sicherheit vermieden wird.

Insbesondere kann aufgrund der Lage der Sensoren der Abstand zwischen der Anschluss-Oberfläche 10a des Grundkörpers 10 und der Anschluss-Oberfläche 20b des Betätigungsteils 20 in der Dickenrichtung Z gesehen an der Position des jeweiligen Sensors in der X-Y-Ebene gesehen erfasst oder ermittelt werden.

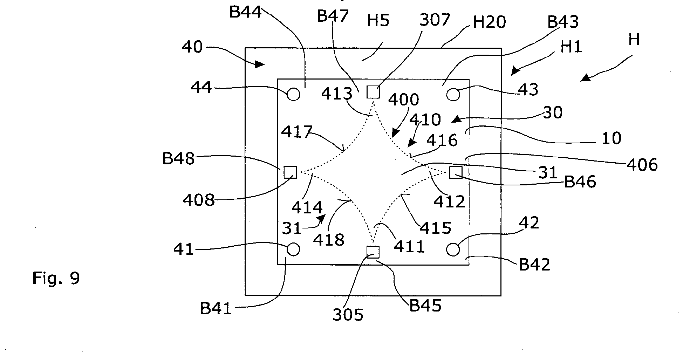

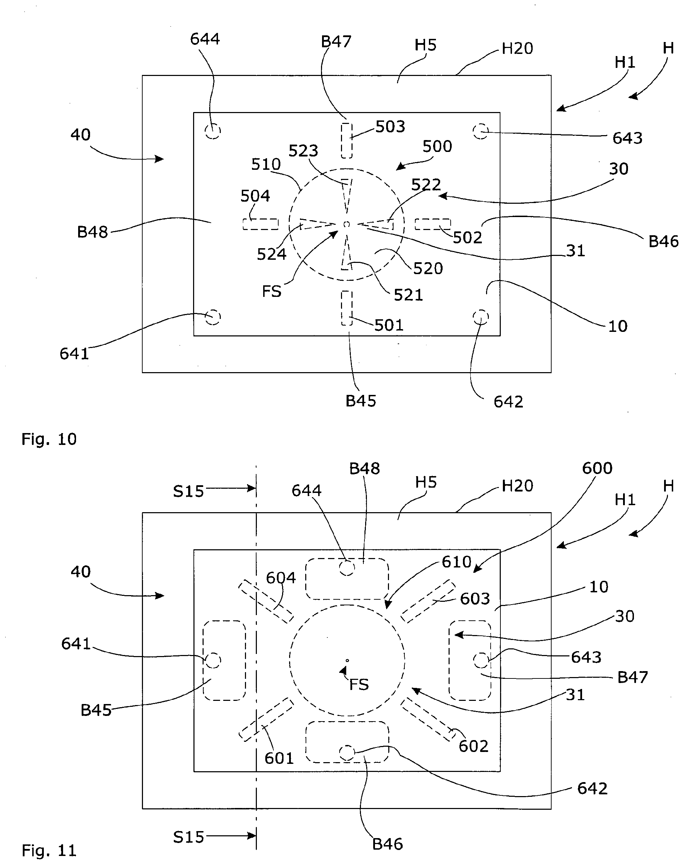

In der Figur 9 ist eine Ausführungsform der Verbindungsschicht 31 einer Verbindungsvorrichtung 400 gezeigt, die dort mit dem Bezugszeichen "410" versehen ist. Die Verbindungsschicht 410 ist in der Draufsicht, also in der Z-Richtung gesehen, karoförmig oder im Wesentlichen karoförmig gestaltet. Dementsprechend weist die sich in der Z-Richtung gesehen äußere Randlinie der Verbindungsschicht 410 vier Ecken oder Eckabschnitte 411, 412, 413, 414 auf, von denen eine bzw. einer jeweils zwischen zwei entsprechenden zueinander benachbarten und von dem Flächenschwerpunkt FS des Betätigungsteils 20 aus gesehen konkav verlaufenden Seitenrand-Abschnitten 415, 416, 417, 418 gelegen ist. Bei der Ausführungsform der Figur 10 ist zwischen jeweils zwei entsprechenden zueinander benachbarten Seitenrand-Abschnitten 415, 416, 417, 418 jeweils eine Ecke 411, 412, 413, 414 ausgebildet. Alternativ dazu kann vorgesehen sein, dass zwischen jeweils zwei entsprechenden zueinander benachbarten Seitenrand-Abschnitten 415, 416, 417, 418 jeweils gekrümmte und insbesondere von dem Flächenschwerpunkt FS des Betätigungsteils 20 aus gesehen konkav gekrümmte Eckabschnitte (nicht gezeigt) ausgebildet sind. Bei diesen Ausführungsformen ist jede Ecke oder jeder Eckabschnitt von dem Flächenschwerpunkt FS des Betätigungsteils 20 aus gesehen jeweils zwischen zwei entsprechenden und zueinander benachbarten Sensoren für jeweils einen Betätigungsbereich gelegen. An den Ecken 411, 412, 413, 414 kann jeweils ein im Wesentlichen unelastisches Weichenteil 405 bzw. 406 bzw. 407 bzw. 408 in Form eines von der Oberfläche 10a oder 10b abstehendes Weichenteil in Form z.B. eines Vorsprungs, eines Stegs, einer Rippe angeordnet sein.

Als Variante zu der in der Figur 9 gezeigten Karoform der Verbindungsschicht 410 kann diese statt vier drei Ecken oder Eckabschnitte aufweisen, die von dem Flächenschwerpunkt FS des Betätigungsteils 20 aus gesehen zwischen zwei von drei entsprechenden und zueinander benachbarten Sensoren für jeweils einen Betätigungsbereich gelegen.

In der Figur 10ist eine Ausführungsform der Verbindungsvorrichtung gezeigt, die dort mit dem Bezugszeichen "500" versehen ist. Die Verbindungsvorrichtung 500 weist eine Verbindungsschicht 510 auf, die in der Z-Richtung gesehen kreisrund gestaltet ist. Die Verbindungsschicht 510 in einem Grundbereich 520 mit einer ersten Elastizität und mit zusätzlichen Elastizitätsbereichen 521, 522, 523, 524 mit einer zweiten Elastizität versehen, wobei die zweite Elastizität geringer ist wie die erste Elastizität. Dabei kann vorgesehen sein, dass die zweite Elastizität betragsmäßig um mindestens das 1,5-fache geringer ist wie die erste Elastizität. Dabei sind die zusätzlichen Elastizitätsbereiche 521, 522, 523, 524 von dem Flächenschwerpunkt FS aus gesehen an einer Stelle in der Verbindungsschicht 510 gelegen, die zwischen zwei zueinander benachbarten Sensoren, z.B. die Sensoren 41, 42, bzw. Betätigungsbereichen gelegen ist. Auf diese Weise erfüllen die zusätzlichen Elastizitätsbereiche 521, 522, 523, 524 die Funktion von Weichen für die Einstellung von Betätigungsrichtungen bei der Betätigung des Betätigungsteils 20.

Bei Bildung der Verbindungsschicht 510 aus einem Schaummaterial kann vorgesehen sein, dass die zusätzlichen Elastizitätsbereiche 521, 522, 523, 524 geringerer Elastizität eine geringere Porigkeit aufweisen wie der Grundbereich 520, durch die eine geringere Rückstellfähigkeit bereitgestellt wird.

Weiterhin kann vorgesehen sein, dass die Verbindungsschicht 510 nicht kreisrund gestaltet ist, sondern z.B. quadratisch. Generell kann die Form der Verbindungsschicht 510 unterschiedlich sein, wenn die zusätzlichen Elastizitätsbereiche 521, 522, 523, 524 von dem Flächenschwerpunkt FS aus gesehen an einer Stelle in der Verbindungsschicht 510 gelegen sind, die zwischen zwei zueinander benachbarten Sensoren, z.B. den Sensoren 41, 42, bzw. Betätigungsbereichen gelegen ist.

Bei der Verbindungsvorrichtung 500 können zusätzliche Weichenteile 501, 502, 503, 504 vorgesehen sind, die in der Z-Richtung gesehen außerhalb der Verbindungsschicht 510 gelegen sind, wobei die zusätzlichen Weichenteile 501, 502, 503, 504 von dem Flächenschwerpunkt FS aus gesehen an einer Stelle in der Verbindungsschicht 510 gelegen sind, die zwischen zwei zueinander benachbarten Sensoren, z.B. den Sensoren 41, 42, bzw. Betätigungsbereichen gelegen ist.

In den Figuren 11 und 12 ist eine Ausführungsform der Schaltvorrichtung 1 dargestellt, die Sensoren 641, 642, 643, 644 zur Erzeugung von Betätigungskommandos an Betätigungsstellen B45, B46, B47, B48 aufweist, die in einem jeweiligen Mittenbereich von jeweils entgegen gesetzt zueinander gelegenen Seitenrändern des Betätigungsteils 20 oder der Öffnung H7 gelegen sind. Die Verbindungsvorrichtung 600 weist eine Verbindungsschicht 610 auf, die in der Z-Richtung gesehen kreisrund gestaltet ist, jedoch auch eine andere Gestalt haben kann und z.B. quadratisch oder karoförmig gemäß Figur 9, gestaltet sein kann. Auch kann die Verbindungsvorrichtung 600, wie es anhand der Figur 10 beschrieben ist, mit einem Grundbereich mit einer ersten Elastizität und mit zusätzlichen Elastizitätsbereichen mit einer zweiten, vorzugsweise mit einer betragsmäßig um mindestens das 1,5-fache geringeren Elastizität versehen sein, wobei die zusätzlichen Elastizitätsbereiche von dem Flächenschwerpunkt FS aus gesehen an einer Stelle in der Verbindungsschicht 610 gelegen sind, die zwischen zwei zueinander benachbarten Sensoren, z.B. die Sensoren 641, 642, bzw. Betätigungsbereichen gelegen ist.

Generell kann die Schaltvorrichtung 1 eine Verbindungsvorrichtung mit einem Grundbereich mit einer ersten Elastizität und mit zusätzlichen Elastizitätsbereichen mit einer zweiten, vorzugsweise mit einer betragsmäßig gegenüber der ersten Elastizität um mindestens das 1,5-fache geringeren Elastizität aufweisen, von dem Flächenschwerpunkt FS aus gesehen an einer Stelle in der Verbindungsschicht gelegen sind, die zwischen zwei zueinander benachbarten Sensoren bzw. Betätigungsbereichen gelegen ist.

Bei der Verbindungsvorrichtung 600 können zusätzliche Weichenteile 601, 602, 603, 604 vorgesehen sein, die in der Z-Richtung gesehen außerhalb der Verbindungsschicht 610 gelegen sind, wobei die zusätzlichen Weichenteile 601, 602, 603, 604 von dem Flächenschwerpunkt FS aus gesehen an einer Stelle in der Verbindungsschicht 610 gelegen sind, die zwischen zwei zueinander benachbarten Sensoren, z.B. den Sensoren 641, 642, bzw. Betätigungsbereichen gelegen ist.

In der Figur 13 ist eine Ausführungsform von Komponenten der Schaltvorrichtung 1 dargestellt, bei der optional vorgesehene elastische Zwischenschichten 651, 652, 653, 654 angeordnet sind, von denen jeweils eine zwischen der Verbindungsschicht 610 und jeweils einem Sensor 641, 642, 643, 644 gelegen ist.

Grundsätzlich kann eine Verbindungsvorrichtung, z.B. die Verbindungsvorrichtung 500 oder 600, bei Ausführungsformen der Schaltvorrichtung 1 nach der Erfindung mit oder ohne einer Verbindungsschicht zusätzliche Weichenteile z.B. in Form von Rippen oder Stegen aufweisen, die im Wesentlichen unelastisch oder elastisch sind und die jeweils zwischen dem Grundkörper 10 und dem Betätigungsteil 20 und an einer Stelle in der Verbindungsschicht gelegen sind, die von dem Flächenschwerpunkt FS des Betätigungsteils 20 aus gesehen jeweils zwischen zwei zueinander benachbarten Sensoren bzw. Betätigungsbereichen jeweils zur Erfassung einer Auslenkung des Betätigungsteils 20 eines jeweiligen Betätigungsbereichs gelegen sind. Generell können die gegebenenfalls vorgesehenen Weichenteile der jeweiligen Ausführungsformen der Schaltvorrichtung 1 an der Anschluss-Oberfläche 10a des Grundkörpers 10 oder der Anschluss-Oberfläche 20b des Betätigungsteils 20 angebracht sein. Dabei können die gegebenenfalls vorgesehenen Weichenteile auch in einem Stück mit dem Grundkörper 10 bzw. dem Betätigungsteil 20 ausgebildet sein.

Bei dem Vorsehen von relativ unelastischen Weichenteilen ist vorzugsweise vorgesehen, dass das Betätigungsteils 20 eine Elastizität aufweist, bei der sich das Betätigungsteils 20 bei Betätigung an einem Betätigungsbereich verformt, um den Grenzwert G1 für die Auslenkung des jeweiligen Betätigungsbereichs zu überschreiten. In den Figuren 14 bis 16 ist beispielsweise dargestellt, wie durch Verformung des Betätigungsteils 20 eine Überschreitung des Grenzwertes G1 zwischen im Wesentlichen unelastischen Weichenteilen 601, 602 auftritt. Ein jeweilige Bereich 20c der Oberfläche 20a liegt dabei an den Weichenteilen 601, 602, 603, 604 an.

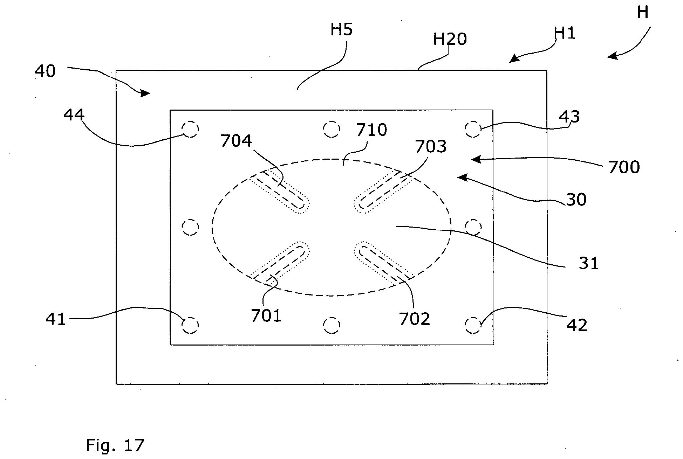

Die Figur 17 zeigt eine Variante zu der in der Figur 13 dargestellten Ausführungsform der Verbindungsvorrichtung 700, bei der Weichenteile 701, 702, 703, 704 als Bereiche größerer Elastizität in der Verbindungsschicht 710 integriert sind.

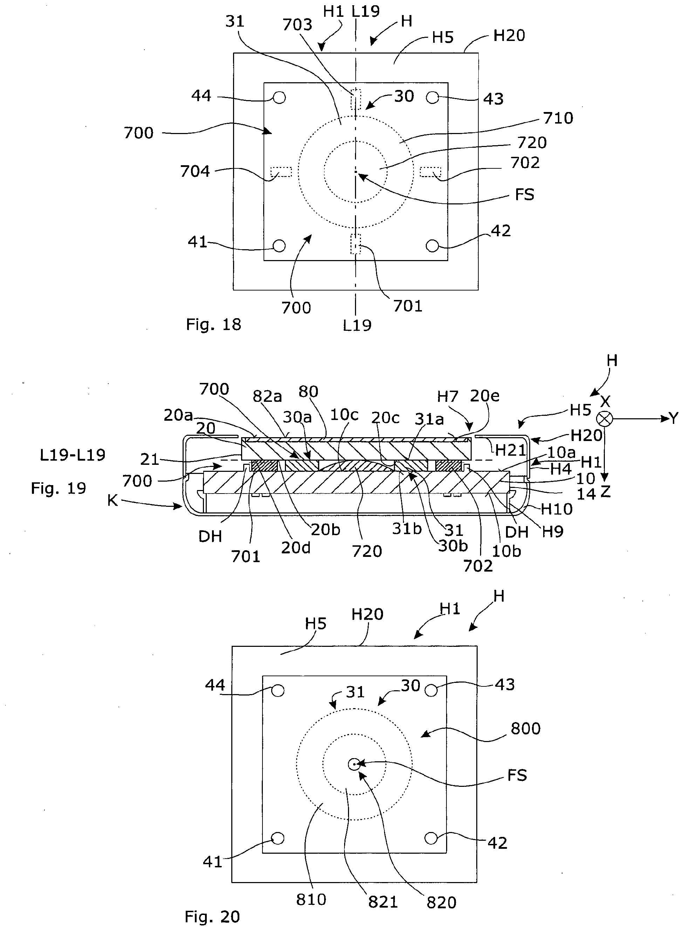

In der Figur 18 ist eine weitere Ausführungsform der Verbindungsvorrichtung dargestellt, die mit dem Bezugszeichen 700 bezeichnet ist. Die Verbindungsvorrichtung 700 weist eine in der Z-Richtung gesehen ringförmige Verbindungsschicht 710 auf, deren Zentrum im Flächenschwerpunkt FS des Betätigungsteils 20 gelegen ist. Im Inneren der Verbindungsschicht 710 ist ein sphärisches Weichenteil 720, wobei deren äußerer Umfangsrand an dem Innenrand der Verbindungsschicht 710 anliegt. Das sphärische Weichenteil 720 ist unelastisch oder im Wesentlichen unelastisch, d.h. hat eine geringere oder zweite Elastizität gegenüber einer ersten Elastizität der optional vorgesehenen Verbindungsschicht 710. Dabei kann vorgesehen sein, dass die zweite Elastizität betragsmäßig um mindestens das 1,5-fache geringer ist wie die erste Elastizität. Bei der Verbindungsvorrichtung 700 können zusätzliche Weichenteile 701, 702, 703, 704 vorgesehen sein, die in der Z-Richtung gesehen außerhalb der Verbindungsschicht 710 gelegen sind, wobei die zusätzlichen Weichenteile 701, 702, 703, 704 von dem Flächenschwerpunkt FS aus gesehen an einer Stelle außerhalb der Verbindungsschicht 710 und zwischen zwei zueinander benachbarten Sensoren, z.B. den Sensoren 41, 42, bzw. Betätigungsbereichen gelegen ist.

Alternativ dazu kann, wie es anhand der Ausführungsform 800 der Figur 20 dargestellt ist, auch ein Abstand zwischen dem äußeren Umfangsrand des sphärischen Weichenteils 820 und dem Innenrand der Verbindungsschicht 810 bestehen. Die Verbindungsvorrichtung 800 weist keine zusätzlichen Weichenteile auf.

Bei den Ausführungsformen der Schaltvorrichtung 1 nach den Figuren 18 und 20 weist diese vier Sensoren 41, 42, 43, 44 auf, die jeweils in den Eckbereichen gelegen sind.

In einer Variante hierzu können, wie auch bei anderen entsprechenden Ausführungsformen, die vier Sensoren 41, 42, 43, 44 an Mittenbereichen von Seitenrandabschnitten des Betätigungsteils 20 sein.

Bei den hierin genannten Ausführungsformen der Schaltvorrichtung 1 mit einer Verbindungsschicht 31 kann vorgesehen sein, dass eine oder beide der folgenden Oberflächen:
(a) Anschluss-Oberfläche 10a des Grundkörpers 10,
(b) die Anschluss-Oberfläche 20b des Betätigungsteils 20,
zumindest im Bereich der jeweiligen Verbindungsschicht 31, also insbesondere in dem Bereich, in dem diese Oberflächen mit der Verbindungsschicht 31 verbunden sind, vom Massenschwerpunkt der Verbindungsschicht 31 aus gesehen konkav oder konvex gestaltet sind. Die Konvexität und Konkavität des Grundkörpers 10 oder Betätigungsteils 20 kann insbesondere durch den größten Abstand d10b bzw. d20b (Figuren 22, 23) in Z-Richtung, der sich zwischen verschiedenen Punkten der Anschluss-Oberfläche 10a bzw. Anschluss-Oberfläche 10a im Bereich der Verbindung des Grundkörpers 10 bzw. des Betätigungsteils 20 mit der Verbindungsschicht 31 ergibt, definiert sein. Für die Abstände d10b bzw. d20b können insbesondere ein Wert von 1/10 der größten Dicke der Verbindungsschicht 31 in der Z-Richtung definiert sein.

Bei der Ausführungsform der Figur 22 sind sowohl die Anschluss-Oberfläche 10a als auch die Anschluss-Oberfläche 20b in der bezeichneten Hinsicht konvex gestaltet. Bei der Ausführungsform der Figur 22 sind sowohl die Anschluss-Oberfläche 10a als auch die Anschluss-Oberfläche 20b in der bezeichneten Hinsicht konvex gestaltet.

In den Schritten nach den Figuren 27 bis 30 ist dargestellt, dass mit zumindest zwei Grenzwerten G1, G2 an demselben Sensor und Betätigungsbereich B41 zwei Betätigungsmöglichkeiten und somit Auswahlmöglichkeiten realisierbar sind.

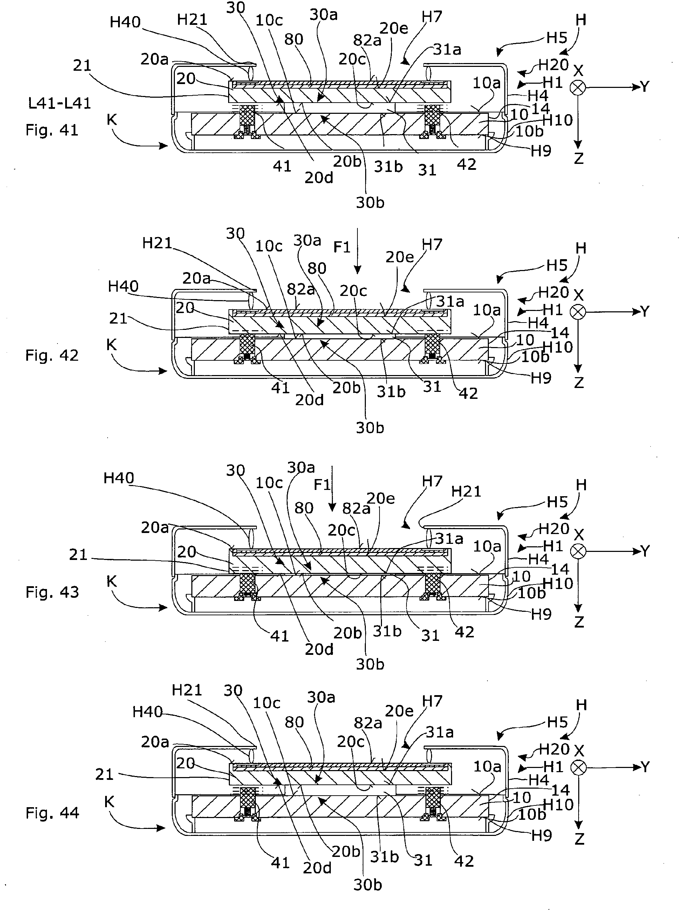

Mit der Ausführungsform nach der Figur 43 ist dazu alternativ oder zusätzlich gezeigt, dass an einem Betätigungsbereich z.B. dem Betätigungsbereich B41, mehrere Betätigungsmöglichkeiten und somit Auswahlmöglichkeiten realisierbar sind, wenn an zumindest einem Betätigungsbereich zwei Sensoren angeordnet sind, mit denen durch die Betätigungsbereich-Identifikationsfunktion 91 an demselben Betätigungsbereich das Überschreiten zumindest eines Grenzwertes G1, G3 ermittelt werden kann. Somit ist an jedem Sensor 41, 42, 43, 44 jeweils ein zusätzlicher in Bezug auf den Flächenschwerpunkt des Betätigungsteils 20 innerer Sensor 51, 52, 53, 54 angeordnet, der jeweils zwischen einem äußeren Sensor 41, 42, 43, 44 und dem Flächenschwerpunkt des Betätigungsteils 20 gelegen ist. Dabei ist, wie in den Figuren 35 bis 38 gezeigt ist, insbesondere vorgesehen, dass der Grenzwert G1 des vom Flächenschwerpunkt des Betätigungsteils 20 aus gesehen äußeren Sensors kleiner ist wie der Grenzwert G3 des jeweils zugeordneten inneren Sensors 51, 52, 53, 54, wobei insbesondere ein Faktor von mindestens 1,1 vorgesehen sein kann.

In der Figuren 34 bis 37 ist gezeigt, dass das Betätigungsteil derart in seiner flächigen Erstreckung elastisch ausgeführt sein kann, dass zumindest zwei entgegen gesetzt zueinander gelegene Betätigungsbereiche, z.B. diametral zueinander entgegen gesetzt gelegene Betätigungsbereiche (z.B. B41 und B42) oder an derselben Seitenkante des Betätigungsteils 20 gelegene Betätigungsbereiche (z.B. B41 und B43) oder optional auch drei oder vier Betätigungsbereiche (z.B. B41, B42, B43 und B44) eine ausreichende Abstandsverringerung an zwei Sensoren durch entsprechende Betätigung (F1, F2) unter Bereitstellung einer entsprechenden Rückstellfähigkeit des Betätigungsteils 20 gegeben sein kann.

Zur Realisierung der Betätigungsfunktion der Schaltvorrichtung 1 sind bei dem Vorhandensein von mehreren Sensoren einer Schaltvorrichtung 1 ist die flächige Relation der Betätigungsbereiche in der Dickenrichtung Z gesehen an Stellen gleich der räumlichen Relation der Stellen, an denen die Sensoren gelegen sind. Zusätzlich sind die Bereiche in der Dickenrichtung Z gesehen und die Stellen der Sensoren übereinander gelegen, so dass sich die jeweilige flächige Relation ergibt.

Unter der Bezeichnung "flächige Relation" wird hierin die relative Zuordnung der Betätigungsbereiche in der X-Y-Ebene verstanden. Unter der Bezeichnung "Stellen der Sensoren" wird hierin die Positionen der Sensoren in der in der X-Y-Ebene verstanden.

Bei der Ausführungsform der Schaltvorrichtung 1 nach der Figur 68 weist deren Verbindungsvorrichtung 30 nicht eine zentrale Verbindungsschicht auf. Vielmehr ist die Verbindungsvorrichtung 30 aus mehreren Verbindungsschichten 61, 62, 63, 64 gebildet, die um den Flächenschwerpunkt des Betätigungsteils 20 entlang des äußeren Randabschnitts 21 des Betätigungsteils 20 über diesen verteilt angeordnet sind. Diese Anordnung von verteilt angeordneten Verbindungsschichten 61, 62, 63, 64 können auch bei anderen der hierin beschriebenen Ausführungsformen angeordnet sein. Die Verbindungsschichten 61, 62, 63, 64 sind länglich geformt.

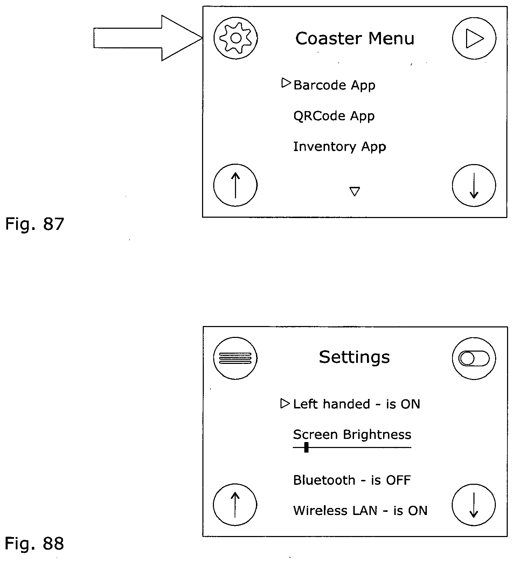

Bei der Ausführungsform der Schaltvorrichtung 1 nach der Figur 87 ist das Display 80 in die Grundplatte 10 integriert, wobei das Display 80 an der ersten Oberfläche 10a der Grundplatte 10 gelegen sein kann. Dabei ist das Betätigungsteil aus einem transparenten Material gebildet, so dass Darstellungen des Displays 80 an der Betätigungsseite S1 erkennbar sind.

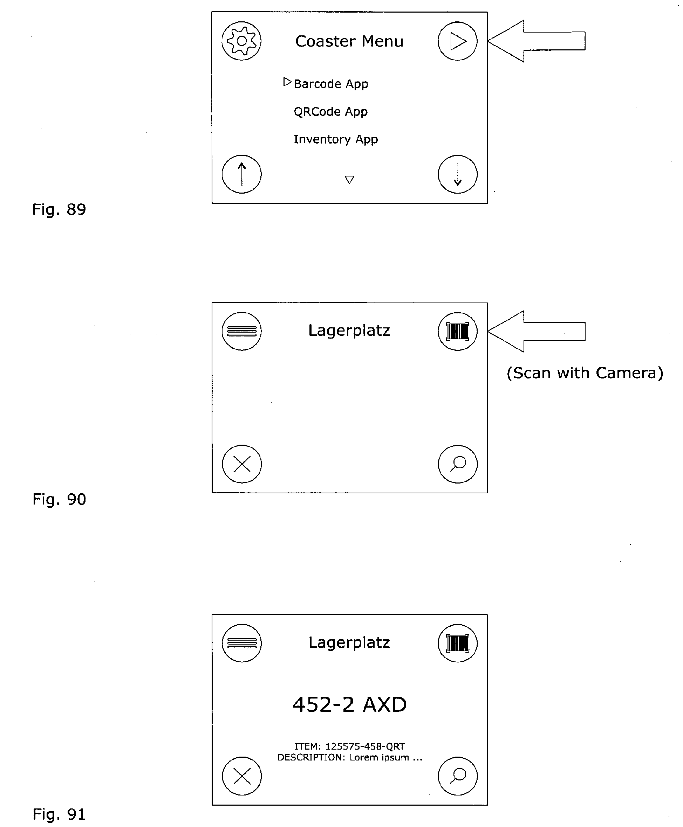

Bei der Ausführungsform der Schaltvorrichtung 1 nach der Figur 71 weist eine Verbindungsvorrichtung 30 auf, die ebenfalls keine zentrale Verbindungsschicht aufweist, sondern gegenüber der Schaltvorrichtung 1 nach der Figur 68 kreisförmige Verbindungsschichten 61, 62, 63, 64 aufweist, die um den Flächenschwerpunkt des Betätigungsteils 20 entlang des äußeren Randabschnitts 21 des Betätigungsteils 20 über diesen verteilt angeordnet sind. Auch bei der Ausführungsform der Schaltvorrichtung 1 nach der Figur 90 ist das Display 80 in die Grundplatte 10 integriert.

Die Schaltvorrichtung 1 nach der Figur 68 oder 71 kann eine zusätzliche am Flächenschwerpunkt des Betätigungsteils 20 gelegene, zentrale Verbindungsschicht 31 z.B. gemäß der Figur 1 aufweisen.

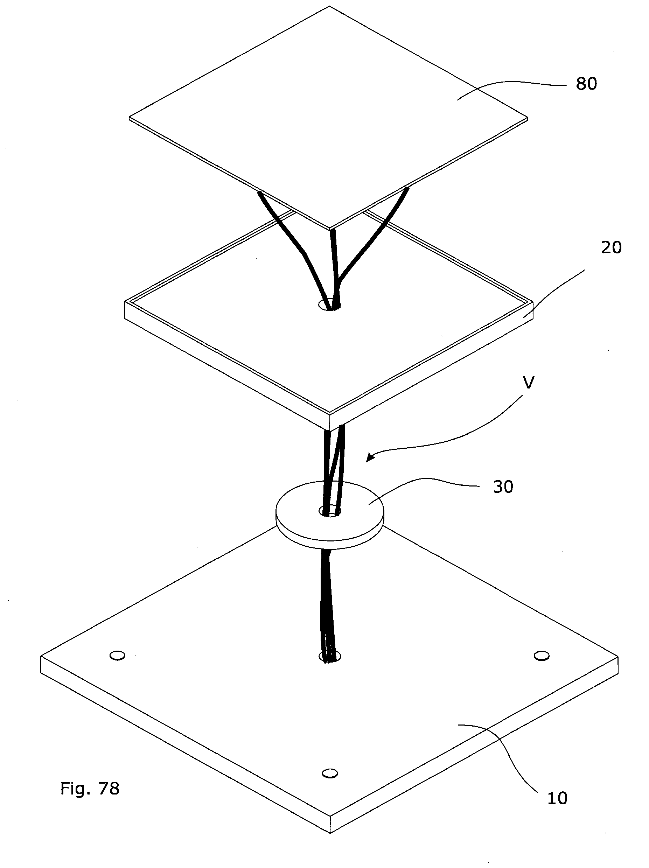

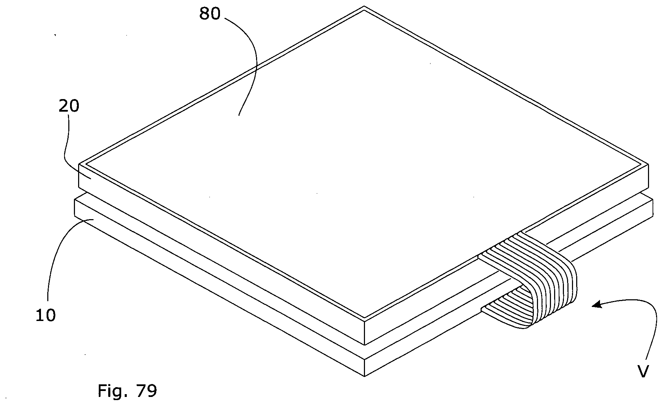

In den Figuren 78 und 79 sind beispielartig verschiedene Ausführungsformen einer elektrischen Anbindung des Display 80 an elektrische Komponenten K des Grundkörpers 10 mittels einer Verbindungsvorrichtung V und somit die Realisierung einer Funktionalität der Schaltvorrichtung dargestellt. Bei der in der Figur 798 dargestellten Ausführungsform weist die Schaltvorrichtung 1 eine Signalverbindungs-Vorrichtung V in Form eines Kabelstrangs V1 von Leitungen auf, die einerseits mit elektrischen Komponenten des Displays 80 und andererseits mit elektronischen oder elektrischen Komponenten K der Bodenplatte 10 verbunden sind. Dabei erstreckt sich der Kabelstrang durch eine zentrale Öffnung des Betätigungsteils 20 und, bei einer zentral angeordneten Verbindungsschicht 31, durch eine zentrale Öffnung der Verbindungsschicht 31. Bei der dargestellten Ausführungsform erstreckt sich der Kabelstrang V1 durch zumindest eine Öffnung des Betätigungsteils 20 und gegebenenfalls durch die Verbindungsvorrichtung 30. Bei der Ausführungsform, bei der die elektronischen Komponenten K an dem Grundkörper 10 angeordnet sind, sind diese an elektrische Leitungen desselben angeschlossen. Dabei kann der Kabelstrang an Leitungen des Grundkörpers 10 angeschlossen sein. Optional kann, wie es in der Figur 78 gezeigt ist, auch vorgesehen sein, dass sich der Kabelstrang durch die Grundplatte 10 erstreckt und gegebenenfalls an der zweiten Seite S2 an die mit den Komponenten K in Verbindung stehenden Leitungen den Grundkörper 10 angeschlossen ist. wird derselben Bei der in der Figur 79 dargestellten Ausführungsform weist die Signalverbindungs-Vorrichtung V einen Kabelstrang V2 in Form eines Breitbandkabels auf. Bei der Schaltvorrichtung 1 nach der Figur 79 wird der Kabelstrang V2 an einer Seite der Schaltvorrichtung 1, also von dem Display 80 aus seitlich von dem Betätigungsteil 20 weg geführt und dem Grundkörper 10 zugeführt, wobei der Kabelstrang V2 elektrisch an Leitungen des Grundkörpers 10 und somit eine Verdrahtung der Leitungen des Kabelstrang V2 mit den an dem Grundkörper 10 angebrachten Komponenten K realisiert ist.

Generell und insbesondere bei dem Vorhandensein von mehreren Sensoren einer Schaltvorrichtung 1 sind die Betätigungsbereiche derart gelegen, dass eine Betätigung oder ein Ausüben einer Druckkraft mit einer Mindestgröße in einem jeweiligen Betätigungsbereich
- in Abhängigkeit der Ausführung der Verbindungsvorrichtung und insbesondere der Gestalt, Anzahl und Lage oder Anordnung der zumindest einen Verbindungsschicht
- in Richtung von der Betätigungsseite S1 zum Grundkörper 10 hin
eine ausreichende Verringerung des Abstands zwischen dem Grundkörper 10 und dem Betätigungsteil 20 nur in diesem jeweiligen Betätigungsbereich und somit nur an dem Sensor, der an dem jeweiligen Betätigungsbereich oder Steuerungsfeld gelegen ist, auftritt. Dabei ist der Sensor und eine mit diesem funktional verbundene Funktions-Verarbeitungsvorrichtung oder Auswertungsvorrichtung 90 (Figuren 85 und 86) derart ausgeführt, dass bei einer solchen Aktion mittels einer Aktivierungs-Identifikationsfunktion 91 die Betätigung des jeweiligen Betätigungsbereichs erfasst wird.

Bei Vorhandensein eines annäherungssensitiven und/oder berührungssensitiven Paneels 82, das z.B. auf einem insbesondere plattenförmigen Bilderzeugungsmodul 81 angeordnet ist, können in dem Display 80 mittels eines Bilderzeugungs-Generators 97 Darstellungen in vorbestimmten Darstellungsformaten sichtbar gemacht werden. Dabei wird ein jeweiliges Steuerungsfeld im Anzeigebereich eines Anzeigepaneels bzw. im z.B. plattenförmigen Bilderzeugungsmodul 81 des Displays 80 durch Generierung mittels des Bilderzeugungs-Generators 97 sichtbar gemacht. Ein Steuerungsfeld kann ein Betätigungsbereich (z.B. B41 gemäß Figur 4) sein, so dass bei manuellem Drücken auf diesen Betätigungsbereich ein an der Stelle dieses Betätigungsbereichs und insbesondere in Z-Richtung benachbart zu diesem liegender Sensor (z.B. der Sensor 41) eine Bewegung des Betätigungsteils 20 an dem jeweiligen Betätigungsbereich über den Grenzwert G1 hinaus ermittelt. Es können in Bezug auf die Lage der Sensoren 40 an weiteren Stellen Steuerungsfelder zur Anzeige gebracht werden.

Die im Folgenden beschriebene Auswertungsvorrichtung 90 kann insbesondere bei einer Schaltvorrichtung 1 nach einer anhand der Figuren 1 bis 77 beschriebenen Ausführungsform vorgesehen sein. Alternativ dazu kann die Auswertungsvorrichtung 90 in Kombination mit einer auf andere Weise ausgeführten Schaltvorrichtung, insbesondere eine aus dem Stand der Technik bekannte Schaltvorrichtung mit zumindest einem an dessen Display erzeugbaren Steuerungsfeld vorgesehen sein.

Nach einer Ausführungsform der Schaltvorrichtung 1 sind die Funktionen der Auswertungsvorrichtung 90 in den Komponenten K, die an dem Grundköper 10 angebracht oder an diesem integriert sind, funktional integriert.

Die Auswertungsvorrichtung 90 kann derart ausgeführt sein, dass die Aktivierungs-Identifikationsfunktion 91 von dem zumindest einen Sensor der Schaltvorrichtung 1 über eine Funktionsleitung 91e Signale erhält, die einer ausreichenden Verringerung des Abstands zwischen dem Grundkörper 10 und dem Betätigungsteil 20 über den GrenzwertG1 hinaus entsprechen, bei der die Betätigungsbereich-Identifikationsfunktion 91 eine Betätigung identifiziert. Auf diese Weise kann die Erfassung einer ausreichenden Verringerung des Abstands mittels eines Sensors durch die Aktivierungs-Identifikationsfunktion 91 bestätigt werden.

Bei Vorhandensein eines annäherungssensitiven und/oder berührungssensitiven Paneels 82 kann das jeweilige Steuerungsfeld, das in seiner Lage der relativen Lage eines Display-Betätigungsbereichs entsprechen kann und insbesondere in diesem gelegen sein kann, durch ein Menü-Steuerungsmodul 96 und einen mit diesem funktional verbundenen Bilderzeugungs-Generator 97 mittels des mit diesem funktional verbundenen Bilderzeugungsmoduls 81 oder in dem Bilderzeugungsmodul 81, also im Display 80, insbesondere an einem Display-Betätigungsbereich sichtbar gemacht werden. Mittels der Aktivierungs-Identifikationsfunktion 91, die über die Leitung 97a mit dem annäherungssensitiven und/oder berührungssensitiven Paneel 82 funktional verbunden ist, kann erfasst werden, ob das jeweils im Display 80 sichtbar gemachte Steuerungsfeld durch eine manuelle Geste, also insbesondere durch ein Drücken eines jeweiligen Betätigungsbereichs, betätigt worden ist.

Durch das Menü-Steuerungsmodul 96 werden je nach den bereitgestellten Benutzerfunktionen und einem mit diesen jeweils zur Ansicht auf dem Display 80 gebrachten Menüformat dem jeweiligen Steuerungsfeld Bedeutungen zugeordnet, die insbesondere im Zusammenhang mit zu erfüllenden Aufgaben einer externen Arbeitseinrichtung E und insbesondere von Arbeitsbereich-Teilnehmern T oder einem Zentralsystem Z stehen.

Generell und insbesondere bei einer Ausführungsform des Schaltgeräts 1 mit dem annäherungs- und/oder berührungssensitives Paneel 84 und ohne der Verbindungsvorrichtung mit einer insbesondere elastischen Verbindungsschicht 31, dabei optional ohne Betätigungsteil 20, und ohne Sensor-Vorrichtung 40 kann das Schaltgerät 1 derart ausgeführt sein, dass die Betätigung eines Steuerfelds in einer Menüauswahl durch Auswahl einer in dem Steuerbereich angegebenen Option mittels Berührung oder Berührungsannäherung des Fingers eines Schaltgerät-Benutzers einer solchen Option, die im Anzeigebereich des Display 80 verfügbar gemacht wird, erfolgen kann.

Generell und insbesondere bei einer Ausführungsform des Schaltgeräts 1 ohne einem annäherungs- und/oder berührungssensitives Paneel 84 und ohne der elastischen Verbindungsschicht 31, dabei optional ohne Betätigungsteil 20, und Sensoren 40 kann das Schaltgerät 1 derart ausgeführt sein, dass die Betätigung eines Steuerfelds in einer Menüauswahl durch herkömmliche Aktivierung oder Auswahl einer in dem Steuerbereich angegebenen Option, die im Anzeigebereich des Display 80 verfügbar gemacht wird, erfolgen kann, also z.B. durch Tasten oder einer Computermaus oder einer anderen manuellen Eingabevorrichtung.

Die Betätigung eines Steuerfelds in einer Menüauswahl durch Berührung oder Berührungsannäherung und alternativ oder zusätzlich durch herkömmliche Aktivierung kann auch bei der Ausführungsform der Schaltvorrichtung mit der elastischen Verbindungsschicht 31 und Sensoren 40 gegeben sein.

Wie in den Figuren 85 und 86 gezeigt, werden bei einer Ausführungsform des Schaltgeräts 1 mit der elastischen Verbindungsschicht 31 und Sensoren 40 die von dem zumindest einen Sensor erzeugten Sensorsignale, die in Abhängigkeit einer am jeweiligen Betätigungsbereich ausgeübten Betätigungskraft F1, F2 Abstandswerten für Abstände zwischen dem Grundkörper 10 und dem Betätigungsteil 20 entsprechen, über mit jeweils einem Sensor verbundene Funktionsleitungen 91e der Betätigungsbereich-Identifikationsfunktion 91 zugeführt. Generell wird bei Betätigung eines Steuerungsfelds der Schaltvorrichtung, das im Display vorhanden ist oder durch das Menü-Steuerungsmodul 96 erzeugt wird, in der Aktivierungs-Identifikationsfunktion 91 eine Aktivierung des Steuerungsfelds identifiziert.

Insbesondere bei einer Schaltvorrichtung 1 nach einer anhand der Figuren 1 bis 77 beschriebenen Ausführungsform ermittelt die Aktivierungs-Identifikationsfunktion 91 aus diesen Sensorsignalen anhand von vorgegebenen Betätigungs-Mindestwerten, ob aufgrund der jeweils ausgeübten Betätigungskraft F1, F2 eine Betätigung eines Betätigungsbereichs, bei der Ausführungsform der Figur 1 einer der Betätigungsbereiche B41 bzw. B42 bzw. B43 bzw. B44, und in welcher Weise (gegebenenfalls eine spezielle Verrastungsstellung) gegeben ist. Die Betätigungsbereich-Identifikationsfunktion 91 ermittelt anhand von zumindest einem vorgegebenen Betätigungs-Mindestwert, der jeweils einem Sensor zugeordnet ist, ob der Abstand zwischen dem Grundkörper 10 und dem Betätigungsteil 20 am Ort des Sensors, der jeweils an einem durch eine Betätigungskraft F1, F2 bewegten Betätigungsbereichs gelegen ist, zumindest einen vorgegebenen Betätigungs-Mindestwert (z.B. G1 oder G2) überschreitet. Wenn dieser Vergleich eine solche Überschreitung feststellt, stellt die Betätigungsbereich-Identifikationsfunktion 91 fest, dass an dem jeweiligen Betätigungsbereich eine Betätigung des Betätigungsteils 20 gegeben ist. Dabei kann auch vorgesehen sein, dass mehrere Grenzwerte G1, G2 bzw. G1, G3 mit den Sensorwerten eines Sensors oder der Sensoren verglichen werden, so dass mehrere Kraftstufen einer Betätigungskraft F1, F2 als unterschiedliche Betätigungen an demselben Betätigungsbereich festgestellt werden können. Der zumindest eine Betätigungs-Mindestwert kann in der Betätigungsbereich-Identifikationsfunktion 91 als zumindest ein vorgegebener Wert abgespeichert sein. Alternativ oder zusätzlich dazu kann vorgesehen sein, dass der zumindest eine Betätigungs-Mindestwert über eine Schnittstelle 95 und mittels dem Menü-Steuerungsmodul 96 der Betätigungsbereich-Identifikationsfunktion 91 zugeführt ist, beispielsweise wiederum über eine Menüfunktion, die über die Betätigung eines Betätigungsbereichs in einer vorgegebenen Menüebene oder Menüauswahl ausgewählt werden kann.

Wenn die Betätigungsbereich-Identifikationsfunktion 91 feststellt, dass eine Betätigung eines Betätigungsbereichs aufgrund der voranstehend beschriebenen Weise oder auf andere Weise wie Berührung oder Annäherung gegeben ist, sendet die Betätigungsbereich-Identifikationsfunktion 91 diese Betätigungsinformation über eine Funktionsleitung 91b an ein Betätigungsmodul 92.

Je nach der Ausführungsform des Schaltgeräts 1 kann die Betätigungsinformation, die über eine Funktionsleitung 91b an ein Betätigungsmodul 92 übermittelt wird, insbesondere bei jeglichen Schaltvorrichtungen auch anders erzeugt werden, z.B.
- durch Berührung oder Berührungsannäherung bei einer Eingabegeste des Fingers eines Schaltgerät-Benutzers in oder an einem in einem von dem Generator 97 in dem Bilderzeugungsmodul 81 erzeugten Steuerbereich oder Steuerungsfeld, der bzw. das im Anzeigebereich des Display 80 als Eingabeoption verfügbar gemacht wird, oder
- durch herkömmliche Aktivierung einer solchen Option durch Tasten oder einer Computermaus oder einer anderen manuellen Eingabevorrichtung.

Grundsätzlich ist es möglich für die Eingabe von Betätigungsinformationen im Zusammenhang mit Aufgaben im Bereich der Logistik auch auf nicht erfindungsgemäße Vorrichtungen zurückzugreifen, und hierfür Geräte aus dem Stand der Technik zu verwenden (insbesondere sog. Smartphones oder sog. Tablet-PCs). Die Verwendung von erfindungsgemäßen Schaltvorrichtungen für diesen Zweck ist hinsichtlich einer einfachen Bedienbarkeit insbesondere unter industriellen Bedingungen (wenn z. B. die bedienende Person Arbeitshandschuhe trägt) besonders vorteilhaft.

Eine jeweils zu erfüllende und mittels des Schaltgeräts an eine Teilnehmer-Vorrichtung eines Teilnehmers einer Anlage zu übermittelnde Teilnehmer-Aufgabe wird durch das Menü-Steuerungsmodul 96 in einem jeweiligen Steuerungsfeld als eine logische Aufgabenfrage in einem vorbestimmten Darstellungsformat insbesondere in Form einer Option dem Betätigungsmodul 92 über eine Funktionsleitung 96a zur Verfügung gestellt. Eine Option oder logische Frage kann z.B. sein: "Senden einer Anzahl N1 von Lagerobjekten O1 an einen Warenausgang", wobei diese Option an ein Lagerfahrzeug zu richten ist.

Die Schnittstelle 95 weist insbesondere eine Eingangsvorrichtung auf, mit der von einem Arbeitsbereich-Teilnehmer T oder einem Zentralsystem Z oder beiden Daten über eine drahtlose Kommunikationsverbindung und insbesondere ein drahtloses Kommunikations-Netzwerk und insbesondere über Funk empfangen werden können. Der Teilnehmer T und/oder das Zentralsystem Z kann hierzu eine Programm-Speichervorrichtung, hierin auch App-Library genannt, aufweisen. Insbesondere kann eine optionale Arbeitsaufgabe, hierin auch generell Aufgabe genannt, und insbesondere auch optional zur Erfüllung der Aufgabe verfügbare Aufgabendurchführungs-Kommandos zur Betätigung des jeweiligen Teilnehmers über die Sende- und Empfangseinrichtung der Schnittstelle 95 eingelesen werden, die in dem Zentralsystem Z, insbesondere der App-Library, oder einem Steuerungssystem des jeweiligen Teilnehmers abgespeichert sein kann. Auch können in der jeweiligen Schaltvorrichtung entsprechende Aufgabendurchführungs-Kommandos abgespeichert und zur Übermittlung abrufbar sein. Mit einer Ausgangsschnittstelle 93 können insbesondere Instruktionen an einen oder den jeweiligen Teilnehmer übermittelt werden.

Generell kann vorgehen sein, dass die Kommunikation zwischen der Schaltvorrichtung, dem Zentralsystem Z und einem jeweiligen Arbeitsbereich-Teilnehmer T über eine drahtlose Kommunikationsverbindung und insbesondere ein drahtloses Kommunikations-Netzwerk und insbesondere über Funk erfolgt.

Auch kann das Menü-Steuerungsmodul 96 derart ausgeführt sein, dass mit diesem die Auswahl einer Menü-Ebene oder eines Menüauswahl-Formats insbesondere mit einer Auswahlmöglichkeit über ein wählbares Auswahlformat im oder am Betätigungsbereich zur Anzeige gebracht wird, um eine zu erfüllende Teilnehmer-Aufgabe zu ermitteln und zur Anzeige zu bringen. Hierzu zeigt das Menü-Steuerungsmodul 96 über ein Menü und insbesondere eine entsprechende Menüauswahl eine Aufgabe oder eine Anfrage über ein Menü wie z.B. Anfrage über eine Menü-Ebene, also ein Menüauswahl-Format, auf dem Display 80 an. Die Auswahl eines Menüformats in einer dargestellten Menüauswahl erfolgt über eine Betätigung der Schaltvorrichtung und eine mittels der Betätigungsbereich-Identifikationsfunktion 91 festgestellte Betätigung, dabei insbesondere aufgrund einer der hierin dazu beschriebenen Optionen, und indem aufgrund dieser Betätigung eine Betätigungsinformation über die Funktionsleitung 96a an das Menü-Steuerungsmodul 96 übermittelt wird, das daraufhin das ausgewählte Menüformat auf dem Display 80 zur Verfügung stellt.

In gleicher Weise wird im Rahmen einer dargestellten Menüauswahl eine Arbeitsaufgabe oder Aufgabe ausgewählt und als Aufgabendurchführungs-Kommando durch einen Arbeitsbereich-Teilnehmer über die Schnittstelle 95 an den jeweiligen Teilnehmer zur Aufgaben-Erfüllung durch denselben übermittelt. Dabei kann insbesondere vorgesehen sein, dass durch die Übermittlung der Dies erfolgt über eine mittels der Betätigungsbereich-Identifikationsfunktion 91 festgestellte Betätigung der Schaltvorrichtung und indem aufgrund dieser Betätigung eine Betätigungsinformation über die Funktionsleitung 96a an das Menü-Steuerungsmodul 96 übermittelt wird, das daraufhin die ausgewählte Teilnehmer-Aufgabe oder eine Aufgabendurchführungs-Kommando zur Erfüllung der ausgewählten Teilnehmer-Aufgabe an den jeweiligen Teilnehmer übermittelt.

Der jeweilige Teilnehmer und insbesondere dessen Steuerungssystem ist derart ausgeführt, dass der Teilnehmer das übermittelte bzw. empfangende Aufgabendurchführungs-Kommando ausführt und dadurch die kommandierte Aufgaben-Erfüllung realisiert.

Das Menü-Steuerungsmodul 96 kann auch derart ausgeführt sein, dass auf diese Weise, also mit Auswahlmöglichkeiten über ein wählbares Auswahlformat, eine Anwendungsfunktion, die in den Figuren 87, 89, 95 und 96 mit der Bezeichnung "App" bezeichnet ist, oder eine von mehreren Anwendungsfunktionen, durch eine genannte Betätigung ausgewählt werden kann. Eine solche Anwendungsfunktion kann insbesondere eine Teilnehmer-Aufgabe und zumindest ein dieser zugeordnetes Aufgabendurchführungs-Kommando zur Erfüllung dieser Aufgabe aufweisen. Dabei kann vorgesehen sein, dass die Anwendungsfunktion "App" über die Schnittstelle 95 eine genannte Betätigung angewählt werden kann und übermittelt wird oder in dem Menü-Steuerungsmodul 96 verfügbar ist und angewählt werden kann. Die Anwendungsfunktion "App" enthält zumindest ein entsprechendes Aufgabendurchführungs-Kommando, das - wie beschrieben - an einen Teilnehmer zur Erfüllung einer ausgewählten Aufgabe übermittelt werden kann.

Somit ist nach einer Ausführungsform des Arbeitsverfahrens in der ausgewählten Anwendungsfunktion App zumindest eine von einem oder mehreren Arbeitsbereich-Teilnehmern T; T1, T2, T3 des Arbeitssystems S zu erfüllende Teilnehmer-Aufgabe auf dem Display 80 auswählbar und die Erfüllung der jeweiligen Aufgabe aufgrund der Übermittlung eines Aufgabendurchführungs-Kommandos an einen Arbeitsbereich-Teilnehmer durch diesen Teilnehmer realisierbar.

Das Arbeitssystem S kann insbesondere die zumindest eine Schaltvorrichtung insbesondere nach einer der hierin beschriebenen Ausführungsformen, zumindest einen Teilnehmer, wie z.B. ein Fahrzeug oder eine Arbeitsvorrichtung, und ein Zentralsystem Z aufweisen.

Das Betätigungsmodul 92 ermittelt aus der Information über die angefragte Teilnehmer-Aufgabe und der Betätigungsinformation ein Aufgabendurchführungs-Kommando, das über eine Ausgangsleitung 92a an eine Ausgangsschnittstelle 93 übermittelt wird. Das Aufgabendurchführungs-Kommando ist ein Kommando für einen Arbeitsbereich-Teilnehmer T, eine Aufgabe TA durchzuführen. Die Ausgangsschnittstelle 93 übermittelt das Signal an eine externe Einheit wie z.B. dem Zentralsystem oder einem Teilnehmer T bzw. T1, T2, T3 des Arbeitssystems S.

Alternativ kann vorgesehen sein, dass die Information über die angefragte Teilnehmer-Aufgabe statt über die Funktionsleitung 96a über die Funktionsleitung 91a an das Betätigungsbereich-Identifikationsfunktion 91 gesendet wird, das die Information über die angefragte Teilnehmer-Aufgabe zusammen mit der Betätigungsinformation über die Funktionsleitung 91a an die Ausgangsschnittstelle 93 übermittelt.

Die Ausgangsschnittstelle 93 übermittelt das Aufgabendurchführungs-Kommando über einen Übertragungsweg 93a an das Zentralsystem Z oder einem oder mehreren Arbeitsbereich-Teilnehmern T bzw. T1, T2, T3 des Arbeitssystems S.

Die Ausgangsschnittstelle 93 kann insbesondere eine Übertragungsfunktion zum Übersenden des Aufgabendurchführungs-Kommandos generell über eine Netzwerkanbindung und dabei insbesondere per Funk aufweisen. Weiterhin kann die Ausgangsschnittstelle 93 derart ausgestaltet sein, dass das Aufgabendurchführungs-Kommando an das Zentralsystem Z und sämtliche Arbeitsbereich-Teilnehmer oder an sämtliche Arbeitsbereich-Teilnehmer und nicht an das Zentralsystem Z gesendet werden kann bzw. wird. Die Ausgangsschnittstelle 93 kann auch derart ausgeführt sein, dass alternative Teilnehmer-Aufgaben und zumindest ein jeweils zugehöriges Aufgabendurchführungs-Kommando aufgrund einer durch das Menü-Steuerungsmodul 96 angegebenen oder Menüauswahl in einer entsprechenden Menüebene einzeln auswählbar sind und an einen Teilnehmer übermittelt werden können.

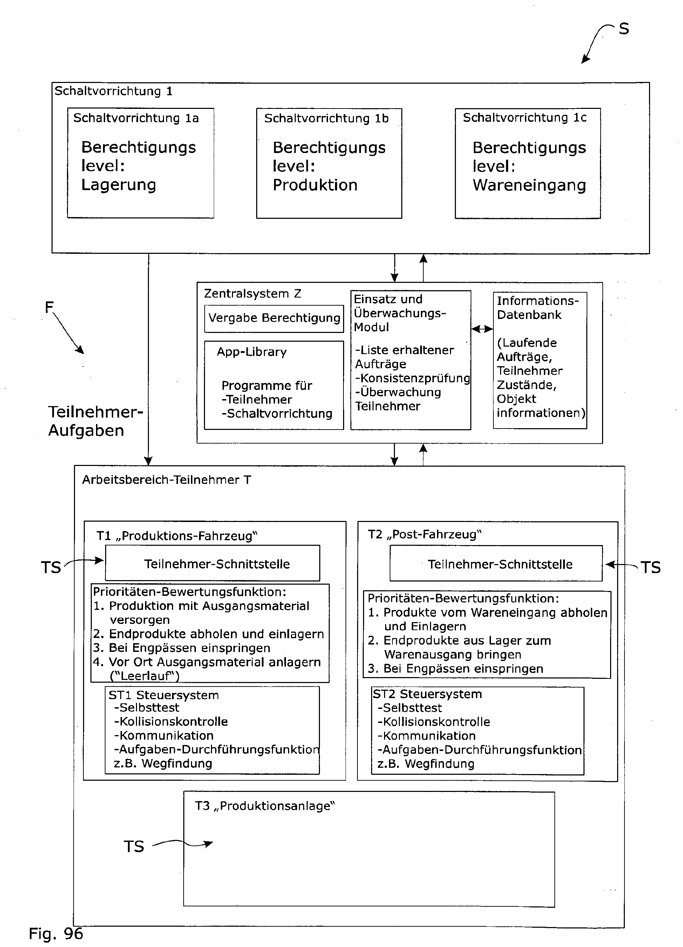

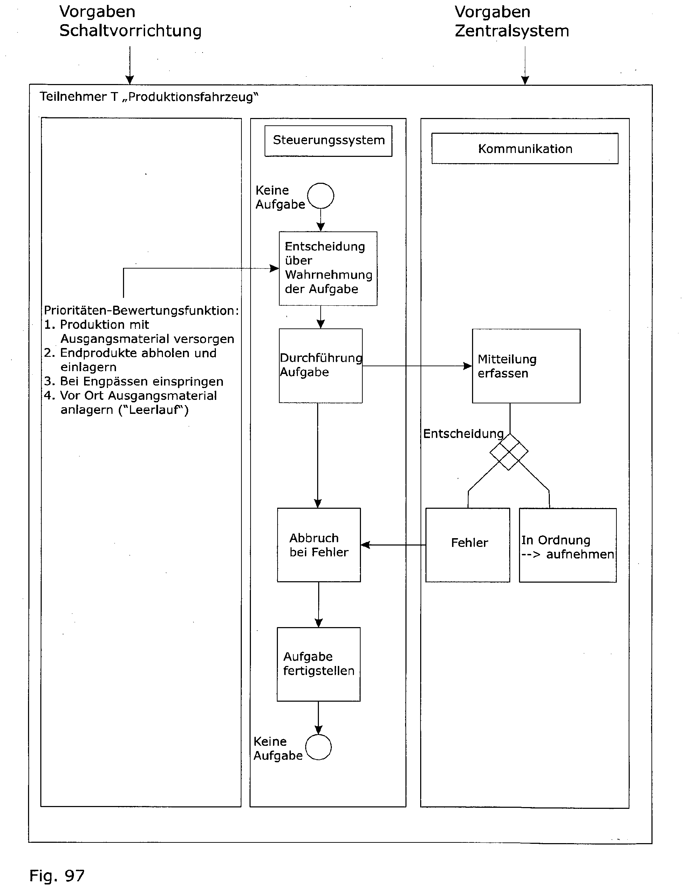

Die zu den Figuren 96 und 97 beschriebenen Funktionen können auch auf andere Weise zusammengefasst und miteinander integriert sein, so dass insbesondere die angegebenen Funktionsverbindungen einfache funktonale Übergabestellen eines Programmsystems sein können.

Die für die Auswertungsvorrichtung 90 bezeichneten Leitungen können auch Übergabeverfahren innerhalb eines Programmprodukts sein.

Somit kann mit der Schaltvorrichtung nach einer der hierin beschriebenen Ausführungsformen eine von einem oder mehreren Arbeitsbereich-Teilnehmern T bzw. T1, T2, T3 des Arbeitssystems S zu erfüllende Teilnehmer-Aufgabe ermittelt werden, gegebenenfalls zur Anzeige gebracht werden, und als Aufgabendurchführungs-Kommando über einen Übertragungsweg 93a an das Zentralsystem Z oder einem oder mehreren Arbeitsbereich-Teilnehmern T bzw. T1, T2, T3 des Arbeitssystems S übermittelt werden.

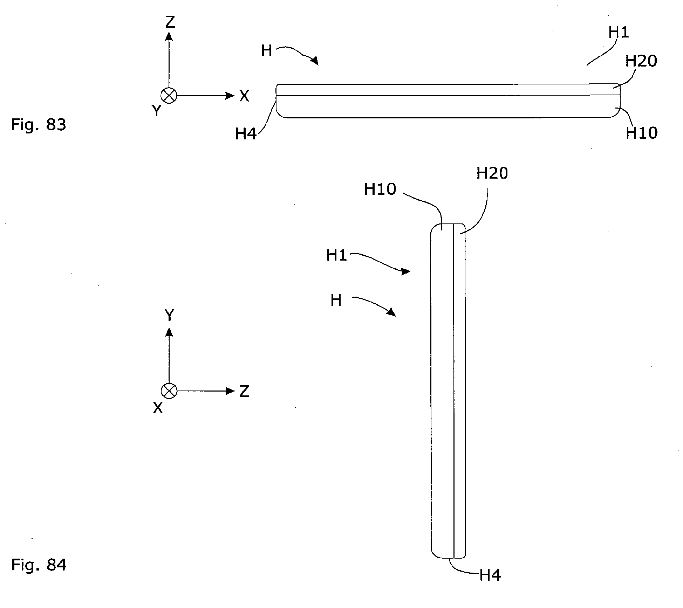

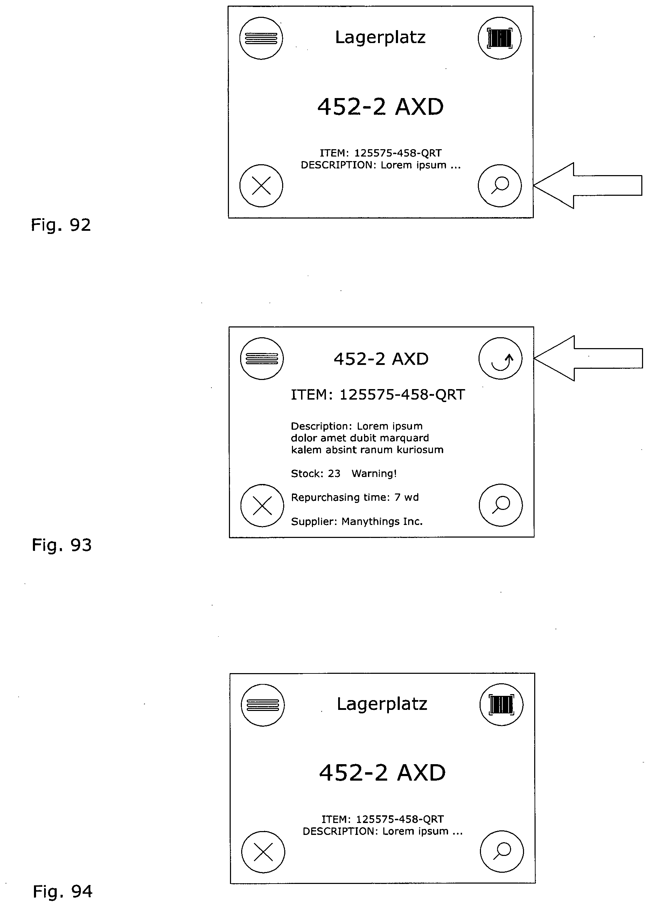

Die hierin beschriebenen Funktionen der Auswertungsvorrichtung 90 können insbesondere in den Komponenten K des Grundkörpers 10 integriert und somit Bestandteil generell einer mobilen und insbesondere tragbaren Schaltvorrichtung und insbesondere der Schaltvorrichtung 1 nach einer Ausführungsform der Figuren 1 bis 95 sein. Jedoch können die beschriebenen Funktionen der Auswertungsvorrichtung 90 in einer Schaltvorrichtung integriert sein, die als Smartphone oder als Laptop und insbesondere als tragbarer Computer ausgeführt ist.

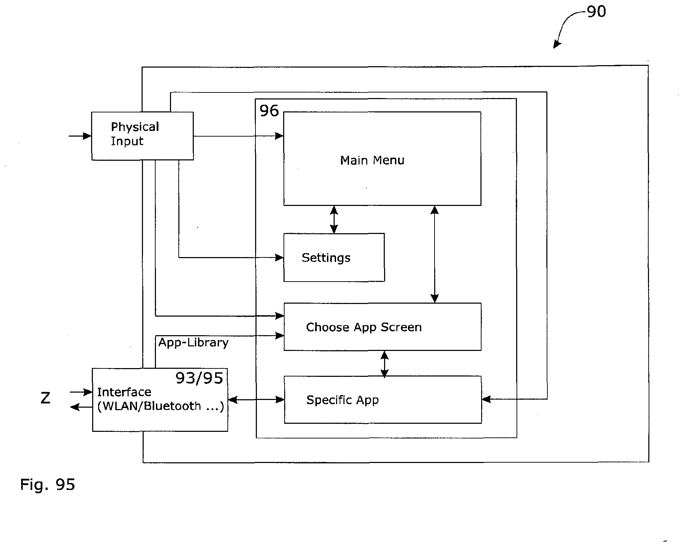

In der Figur 95 sind die Funktionen der Schaltvorrichtung in benutzerbezogener Weise dargestellt. Die Betätigung der Schaltvorrichtung in Verbindung mit einer in einem Steuerungsfeld von dem Menü-Steuerungsmodul 96 zur Anzeige gebrachten Menüauswahl ist mit dem Block "Physical Input" benannt. Die in einem Steuerungsfeld von dem Menü-Steuerungsmodul 96 durch eine zur Anzeige gebrachte Menüauswahl ist in dem mit dem Bezugszeichen "96" bezeichneten Block beispielsweise dargestellt.

In den Betätigungsbereichen können an der Display-Oberfläche 82a abschnittsweise zumindest ein räumlich ausgeprägter Oberflächenabschnitt 81r, 83r oder eine räumlich ausgeprägte Oberflächenstruktur zur haptischen Erfassung des jeweiligen Betätigungsbereichs ausgebildet sein. Die räumlich ausgeprägte Oberflächenabschnitte können gegenüber der flächigen Erstreckung der Display-Oberfläche 82a als vertiefte und/oder erhabene Stellen ausgeführt sein. Auf diese Weise kann ein Benutzer einen Betätigungsbereich innerhalb der ansonsten sich eben, also planar erstreckenden der Oberfläche 11a ertasten. Unter "räumlich ausgeprägter Struktur" wird hierin verstanden, dass diese eine plastische Formgebung hat, also eine Form hat, bei der die Oberflächenpunkte der Struktur nur mittels sämtlicher drei Raumkoordinaten definiert werden können.

In der Figur 96 sind Funktionen und Schritte einer Ausführungsform des Arbeitsverfahrens dargestellt. Generell können bei dem Arbeitsverfahren mehrere Schaltvorrichtungen und optional insbesondere gleichzeitig verwendet werden.

Nach einer Ausführungsform des Arbeitsverfahrens kann vorgesehen sein, dass für sämtliche oder einzelne verwendete Schaltvorrichtungen Berechtigungen für die Betätigung jeweils von Arbeitsbereich-Teilnehmern zu erfüllende Teilnehmer-Aufgaben oder für Aufgabenbereiche wie z.B. Lagerung, Produktion, Wareneingang, zu denen jeweils eine zu erfüllende Teilnehmer-Aufgabe gehört, bestehen. Dabei kann vorgesehen sein, dass zur Betätigung und Kommandierung der Durchführung einer zu erfüllenden Teilnehmer-Aufgabe oder zur Anwahl eines zugehörigen Aufgabenbereichs eine entsprechende Berechtigung freigeschaltet werden muss. Eine solche Sicherheitsfunktion kann in dem Zentralsystem bereitgestellt sein ("Vergabe Berechtigung"). Die Freischaltung kann über die Schnittstellen 93, 95 durch entsprechende Betätigung der Schaltvorrichtung in Verbindung mit einer in einem Steuerungsfeld von dem Menü-Steuerungsmodul 96 zur Anzeige gebrachten Menüauswahl erfolgen. Dabei kann auch vorgesehen sein, dass entsprechende Berechtigungen von dem Zentralsystem Z bereitgestellt werden, indem das Zentralsystem Z aufgrund des Empfangs eines Zugangscodes von einer Schaltvorrichtung freigegeben wird. Dabei kann in der Anwendungsfunktion oder der Steuerungsfunktion bzw. der Schaltvorrichtung 1 und insbesondere dem Betätigungsmodul 92 der Schaltvorrichtung auch die Bedingung implementiert sein, dass nur dann eine Teilnehmer-Aufgabe an eine Schaltvorrichtung übermittelt wird und/oder nur dann ein zugehöriges Aufgabendurchführungs-Kommando an einen Teilnehmer übermittelt wird, wenn der Abstand zwischen der Steuerungsvorrichtung des jeweiligen Teilnehmers und der Schaltvorrichtung 1 kleiner als ein vorgegebener Maximalabstand beträgt. Zu diesem Zweck kann die Steuerungsfunktion und/oder das Betätigungsmodul 92 eine Freigabe-Funktion aufweisen, die einen von der Steuerungsfunktion bzw. der Schaltvorrichtung 1 ermittelten Ist-Abstand verwendet und mit dem vorgegebenen Maximalabstand vergleicht. In dem Fall, dass der ermittelte Ist-Abstand geringer ist als der vorgegebene Maximalabstand, lässt die Freigabe-Funktion die jeweilige Übermittlung zu und andernfalls blockiert diese die jeweilige Übermittlung. In beiden Fällen kann die Freigabe-Funktion in der Steuerungsvorrichtung eines Teilnehmers oder in der Schaltvorrichtung und insbesondere dem Betätigungsmodul 92 der Schaltvorrichtung oder in beiden funktional integriert sein.

Diese Freigabe-Funktion kann jeweils auch als abschaltbar oder zuschaltbar implementiert sein.

Nach einer Ausführungsform des Arbeitsverfahrens erfolgt nach Auswahl einer Teilnehmer-Aufgabe eine Übermittlung einer ausgewählten Teilnehmer-Aufgabe durch Betätigung der Schaltvorrichtung 1 an mehrere Arbeitsbereich-Teilnehmer T bzw. T1, T2, T3. ;it Empfang des Aufgabendurchführungs-Kommandos durch den Teilnehmer T erfolgt eine Aktivierung des Steuerungssystems des Arbeitsbereich-Teilnehmers T, da das Steuerungssystem aufgrund des Empfangs des Aufgabendurchführungs-Kommandos Steuerungskommandos erzeugt und an Aktuatoren des Teilnehmers übermittelt. Durch die Steuerungskommandos wird zumindest ein Aktuator des Teilnehmers zur Durchführung einer Aufgabendurchführungs-Aktion betätigt, wodurch der jeweilige Teilnehmer eine Erfüllung der von der Schaltvorrichtung 1 ausgewählten bzw. betätigten Arbeitsaufgabe durch den Teilnehmer T entsprechend des Aufgabendurchführungs-Kommandos vornimmt.

Als Beispiele für einen Teilnehmer T sind ein Produktionsfahrzeug T1, eine Post-Fahrzeug T2 und eine Produktionsanlage T3 dargestellt. Generell kann der Teilnehmer T ein Fahrzeug oder eine Arbeitsvorrichtung sein, die jeweils zumindest einen Aktuator aufweisen, um eine Arbeitsaufgabe auszuführen.

Beispielsweise in dem Fall, dass der Teilnehmer T ein Fahrzeug ist, kann der Aktuator eine Betätigungsvorrichtung zur Einstellung einer Lenkvorrichtung oder eine Betätigungsvorrichtung zum Beschleunigen oder eine Betätigungsvorrichtung zum Bremsen sein.

Beispielsweise in dem Fall, dass der Teilnehmer T eine am Boden gelagerte Arbeitsvorrichtung und z.B. eine Produktionsanlage wie z.B. eine Werkzeugmaschine oder einer Bauteil-Herstellungsvorrichtung ist, kann der Aktuator eine Betätigungsvorrichtung zum Starten einer Komponente wie z.B. eines Förderbandes, zum Erhitzen eines Ofens, zur Einstellung einer Zufuhreinrichtung sein.

Das Arbeitssystem S kann insbesondere die zumindest eine Schaltvorrichtung insbesondere nach einer der hierin beschriebenen Ausführungsformen, zumindest einen Teilnehmer wie eine Arbeitsvorrichtung und ein Zentralsystem Z aufweisen. Die Arbeitsvorrichtung kann ein solches Lagersystem sein.

Das Arbeitssystem S, in dem das Arbeitsverfahren erfolgt, kann insbesondere ein Lagersystem sein, wobei zumindest zwei Teilnehmer T; T1, T2, T3 Lagerbediengeräte wie z.B. Gabelstapler, Kräne, an einem Lagerregal bewegbare Fahrzeuge, oder eine Kombination zumindest einer Auswahl derselben sein.

Das Arbeitssystem S kann auch ein Produktionssystem oder Liefersystem oder Fördersystem oder Beförderungssystem jeweils mit einem hierin beschriebenen Zentralsystem Z sein. Generell ist das Arbeitssystem S eine Industrieanlage mit einem hierin beschriebenen Zentralsystem Z.

Auch kann der Teilnehmer oder die Arbeitsvorrichtung eine Produktionsvorrichtung oder eine Liefervorrichtung oder Fördervorrichtung sein.

Die Teilnehmer T bzw. T1, T2, T3 können jeweils ein Teilnehmer-System TS aufweisen, das eine Schnittstelle insbesondere zum Empfang eines von einer Ausgangsschnittstelle 93 übermittelten Aufgabendurchführungs-Kommandos auf. Weiterhin kann das Teilnehmer-System TS eine Prioritäten-Bewertungsfunktion aufweisen, mit der über einen Arbeitszeitraum empfangene Aufgabendurchführungs-Kommando jeweils eine Priorisierung der über einen vorgegebenen Arbeitszeitraum empfangenen Teilnehmer-Aufgaben erfolgt, die den empfangenen Aufgabendurchführungs-Kommandos entsprechen. Die Bedeutung und Inhalte von Aufgaben, die zu einem jeweiligen Aufgabendurchführungs-Kommando gehören, können in dem Teilnehmer T bzw. T1, T2, T3 verfügbar sein. Alternativ oder zusätzlich kann vorgesehen sein, dass diese gegebenenfalls insbesondere auf automatische Anfrage durch den jeweiligen Teilnehmer T bzw. T1, T2, T3 an das Zentralsystem Z von dem Zentralsystem Z dem jeweiligen Teilnehmer T bzw. T1, T2, T3 bereitgestellt wird.

Die Schaltvorrichtung kann somit eine Schnittstellenfunktion aufweisen, mit der diese über eine drahtlose Kommunikationsverbindung eine Arbeitsaufgabe von einem Teilnehmer oder einem Zentralsystem Z empfangen kann. Mit dem Display der Schaltvorrichtung kann eine Anwahl der Arbeitsaufgabe vorgenommen und bei entsprechender Betätigung der Schaltvorrichtung und insbesondere des Displays wird ein Aufgabendurchführungs-Kommando an den Teilnehmer T über die drahtlose Kommunikationsverbindung übermittelt. Die Schaltvorrichtung kann insbesondere nach einer hierin beschriebenen Ausführungsform gebildet sein.

Der zumindest einen Teilnehmer weist ein Steuerungssystem und eine mit dieser funktional in Verbindung stehende Schnittstellen-Funktion auf, die zumindest ein Aufgabendurchführungs-Kommando von der Schaltvorrichtung empfangen kann und dieses an das Steuerungssystem übermittelt, wobei das Steuerungssystem nach Empfangen des Aufgabendurchführungs-Kommandos Steuerungskommandos erzeugt und an zumindest einen Aktuator des Teilnehmers übermittelt, wobei daraufhin der Aktuator zur Durchführung einer Aufgabendurchführungs-Aktion durch den Teilnehmer T und zur Erfüllung der Arbeitsaufgabe entsprechend des Aufgabendurchführungs-Kommandos betätigt wird.

In jedem oder in mehreren der Teilnehmer T bzw. T1, T2, T3 oder die eine Prioritäten-Bewertungsfunktion kann eine Funktion zur Konsistenzprüfung mit einem Vergleich der zu einem Zeitpunkt oder einem Zeitraum in den jeweils aktiven Teilnehmer T bzw. T1, T2, T3 erhaltenen Teilnehmer-Aufgaben, z.B. durch Bildung einer Gesamtliste der Teilnehmer-Aufgaben in jedem Teilnehmer-System TS, und ein Abgleich der Teilnehmer-Aufgaben zwischen den Teilnehmern T bzw. T1, T2, T3 derart erfolgt, dass vermieden wird, dass derselben Aufgabe die oberste Priorität zugewiesen wird. Alternativ oder zusätzlich kann eine solche Konsistenzprüfungs-Funktion auch im Zentralsystem Z vorgesehen sein. In einem Fall, in dem derselben Aufgabe die oberste Priorität zugewiesen worden ist, erfolgt ein Abgleich durch Verschiebung der Prioritäten z.B. nach einer vorbestimmten Priorisierung der jeweils betroffenen Teilnehmer, derart, dass vermieden wird, dass derselben Aufgabe die oberste Priorität zugewiesen wird.

Auf diese Weise erfolgt durch ein Steuerungssystem eine Abarbeitung der Aufgabe jeweils oberster Priorität durch den jeweiligen Teilnehmer T bzw. T1, T2, T3 derart, dass jeder Teilnehmer T bzw. T1, T2, T3 eine Aufgabe oberster Priorität erfüllt. Ein Steuerungssystem weist hierzu insbesondere eine Aufgaben-Durchführungsfunktion auf, mit der die inhaltliche Teilnehmer-Aufgaben, die zu einem jeweils empfangenen Aufgabendurchführungs-Kommando gehört, von dem jeweiligen Teilnehmer T bzw. T1, T2, T3 ausgeführt werden.

Dabei kann vorgesehen sein, dass dieses Arbeitsverfahren über einen längeren Zeitraum wie z.B. einen halben oder vollen Tag oder mehrere Tage abläuft, so dass also mehrere Teilnehmer-Aufgaben durchgeführt werden. Der Zeitraum kann dabei mindestens die dreifache der Zeitraums der zeitlich am kürzesten abzuarbeitenden Aufgabe sein.

## Patentansprüche

1. Schaltvorrichtung (1), die aufweist:
- eine Gehäusevorrichtung (H) mit einem plattenförmigen Grundkörper (10) mit einer Anschluss-Oberfläche (10a), die einer Betätigungsseite (S1) der elektrischen Schaltvorrichtung (1) zugewandt ist, und mit einem Gehäuseteil (H1),
- ein in einer Dickenrichtung (Z) gesehen auf dem Grundkörper (10) angeordnetes plattenförmiges Betätigungsteil (20) mit einer der Betätigungsseite (S1) zugewandten Betätigungsoberfläche (20a) und einer entgegen gesetzt zu dieser gelegenen Anschluss-Oberfläche (20b),
- ein in dem Betätigungsteil (20) integriertes Display (80) oder ein als Betätigungsteil (20) wirkendes Display zur Anzeige von Darstellungen auf der Betätigungsseite (S1), wobei das Gehäuseteil (H1) aufweist: eine Seitenwand (H4), die eine Verbindungsvorrichtung (30) und das Betätigungsteil (20) in der Dickenrichtung (Z) gesehen zumindest abschnittsweise umgibt, und ein Randabschnitt (H5), der sich zu der Betätigungsseite (S1) hin an der Seitenwand (H4) anschließt und eine zentrale Öffnung (H7) ausbildet, in der sich zumindest abschnittsweise das Display (80) erstreckt, wobei die Verbindungsvorrichtung (30, 300, 400) wenigstens eine Verbindungsschicht (31, 310, 410) aus einem elastischen Material aufweist, das mit einer ersten Oberfläche (30a) an einem inneren Bereich (20c) der Anschluss-Oberfläche (20b) des Betätigungsteils (20) und mit einer zweiten Oberfläche (30b) an einem inneren Bereich (11) der Anschluss-Oberfläche (10a) des Grundkörpers (10) befestigt ist,
- zumindest zwei Sensoren (41, 42, 43, 44), die zwischen dem Grundkörper (10) und dem Betätigungsteil (20) sowie in der Dickenrichtung (Z) gesehen seitlich der Verbindungsvorrichtung (30) gelegen sind, so dass mit jedem Sensor (41, 42, 43, 44) jeweils eine Position eines jeweils an diesem gelegenen Betätigungsbereichs der Anschluss-Oberfläche (20b) des Betätigungsteils (20) in der Dickenrichtung (Z) erfasst werden kann,
wobei die Verbindungsvorrichtung (30, 300) Betätigungsweichen aufweist, die zwischen dem Grundkörper (10) und dem Betätigungsteil (20) gelegen und von dem Flächenschwerpunkt FS aus gesehen an einer Stelle angeordnet sind, die zwischen zwei zueinander benachbarten Sensoren jeweils derselben Betätigungsbereiche gelegen ist.

2. Schaltvorrichtung (1) nach dem Anspruch 1, wobei die Verbindungsschicht (310) in der Dickenrichtung (Z) gesehen einen Zentralbereich (315), in dem der Flächenschwerpunkt FS des Betätigungsteils (20) oder der Öffnung (H7) gelegen ist, und zumindest zwei Seitenarm-Abschnitte (311, 312, 313, 314) aufweist, die sich jeweils von dem Zentralbereich (315) aus in Richtung zu einem Randbereich des Betätigungsteils (20) oder der Öffnung (H7), der jeweils zwischen zwei Betätigungsbereichen gelegen ist, erstrecken.

3. Schaltvorrichtung (1) nach dem Anspruch 2, wobei die Verbindungsschicht (310) vier Seitenarm-Abschnitte (311, 312, 313, 314) aufweist, die sich jeweils von dem Zentralbereich (315) aus kreuzförmig in Richtung zu einem Randbereich des Betätigungsteils (20) oder der Öffnung (H7), der jeweils zwischen zwei Betätigungsbereichen gelegen ist, erstrecken.

4. Schaltvorrichtung (1) nach dem Anspruch 1, wobei die Verbindungsschicht (410) in der Dickenrichtung (Z) gesehen SeitenrandAbschnitte (415, 416, 417, 418) aufweist, die von dem Flächenschwerpunkt (FS) des Betätigungsteils (20) aus gesehen konkav verlaufen und die jeweils zwei von insgesamt vier Ecken oder Eckabschnitte (411, 412, 413, 414) verbinden, wobei eine Ecke oder ein Eckabschnitt jeweils zwischen zwei entsprechenden von dem Flächenschwerpunkt (FS) aus gesehen zueinander benachbarten Sensoren für jeweils einen Betätigungsbereich gelegen ist.

5. Schaltvorrichtung (1) nach einem der voranstehenden Ansprüche, wobei die Verbindungsvorrichtung (30, 300, 400) Weichenteile aufweist, die unelastisch sind und die jeweils zwischen dem Grundkörper (10) und dem Betätigungsteil (20) und in der Z-Richtung gesehen von dem Flächenschwerpunkt (FS) des Betätigungsteils (20) aus gesehen an einer Stelle zwischen zwei zueinander benachbarten Sensoren jeweils zur Erfassung einer Auslenkung des Betätigungsteils (20) eines jeweiligen Betätigungsbereichs gelegen sind.

6. Schaltvorrichtung (1) nach einem der voranstehenden Ansprüche, wobei die Verbindungsschicht (31, 310, 410) mit einem Grundbereich mit einer ersten Elastizität und mit zweiten Elastizitätsbereichen mit einer zweiten gegenüber der ersten Elastizität geringeren Elastizität aufweist, wobei die zweiten Elastizitätsbereiche an einer Stelle in der Verbindungsschicht gelegen sind, die von dem Flächenschwerpunkt (FS) des Betätigungsteils (20) aus gesehen jeweils zwischen zwei zueinander benachbarten Sensoren bzw. Betätigungsbereichen gelegen ist.

7. Schaltvorrichtung (1) nach einem der vorstehenden Ansprüche,
- wobei das Betätigungsteil (20) ein Display (80) aufweist, das in einem in der Dickenrichtung (Z) gesehen inneren Bereich (20e) der Betätigungsoberfläche (20a) des Betätigungsteils (20) gelegen ist,
- wobei der innere Display-Bereich (20e) als an der Betätigungsoberfläche (20a) geformte Vertiefung ausgeführt ist und das Display (80) in der Dickenrichtung (Z) gesehenen zumindest teilweise in der Vertiefung gelegen ist.

8. Schaltvorrichtung (1) nach einem der vorstehenden Ansprüche, wobei das Betätigungsteil (20) zumindest in Flächenanteilen optisch durchsichtig ist und wobei der Grundkörper (10) einen in der Dickenrichtung (Z) gesehen inneren Display-Bereich (10e) aufweist, in dem das Display (80) angeordnet ist, wobei die Lage des inneren Display-Bereichs (10e) nach einem der folgenden Alternativen definiert ist:
- der Display-Bereich (20e) in der Dickenrichtung (Z) gesehen innerhalb eines von den Sensoren (41, 42, 43, 44) aufgespannten Bereichs oder zwischen Sensoren (41, 42, 43, 44) und in der Dickenrichtung (Z) gesehen außerhalb der zumindest einen Verbindungsschicht (31) liegt,
- der Display-Bereich (20e) in der Dickenrichtung (Z) gesehen innerhalb eines von den Sensoren (41, 42, 43, 44) aufgespannten Bereichs oder zwischen Sensoren (41, 42, 43, 44) und in der Dickenrichtung (Z) gesehen zumindest teilweise innerhalb zumindest einer der zumindest einen Verbindungsschicht (31) liegt, wobei die zumindest eine Verbindungsschicht, innerhalb der der Display-Bereich (20e) gelegen ist, optisch durchsichtig ist.

9. Schaltvorrichtung (1) nach dem Anspruch 8, wobei der innere Display-Bereich (10e) als an der Anschluss-Oberfläche (10a) geformte Vertiefung ausgeführt ist und das Display (80) in der Dickenrichtung (Z) gesehenen zumindest teilweise in der Vertiefung gelegen ist.

10. Schaltvorrichtung (1) nach einem der vorstehenden Ansprüche, wobei das plattenförmige Betätigungsteil (20) als starres Teil ausgeführt ist.

11. Schaltvorrichtung (1) nach einem der Ansprüche 1 bis 9, wobei das plattenförmige Betätigungsteil (20) als biege-elastisches Teil ausgeführt ist.

12. Verwendung der Schaltvorrichtung (1) nach einem der voranstehenden Ansprüche als Vorrichtung zur Steuerung von Fahrzeugen in einem Lagerbereich, um Lagereinheiten in dem Lagerbereich räumlich abzulegen oder deren Lagerplätze zu verändern oder dem Lagerbereich zu entnehmen oder als Vorrichtung zur Eingabe von logistischen Daten oder zur Ausgabe von logistischen Daten jeweils in einem Lagerbereich.

## Claims

1. Switch device (1), comprising:
- a housing device (H) with a plate-shaped base body (10) with a connection surface (10a), which is facing an actuation side (S1) of the electrical switch device (1), and with a housing part (H1),
- a plate-shaped actuation part (20) which is, when viewed in the thickness direction (Z), arranged on the base body (10), and which comprises an actuation surface (20a) facing the actuation side (S1) and a connection surface (20b) located contrary to the actuation surface (20a),
- a display (80) integrated in the actuation part (20) or a display acting as an actuation part (20) for displaying images on the actuation side (S1), wherein the housing part (H1) comprises: a side wall (H4), which surrounds a connection device (30) and the actuation part (20) viewed in the thickness direction (Z) at least in a section, and an edge section (H5) which adjoins to the side wall (H4) towards the actuation side (S1) and forms a central opening (H7), in which the display (80) extends, at least in a section, wherein the connection device (30, 300, 400) comprises at least one connection layer (31, 310, 410) made from an elastic material, which is attached with a first surface (30a) to an inner area (20c) of the connection surface (20b) of the actuation part (20) and with a second surface (30b) to an inner area (11) of the connection surface (10a) of the main body (10),
- at least two sensors (41, 42, 43, 44), which are located between the main body (10) and the actuation part (20) and, when viewed in the thickness direction (Z), laterally of the connection device (30), so that each sensor (41, 42, 43, 44) can be used to detect a position in the thickness direction (Z) of one respective actuation area of the connection surface (20b) of the actuation part (20), wherein a respective actuation area is arranged at each of the sensors,
wherein the connection device (30, 300) comprises actuation switches located between the main body (10) and the actuation part (20) and which are arranged, when viewed from the area centroid FS, at a position which is located between two adjacent sensors each of the same actuation areas.

2. Switch device (1) according to claim 1, wherein the connection layer (310) viewed in the thickness direction (Z) comprises a central area (315), in which the area centroid FS of the actuation part (20) or the opening (H7) is located, and comprises at least two side-arm sections (311, 312, 313, 314), each of which extend from the central area (315) in the direction of an edge region of the actuation part (20) or the opening (H7), which region is located in each case between two actuation areas.

3. Switch device (1) according to claim 2, wherein the connection layer (310) comprises four side-arm sections (311, 312, 313, 314), each of which extends from the central area (315) in a cross shape in the direction of an edge region of the actuation part (20) or opening (H7), which region is located in each case between two actuation areas.

4. Switch device (1) according to claim 1, wherein the connection layer (410) viewed in the thickness direction (Z) comprises side edge sections (415, 416, 417, 418), which, when viewed from the area centroid (FS) of the actuation part (20), are formed in a concave manner and each of which connect two of a total of four corners or corner sections (411, 412, 413, 414), wherein a corner or a corner section is located in each case between two corresponding sensors which are located adjacent to each other when viewed from the area centroid (FS), each for one actuation area.

5. Switch device (1) according to any one of the previous claims, wherein the connection device (30, 300, 400) comprises switch parts which are inelastic and each of which are located between the main body (10) and the actuation part (20) and, viewed in the Z-direction of the area centroid (FS) of the actuation part (20), at a position between two adjacent sensors which are provided in each case for detection of a deflection of the actuation part (20) of a respective actuation area.

6. Switch device (1) according to any one of the previous claims, wherein the connection layer (31, 310, 410) with a main area with a first elasticity and second elasticity regions with a second elasticity which is lower compared to the first elasticity, wherein the second elasticity regions are located at a position in the connection layer which, when seen from the area centroid (FS) of the actuation part (20), is in each case located between two adjacent sensors or actuation areas.

7. Switch device (1) according to any one of the previous claims,
- wherein the actuation part (20) comprises a display (80), which is located, when viewed in the thickness direction (Z), in an inner area (20e) of the actuation surface (20a) of the actuation part (20),
- wherein the internal display area (20e) is designed as a recess formed in the actuation surface (20a) and the display (80), when viewed in the thickness direction (Z), is located at least partially in the recess.

8. Switch device (1) according to any one of the previous claims, wherein the actuation part (20) is optically transparent, at least in portions of its area, and wherein the main body (10) comprises, when viewed in the thickness direction (Z), an internal display area (10e), in which the display (80) is disposed, wherein the position of the internal display area (10e) being defined according to one of the following alternatives:
- the display area (20e), when viewed in the thickness direction (Z), is situated within an area defined by the sensors (41, 42, 43, 44) or between sensors (41, 42, 43, 44) and, when viewed in the thickness direction (Z), outside of the at least one connection layer (31),
- the display area (20e), when viewed in the thickness direction (Z), is situated within an area defined by the sensors (41, 42, 43, 44) or between sensors (41, 42, 43, 44) and, when viewed in the thickness direction (Z), at least partially inside at least one of the at least one connection layer (31), wherein the at least one connection layer, within which the display area (20e) is located, is optically transparent.

9. Switch device (1) according to claim 8, wherein the internal display area (10e) is designed as a recess formed in the actuation surface (10a) and wherein the display (80), when viewed in the thickness direction (Z), is located at least partially in the recess.

10. Switch device (1) according to any one of the previous claims, wherein the plate-shaped actuation part (20) is designed as a rigid part.

11. Switch device (1) according to any one of claims 1 to 9, wherein the plate-shaped actuation part (20) is designed as a flexible elastic part.

12. Use of the switch device (1) according to any one of the previous claims as a device for controlling vehicles in a storage area for deposition of storage units in the storage area or for changing their storage locations or for removing them from the storage area or as a device for inputting logistical data or for outputting logistical data, in each case in a warehouse area.

## Revendications

1. Dispositif de commutation (1), qui présente :
- un dispositif de boîtier (H) comportant un corps de base en forme de plaque (10) doté d'une surface de raccordement (10a) qui est tournée vers un côté actionnement (S1) du dispositif de commutation électrique (1), et un élément de boîtier (H1),
- une pièce d'actionnement (20) en forme de plaque disposée, vue dans un sens de l'épaisseur (Z), sur le corps de base (10) et comportant une surface d'actionnement (20a) tournée vers le côté actionnement (S1) et une surface de raccordement (20b) située à l'opposé de celle-ci,
- un afficheur (80) intégré dans la pièce d'actionnement (20) ou un afficheur faisant office de moyen d'actionnement (20) et destiné à afficher des représentations sur le côté actionnement (S1), l'élément d'actionnement (H1) présentant : une paroi latérale (H4) qui entoure un dispositif de liaison (30) et la pièce d'actionnement (20), vus dans le sens de l'épaisseur (Z), du moins par sections, et une section périphérique (H5) qui se raccorde en direction du côté actionnement (S1) à la paroi latérale (H4) et forme un orifice central (H7) dans lequel l'afficheur (80) s'étend du moins par sections, le dispositif de liaison (30,300,400) présentant au moins une couche de liaison (31,310,410) composée d'un matériau élastique qui est fixé par une première surface (30a) à une partie intérieure (20c) de la surface de raccordement (20b) de la pièce d'actionnement (20) et par une seconde surface (30b) à une partie intérieure (11) de la surface de raccordement (10a) du corps de base (10),
- au moins deux capteurs (41,42,43,44) qui sont situés entre le corps de base (10) et la pièce d'actionnement (20), de même que, vu dans le sens de l'épaisseur (Z), à côté du dispositif de liaison (30), de sorte qu'avec chaque capteur (41, 42, 43, 44), respectivement une position d'une zone d'actionnement respectivement située au niveau de celui-ci de la surface de raccordement (20b) de la pièce d'actionnement (20) dans le sens de l'épaisseur (Z) peut être détectée.
le dispositif de liaison (30,300) présentant des aiguillages d'actionnement qui sont situés entre le corps de base (10) et la pièce d'actionnement (20) et, vus depuis le centre de gravité surfacique FS, sont disposés à un endroit qui se trouve entre deux capteurs mutuellement voisins respectivement des mêmes zones d'actionnement.

2. Dispositif de commutation (1) selon la revendication 1, dans lequel la couche de liaison (310), vue dans le sens de l'épaisseur (Z), présente une zone centrale (315) dans laquelle se trouve le centre de gravité surfacique (FS) de la pièce d'actionnement (20) ou de l'orifice (H7), et au moins deux sections de bras latéral (311,312,313,314) qui s'étendent respectivement à partir de la zone centrale (315) en direction d'une zone périphérique de la pièce d'actionnement (20) ou de l'orifice (H7), laquelle zone périphérique est située respectivement entre deux zones d'actionnement.

3. Dispositif de commutation (1) selon la revendication 2, dans lequel la couche de liaison (310) présente quatre sections de bras latéral (311,312,313,314) qui s'étendent respectivement en forme de croix à partir de la zone centrale (315) en direction d'une zone périphérique de la pièce d'actionnement (20) ou de l'orifice (H7), laquelle zone périphérique est située respectivement entre deux zones d'actionnement.

4. Dispositif de commutation (1) selon la revendication 1, dans lequel la couche de liaison (410), vue dans le sens de l'épaisseur (Z), présente des sections périphériques latérales (415,416,417,418) qui, vues depuis le centre de gravité surfacique (FS) de la pièce d'actionnement (20) ont une orientation concave et qui connectent respectivement deux sur un total de quatre angles ou sections d'angle (411,412,413,414), un angle ou une section d'angle se trouvant respectivement entre deux capteurs correspondants mutuellement voisins, vus depuis le centre de gravité surfacique (FS), pour respectivement une zone d'actionnement.

5. Dispositif de commutation (1) selon une des revendications précédentes, dans lequel le dispositif de liaison (30,300,400) présente des pièces d'aiguillage qui ne sont pas élastiques et qui, respectivement entre le corps de base (10) et la pièce d'actionnement (20) et vues dans le sens Z à partir du centre de gravité surfacique (FS) de la pièce d'actionnement (20), se trouvent à un endroit entre deux capteurs mutuellement voisins respectivement de manière à toucher une bifurcation de la pièce d'actionnement (20) d'une zone d'actionnement respective.

6. Dispositif de commutation (1) selon une des revendications précédentes, dans lequel la couche de liaison (31,310,410) présente une zone de base ayant une première élasticité et des secondes zones d'élasticité ayant une seconde élasticité inférieure à la première élasticité, les secondes zones d'élasticité étant situées à un endroit de la couche de liaison qui, vu depuis le centre de gravité surfacique (FS) de la pièce d'actionnement (20), est situé respectivement entre deux capteurs ou zones d'actionnement mutuellement voisins.

7. Dispositif de commutation (1) selon une des revendications précédentes,
- dans lequel la pièce d'actionnement (20) présente un afficheur (80) qui, vu dans le sens de l'épaisseur (Z), est situé dans la partie intérieure (20e) de la surface d'actionnement (20a) de la pièce d'actionnement (20),
- la zone d'affichage intérieure (20e) est réalisée sous forme d'un creux pratiqué dans la surface d'actionnement (20a) et l'afficheur (80), vu dans le sens de l'épaisseur (Z), est situé du moins partiellement dans le creux.

8. Dispositif de commutation (1) selon une des revendications précédentes, dans lequel la pièce d'actionnement (20), du moins dans des parties de sa surface, est transparent optiquement et le corps de base (10) présente une zone d'affichage (10e) intérieure vue dans le sens de l'épaisseur (Z) et dans laquelle l'afficheur (80) est disposé, la position de la zone d'affichage intérieure (10e) étant définie d'après une des alternatives suivantes :
- la zone d'affichage (20e), vue dans le sens de l'épaisseur (Z), se situe dans une zone sous-tendue par les capteurs (41,42,43,44) ou entre les capteurs (41,42,43,44) et, vue dans le sens de l'épaisseur (Z), se situe en dehors de l'au moins une couche de liaison (31),
- la zone d'affichage (20e), vue dans le sens de l'épaisseur (Z), se situe dans une zone sous-tendue par les capteurs (41,42,43,44) ou entre les capteurs (41,42,43,44) et, vue dans le sens de l'épaisseur (Z), se situe du moins partiellement dans au moins une de l'au moins une couche de liaison (31), l'au moins une couche de liaison dans laquelle la zone de d'affichage (20e) se situe étant optiquement transparente.

9. Dispositif de commutation (1) selon la revendication 8, dans lequel la zone d'affichage intérieure (10e) est réalisée sous forme d'un creux pratiqué dans la surface de raccordement (10a) et l'afficheur (80), vu dans le sens de l'épaisseur (Z), se situe du moins partiellement dans le creux.

10. Dispositif de commutation (1) selon une des revendications précédentes, dans lequel la pièce d'actionnement en forme de plaque (20) est réalisée sous forme d'une pièce rigide.

11. Dispositif de commutation (1) selon une des revendications 1 à 9, dans lequel la pièce d'actionnement en forme de plaque (20) est réalisée sous forme d'une pièce élastique à la flexion.

12. Utilisation du dispositif de commutation (1) selon une des revendications précédentes comme dispositif de commande de véhicules dans une zone de stockage pour déposer spatialement des unités de stockage dans la zone de stockage ou modifier leur emplacement de stockage ou les prélever dans la zone de stockage ou comme dispositif de saisie de données logistiques ou d'édition de données logistiques respectivement dans une zone de stockage.
